# EUROPEAN PATENT SPECIFICATION

(11) **EP 4 660 704 B1**
(45) Date of publication and mention of the grant of the patent: **30.09.2026**
(21) Application number: 25180992.7
(22) Date of filing: 05.06.2025
(51) Int. Cl.: G03F 7/028, G03F 7/037, G03F 7/038, G03F 7/32, G03F 7/40

(54) **NEGATIVE PHOTOSENSITIVE RESIN COMPOSITION, PATTERNING PROCESS, METHOD FOR FORMING CURED FILM, INTERLAYER INSULATING FILM, SURFACE PROTECTIVE FILM, AND ELECTRONIC COMPONENT**
NEGATIVE PHOTOLACK-ZUSAMMENSETZUNG, STRUKTURIERUNGSVERFAHREN, VERFAHREN ZUR BILDUNG EINES GEHÄRTETEN FILMS, ZWISCHENSCHICHTISOLATIONSFILM, OBERFLÄCHENSCHUTZFILM UND ELEKTRONISCHES BAUTEIL
COMPOSITION DE PHOTORÉSINE NÉGATIVE, PROCÉDÉ DE FORMATION DE MOTIFS, PROCÉDÉ DE FORMATION DE FILM DURCI, FILM ISOLANT INTERCOUCHE, FILM PROTECTEUR DE SURFACE ET COMPOSANT ÉLECTRONIQUE

(30) Priority: 06.06.2024 JP 2024092618
(43) Date of publication of application: 10.12.2025
(73) Proprietor: Shin-Etsu Chemical Co., Ltd., Tokyo 100-0005 (JP)
(72) Inventor: Takemura, Katsuya, Niigata (JP); Iio, Masashi, Niigata (JP); Urano, Hiroyuki, Niigata (JP); Watanabe, Osamu, Niigata (JP)
(74) Representative: Schicker, Silvia

(56) References cited:
- JP-A- 2007 056 196
- JP-A- 2024 019 341
- JP-B2- 7 252 020
- US-B2- 10 457 779
- OGURA TOMOHITO ET AL: "Development of Negative-type Photosensitive Polyimide, Based on Poly(amic acid)s, Photo Base Generator and Thermal Base Generator", JOURNAL OF PHOTOPOLYMER SCIENCE AND TECHNOLOGY, vol. 21, no. 1, 24 June 2008 (2008-06-24), https://www.jstage.jst.go.jp/article/photopolymer/21/1/21_1_125/_pdf, pages 125 - 130, XP093296418, DOI: https://doi.org/10.2494/photopolymer.21.125

## Description

### TECHNICAL FIELD

The present invention relates to: a negative photosensitive resin composition; a patterning process that uses the negative photosensitive resin composition and is capable of performing development with an organic solvent; a method for forming a cured film; an interlayer insulating film; a surface protective film; and an electronic component.

### BACKGROUND ART

Along with miniaturization and higher performance of various electronic devices such as personal computers, digital cameras, and mobile phones, there is a rapidly increasing demand for further miniaturization, thin profile, and high density of semiconductor devices.

Accordingly, it is demanded to develop a photosensitive insulation material, which can address the increase in substrate area for improved productivity and also achieves fineness and a high aspect ratio on a substrate in high-density packaging technology such as chip size package, chip scale package (CSP), or three-dimensional stacking.

In high-density packaging technology such as three-dimensional stacking, as a photosensitive insulation material available for pattern formation on a substrate, a polyimide film has been utilized as a protective film or an interlayer insulating film. Its insulation property, mechanical strength, adhesion to a substrate, etc. continue to attract attention, so that it is still actively developed.

Polyimide and the like for forming a polyimide film is characterized by low solubility in a solvent. Hence, polyimide is used in a precursor form before imide ring closure reaction, applied or laminated on a substrate, and thereafter heated to cause cyclization of the polyimide precursor to form a cured film, which is used as a protective film, an interlayer insulating film, etc.

Conventionally, a precursor of polyimide as a material available for pattern formation, for example, a material in which a photosensitive group is introduced into a carboxyl group of polyamic acid by an ester bond has been proposed (Patent Documents 1 and 2). However, in these proposals, imidization treatment at a high temperature exceeding 300°C is essential for obtaining a desired polyimide film after forming a patterned film, and to withstand this high temperature, there are problems of limitation to an underlayer base material, oxidation of copper of wiring, and a risk of causing thermal damage to electronic components, etc.

Patent Document 3 discloses a polyimide precursor composition including a polyimide precursor, a thermal base generator that generates a base by heat, and a solvent, wherein the polyimide precursor is polyamic acid, and the thermal base generator is a neutral compound that undergoes thermal decomposition when heated at a temperature of 200°C or lower to generate secondary amine. It discloses that the secondary amine generated by thermal decomposition facilitates imide ring closure reaction, thereby allowing treatment at 200°C or lower.

However, a cured film using the composition disclosed in Patent Document 3 may be inferior in properties including corrosion resistance and chemical resistance required for a protective film, an interlayer insulating film, etc. Additionally, there is a problem with storage stability; in other words, cyclization reaction of the polyimide precursor resin proceeds during storage of the composition, resulting in gelation.

Meanwhile, Patent Documents 4 and 5 disclose a composition to which a polyimide precursor and imidazoles as an imidization catalyst for facilitating imide ring closure reaction are added. However, they do not disclose a photosensitive resin composition capable of forming a pattern on a substrate required for high-density packaging technology, or low-temperature imidization. Furthermore, the imidazoles as the imidization catalyst disclosed in Patent Documents 4 and 5, except N-tert-butoxycarbonyl imidazole (N-Boc-imidazole), have a problem with storage stability, that is, gelation during storage of the composition. Yet further, if the imidazoles as the imidization catalyst are added in the amount disclosed in Patent Documents 4 and 5, deformation of a pattern is caused by heat (thermal flow) in curing reaction subsequent to pattern formation and a fine pattern with a high aspect ratio cannot be expected, or the resulting cured film is unsuitable for use as a protective film, an interlayer insulating film, etc. because its glass transition temperature (Tg.) is reduced.

Meanwhile, Patent Document 6 also discloses the use of an active esterification agent as a compound enabling imidization to proceed at lower temperature, unlike a thermal base generator that generates a base by heat. However, carbonate compounds and esterification compounds of bis(pentafluorophenyl)carbonate, bis(4-nitrophenyl)carbonate, di(N-succrinimidyl)carbonate, and 4-nitrophenyltrifluoroacetate as the active esterification agent disclosed in Patent Document 6 have relatively high decomposition temperature, and it is desired to more effectively facilitate imide ring closure reaction in a heating process to yield a cured film.

Additionally, since pentafluorophenol and 1-hydroxy-7-azabenzotriazole as the active esterification agent disclosed in Patent Document 6 contain a hydroxy group, there is a problem of storage stability deterioration of a photosensitive resin composition containing a polyimide precursor resin.

Meanwhile, Patent Document 7 also discloses addition of an imide compound as a compound capable of facilitating imidization reaction. However, since the imide compound disclosed in Patent Document 7 contains a hydroxyl group or an amino group, it is undeniable that there is a problem of storage stability deterioration of a photosensitive resin composition containing a polyimide precursor resin.

Furthermore, Non Patent Document 1 describes a polyimide precursor composition including a polyimide precursor similar to the one in Patent Document 3, a thermal base generator that generates a base by heat, and a solvent. The polyimide precursor described in Non Patent Document 1 is polyamic acid, and the thermal base generator is a compound that undergoes thermal decomposition when heated at a temperature of 200°C or lower to generate a basic compound. The basic compound generated by thermal decomposition facilitates imide ring closure reaction, thereby allowing imide ring closure reaction at around 200°C. Furthermore, US10457779B2 relates to a tetracarboxylic acid diester compound, polyimide precursor polymer and method for producing the same, negative photosensitive resin composition, positive photosensitive resin composition, patterning process, and method for forming cured film.

However, a cured film using the composition described in Non Patent Document 1 may be inferior in properties including corrosion resistance and chemical resistance required for a protective film, an interlayer insulating film, etc. Additionally, there is a problem with storage stability; in other words, cyclization reaction of the polyimide precursor resin proceeds during storage of the composition, resulting in gelation.

Accordingly, it is desired to develop a photosensitive resin composition using a polyimide precursor as soon as possible in the future, the photosensitive resin composition being characterized by all of the following abilities, without missing any one of them: ability to form a fine pattern; ability to yield a cured film by heating at low temperature; ability to provide a cured protective film or interlayer insulating film with heat resistance in various processes and resistance to various chemicals to be used; and further favorable storage stability of the composition.

### CITATION LIST

### PATENT LITERATURE

Patent Document 1: JP S49-115541 A
Patent Document 2: JP S55-45746 A
Patent Document 3: JP 2007-056196 A
Patent Document 4: JP 7436606 B
Patent Document 5: JP 2022-159241 A
Patent Document 6: JP 2024-19341 A
Patent Document 7: JP 7252020 B

### NON PATENT LITERATURE

Non Patent Document 1: Journal of Photopolymer Science and Technology (2008), 21(1), 125-130

### SUMMARY OF INVENTION

### TECHNICAL PROBLEM

The present invention has been made in view of the above circumstances, and aims to provide a photosensitive resin composition using a polyimide precursor, which enables imide ring closure reaction to be performed at low temperature, has excellent stability of the composition, and is capable of forming a fine pattern and providing resistance to chemicals after cured. Additionally, the present invention has an object to provide: a patterning process using the photosensitive resin composition; an interlayer insulating film and a surface protective film characterized by including a cured film of the photosensitive resin composition; and an electronic component including the same.

### SOLUTION TO PROBLEM

To achieve the above objects, the present invention provides a negative photosensitive resin composition including:
(A) a polymer compound having a polyimide precursor structure;
(C) a photoinitiator;
(D) a nitrogen-containing organic compound represented by the following general formula (1); and
(E) a solvent, 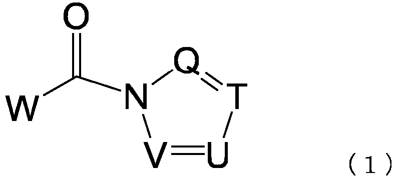
   wherein Q represents a nitrogen atom or a carbon atom having a R^{q} group; T represents a nitrogen atom or a carbon atom having a R^{t} group; U represents a nitrogen atom or a carbon atom having a R^{u} group; V represents a nitrogen atom or a carbon atom having a R^{v} group; the R^{q}, R^{t}, R^{u}, and R^{v} groups each represents a hydrogen atom, a linear, branched, or cyclic alkyl group having 1 to 15 carbon atoms, an aryl group having 6 to 15 carbon atoms, a halogen atom, or a nitro group, and the R^{q} group and the R^{t} group, the R^{t} group and the R^{u} group, or the R^{u} group and the R^{v} group optionally bond together to form a ring with a carbon atom attached thereto; and W represents any structure of the following general formulae (2) to (4), 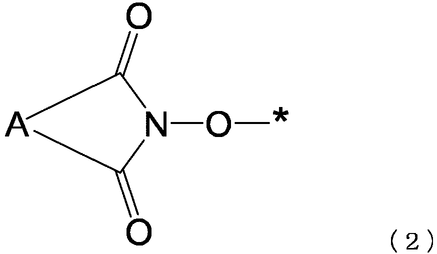
   wherein A represents a divalent organic group; and * represents a bond, 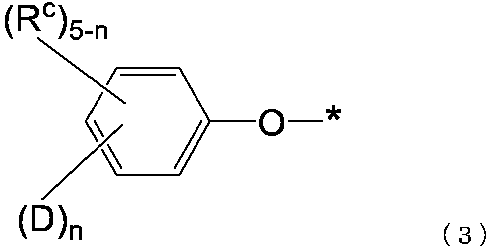
   wherein D represents a halogen atom or a nitro group; R^{C} represents a hydrogen atom, a linear, branched, or cyclic alkyl group having 1 to 15 carbon atoms, or an aryl group having 6 to 15 carbon atoms; "n" represents an integer of 3 to 5 when D represents a halogen atom, and represents 1 when D represents a nitro group; and * represents a bond, 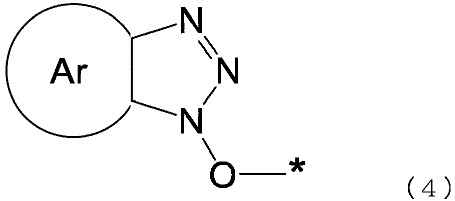
   wherein Ar represents a substituted or unsubstituted aromatic ring structure, or a heterocyclic structure having a heteroatom; and * represents a bond.

It is preferable to contain the polymer compound having the polyimide precursor structure as the component (A) in the negative photosensitive resin composition such that favorable mechanical properties and adhesion to a substrate can be achieved even by curing at low temperature.

By adding the nitrogen-containing organic compound represented by the above general formula (1) to the negative photosensitive resin composition including the polyimide precursor structure, it is possible to set a temperature for curing reaction to obtain a cured film, i.e. imide ring closure reaction, to 200°C or lower.

Additionally, the nitrogen-containing organic compound represented by the above general formula (1) has a -(C=O)-W group on a nitrogen atom, such that aggregation, i.e. gelation, of the polymer compound having the polyimide precursor structure and the nitrogen-containing organic compound can be prevented.

In this aspect, the component (A) of the negative photosensitive resin composition is preferably a polymer compound having a polyimide precursor structure represented by the following general formula (5), 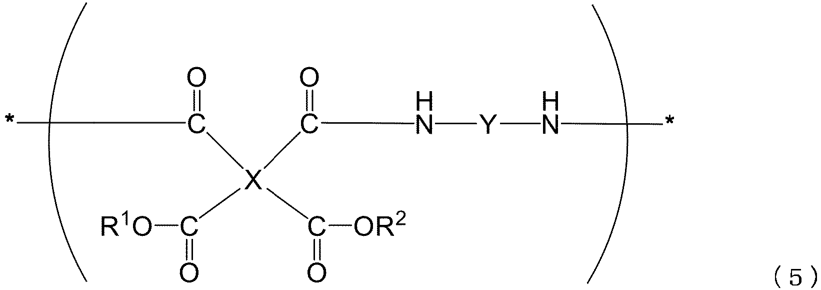
wherein X represents a tetravalent organic group; Y represents a divalent organic group; each of R¹ and R² independently represents a hydrogen atom or a monovalent organic group, and at least one of R¹ and R² represents a group represented by the following general formula (6), 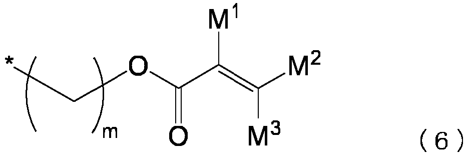
wherein each of M¹, M², and M³ independently represents a hydrogen atom or an organic group having 1 to 3 carbon atoms; "m" represents an integer of 2 to 10; and * represents a bond.

It is preferable to contain the polymer compound having the polyimide precursor structure represented by the above general formula (5) as the component (A) of the negative photosensitive resin composition such that favorable mechanical properties and adhesion to a substrate can be achieved even by curing at low temperature.

It is preferable to further include (B) a polymerizable compound having two or more ethylenically unsaturated groups.

By containing such a polymerizable compound having two or more ethylenically unsaturated groups crosslinking agent having two or more photopolymerizable unsaturated bonds in one molecule, it is possible to facilitate crosslinking of the component (A) due to photopolymerization in an exposed portion and improve the contrast between the exposed portion and an unexposed portion.

Further in this aspect, W in the above general formula (1) of the component (D) is preferably an organic group represented by the following general formula (2-1), 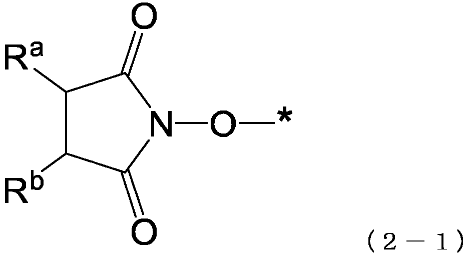 wherein a R⁶ group and a R^{b} group represent a hydrogen atom, a linear, branched, or cyclic alkyl group having 1 to 15 carbon atoms, or an aryl group having 6 to 15 carbon atoms, or the R^{a} group and the R^{b} group optionally bond together to form a ring with a carbon atom attached thereto; and * represents a bond.

When W is the organic group represented by the above general formula (2-1), a nitrogen atom of the organic group in the above general formula (1) is protected by an imidooxycarbonyl group in the indicated structure. The nitrogen-containing organic compound having the organic group represented by the above general formula (2-1) as W enables decomposition and decarboxylation at a temperature of 200°C or lower in a heating process, thereby generating not only an azole compound capable of facilitating imide ring closure reaction, but also a N-hydroxyimide compound, which is an active esterification agent capable of facilitating imide ring closure reaction. Accordingly, imide ring closure can lead to imidization at 200°C or lower.

Yet further, in this aspect, W in the above general formula (1) of the component (D) is preferably an organic group represented by the following general formula (3-1) or (3-2), 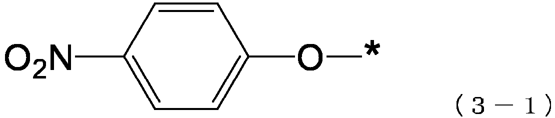 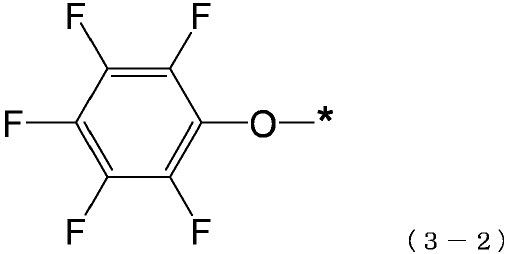 wherein * represents a bond.

When W is the organic group represented by the above general formula (3-1), the nitrogen-containing organic compound represented by the above general formula (1) has a structure in which a nitrogen atom thereof is protected by a 4-nitrophenyloxycarbonyl group. The nitrogen-containing organic compound having the organic group represented by the above general formula (3-1) as W enables decomposition and decarboxylation at a temperature of 200°C or lower in a heating process, thereby generating not only an azole compound capable of facilitating imide ring closure reaction, but also 4-nitrophenol which is an active esterification agent capable of facilitating imide ring closure reaction. Accordingly, imide ring closure can lead to imidization at 200°C or lower.

When W is the organic group represented by the above general formula (3-2), a nitrogen atom of the organic group in the above general formula (1) is protected by a pentafluorophenyloxycarbonyl group in the indicated structure. The nitrogen-containing organic compound having the organic group represented by the above general formula (3-2) as W enables decomposition and decarboxylation at a temperature of 200°C or lower in a heating process, thereby generating not only an azole compound capable of facilitating imide ring closure reaction, but also pentafluorophenol which is an active esterification agent capable of facilitating imide ring closure reaction. Accordingly, imide ring closure can lead to imidization at 200°C or lower.

Furthermore, W in the above general formula (1) of the component (D) is preferably an organic group represented by the following general formula (4-1), 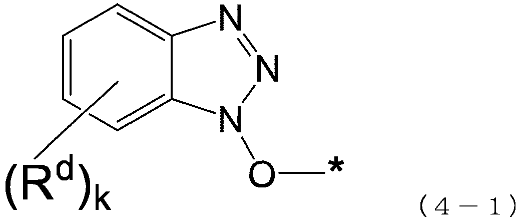 wherein a R^{d} group represents a linear, branched, or cyclic alkyl group having 1 to 15 carbon atoms and optionally having a halogen atom, or an aryl group having 6 to 15 carbon atoms; "k" represents an integer of 0 to 4; and * represents a bond.

When W is the organic group represented by the above general formula (4-1), a nitrogen atom of the organic group in the above general formula (1) is protected by a 1-benztriazoleoxycarbonyl group. The nitrogen-containing organic compound having the organic group represented by the above general formula (4-1) as W enables decomposition and decarboxylation at a temperature of 200°C or lower in a heating process, thereby generating not only an azole compound capable of facilitating imide ring closure reaction, but also a 1-hydroxybenztriazole compound, which is an active esterification agent capable of facilitating imide ring closure reaction. Accordingly, imide ring closure can lead to imidization at 200°C or lower.

Furthermore, the component (D) is preferably contained in an amount of 1 to 10 parts by mass relative to 100 parts by mass of the component (A).

When the amount of the nitrogen-containing organic compound as the component (D) is 10 parts by mass or less, the added nitrogen-containing compound does not function as a plasticizer, causing no thermal deformation, i.e. thermal flow, in a formed pattern, nor damage to pattern formation. Additionally, after curing, a glass transition temperature (Tg.) of the resulting cured film never decreases.

Additionally, the present invention preferably further includes, as (F) a thermal crosslinking agent, one kind or two or more kinds of crosslinking agents selected from an amino condensate modified with formaldehyde or formaldehyde-alcohol, a phenol compound having two or more methylol groups or alkoxymethylol groups on average in one molecule, a compound in which a hydrogen atom of a hydroxyl group of polyhydric phenol is substituted with a glycidyl group, a compound in which a hydrogen atom of a hydroxyl group of polyhydric phenol or a hydroxyl group of polyhydric alcohol is substituted with a substituent represented by the following formula (F-1), and a compound containing two or more nitrogen atoms and having a glycidyl group represented by the following formula (F-2), 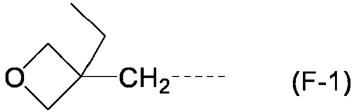 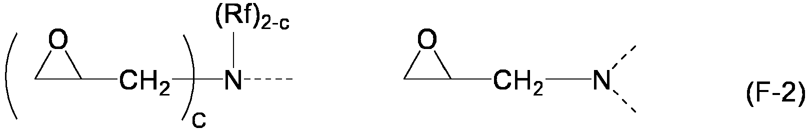 wherein a dotted line represents a bonding arm; Rf represents a linear, branched, or cyclic alkyl group having 1 to 6 carbon atoms; and "c" represents 1 or 2.

The component (F) is a component that causes crosslinking reaction during post curing subsequent to pattern formation using the negative photosensitive resin composition of the present invention, thereby further enhancing strength of a cured material.

The negative photosensitive resin composition preferably further includes (G) an antioxidant.

By containing the antioxidant as the component (G), it is possible to prevent unnecessary crosslinking between the components (A) or between the components (A) and (B) during patterning, and improve the contrast. Additionally, due to an anticorrosion effect on a metal material, it is possible to prevent oxidation of metal by water from the outside, a photo-acid generator, a thermal acid generator, etc., and accompanying decrease in adhesion and peeling off.

The negative photosensitive resin composition preferably further includes (H) a silane compound.

The negative photosensitive resin composition of the present invention preferably includes a metal adhesiveness improver to improve adhesiveness to a metal material for use in an electrode, wiring, etc. A silane compound is usable as the metal adhesiveness improver.

The negative photosensitive resin composition preferably further includes (I) a polymerization inhibitor.

By containing the polymerization inhibitor (I), it is possible to improve stability of viscosity and photosensitivity of the composition solution during storage.

The present invention can also provide a patterning process including the steps of:
(1) applying the above-described negative photosensitive resin composition onto a substrate to form a photosensitive material film;
(2) heating and thereafter exposing the photosensitive material film to a high-energy beam having a wavelength of 190 to 500 nm or an electron beam through a photomask; and
(3) performing development with a developer of an organic solvent after the exposing.

Such patterning process using the negative photosensitive composition is a patterning process using particularly the negative photosensitive resin composition in which the above-described polymer compound having the polyimide precursor structure, namely a polymer having a polymerizable unsaturated linking group, is used as the base resin (A), or the negative photosensitive resin composition including the nitrogen-containing organic compound represented by the above general formula (1) as the component (D).

The patterning process using the negative photosensitive resin composition including the component (A) is preferable because it can provide favorable mechanical properties and adhesion to a substrate even by curing at low temperature. Furthermore, the patterning process using the negative photosensitive resin composition including the nitrogen-containing organic compound represented by the above general formula (1) as the component (D) is preferable because it can prevent aggregation, i.e. gelation, of the polymer compound having the polyimide precursor structure and the nitrogen-containing organic compound.

Then, the present invention can provide a method for forming a cured film, including the step of: heating and post-curing a film having a formed pattern obtained by the above-described patterning process at a temperature of 100 to 300°C.

Such patterning process enables to perform curing reaction, i.e. imide ring closure reaction, at low temperature after pattern formation.

The present invention also provides an interlayer insulating film that is a cured film of the above-described negative photosensitive resin composition.

By curing the negative photosensitive resin composition of the present invention, it is possible to obtain an interlayer insulating film that has excellent chemical resistance and high glass transition temperature (Tg.).

The present invention also provides a surface protective film that is a cured film of the above-described negative photosensitive resin composition.

By curing the negative photosensitive resin composition of the present invention, it is possible to obtain a surface protective film that has excellent chemical resistance and high glass transition temperature (Tg.).

The present invention also provides an electronic component including the above-described interlayer insulating film.

Such electronic component includes a protective film (interlayer insulating film) excellent in heat resistance, chemical resistance, and an insulation property, and thus has excellent reliability.

The present invention also provides an electronic component including the above-described surface protective film.

Such electronic component includes a protective film (surface protective film) excellent in heat resistance, chemical resistance, and an insulation property, and thus has excellent reliability.

### ADVANTAGEOUS EFFECTS OF INVENTION

As described above, according to the embodiment of the present invention, it is possible to provide a negative photosensitive resin composition including a polymer compound having a polyimide precursor structure, which enables imide ring closure reaction at low temperature regardless of the molecular structure of the polyimide precursor and also has high storage stability. Further, the composition can be cured without any change in shape of the resulting pattern, making it possible to form a fine pattern. Yet further, a cured film obtained by curing after pattern formation has excellent chemical resistance and high glass transition temperature (Tg.).

### DESCRIPTION OF EMBODIMENTS

As described above, it has been demanded to develop a photosensitive resin composition using a polyimide precursor, which enables imide ring closure reaction to be performed at low temperature, has excellent stability of the composition, and is capable of forming a fine pattern and providing resistance to chemicals after cured.

The present inventors have made an intensive investigation to achieve the above objects and consequently found that a photosensitive resin composition using a polymer compound having a polyimide precursor structure can be used for a patterning process, wherein a nitrogen-containing organic compound represented by the following general formula (1) is added to the composition, such that the patterning process can be implemented without any damage to formation of a fine pattern, and curing reaction, i.e. imide ring closure reaction, after pattern formation can be performed at 200°C or lower.

Additionally, the present inventors have found that a cured film thus obtained has excellent chemical resistance and high glass transition temperature (Tg.). Yet further, the present inventors have found that storage stability of the photosensitive resin composition is also favorable, and completed the present invention.

Thus, the present invention is a negative photosensitive resin composition including:
(A) a polymer compound having a polyimide precursor structure;
(C) a photoinitiator;
(D) a nitrogen-containing organic compound represented by the following general formula (1); and
(E) a solvent, 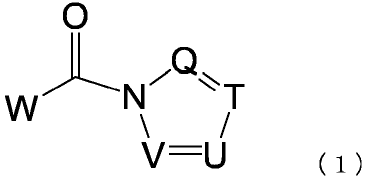
   wherein Q represents a nitrogen atom or a carbon atom having a R^{q} group; T represents a nitrogen atom or a carbon atom having a R^{t} group; U represents a nitrogen atom or a carbon atom having a R^{u} group; V represents a nitrogen atom or a carbon atom having a R^{v} group; the R^{q}, R^{t}, R^{u}, and R^{v} groups each represents a hydrogen atom, a linear, branched, or cyclic alkyl group having 1 to 15 carbon atoms, an aryl group having 6 to 15 carbon atoms, a halogen atom, or a nitro group, and the R^{q} group and the R^{t} group, the R^{t} group and the R^{u} group, or the R^{u} group and the R^{v} group optionally bond together to form a ring with a carbon atom attached thereto; and W represents any structure of the following general formulae (2) to (4), 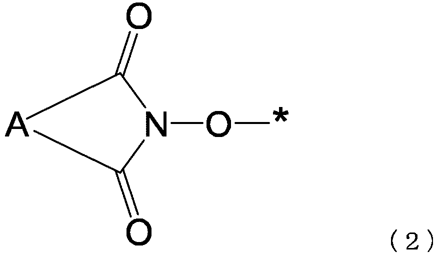
   wherein A represents a divalent organic group; and * represents a bond, 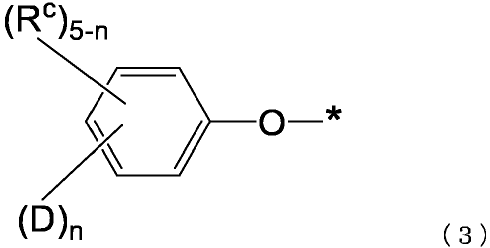
   wherein D represents a halogen atom or a nitro group; R^{C} represents a hydrogen atom, a linear, branched, or cyclic alkyl group having 1 to 15 carbon atoms, or an aryl group having 6 to 15 carbon atoms; "n" represents an integer of 3 to 5 when D represents a halogen atom, and represents 1 when D represents a nitro group; and * represents a bond, 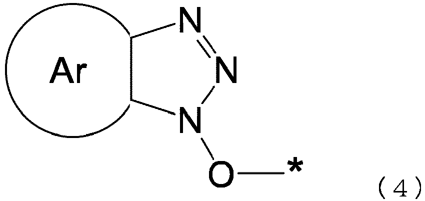
   wherein Ar represents a substituted or unsubstituted aromatic ring structure, or a heterocyclic structure having a heteroatom; and * represents a bond.

Hereinafter, the present invention will be described in detail. However, the present invention is not limited thereto.

### Component (A)

A polymer compound having a structural unit of a polyimide precursor as the component (A) according to the embodiment of the present invention is preferably a polymer compound represented by the following formula (5) from the viewpoint of film strength of a cured film to be obtained, 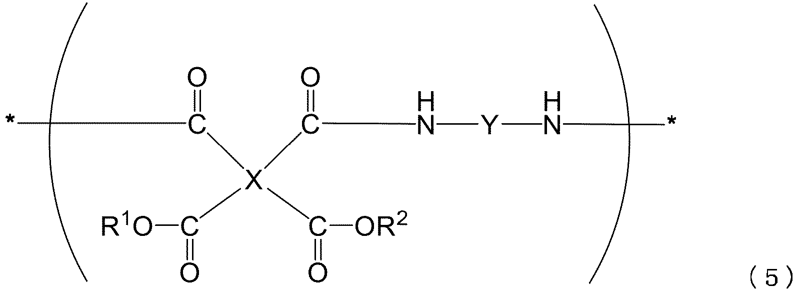
wherein X represents a tetravalent organic group; Y represents a divalent organic group; each of R¹ and R² independently represents a hydrogen atom or a monovalent organic group, and at least one of R¹ and R² represents a group represented by the following general formula (6), 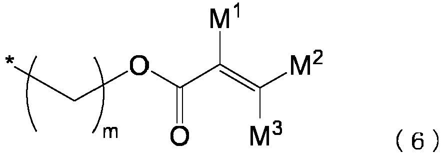
wherein each of M¹, M², and M³ independently represents a hydrogen atom or an organic group having 1 to 3 carbon atoms; "m" represents an integer of 2 to 10; and * represents a bond.

X in the above general formula (5) represents a tetravalent organic group, and is not limited as long as it is a tetravalent organic group. X preferably represents a tetravalent organic group of an alicyclic aliphatic group having 4 to 40 carbon atoms or an aromatic group. Tetravalent organic groups represented by the following formulae (7) are further preferred. Furthermore, X may have one kind of structure or a combination of two or more kinds of structures.

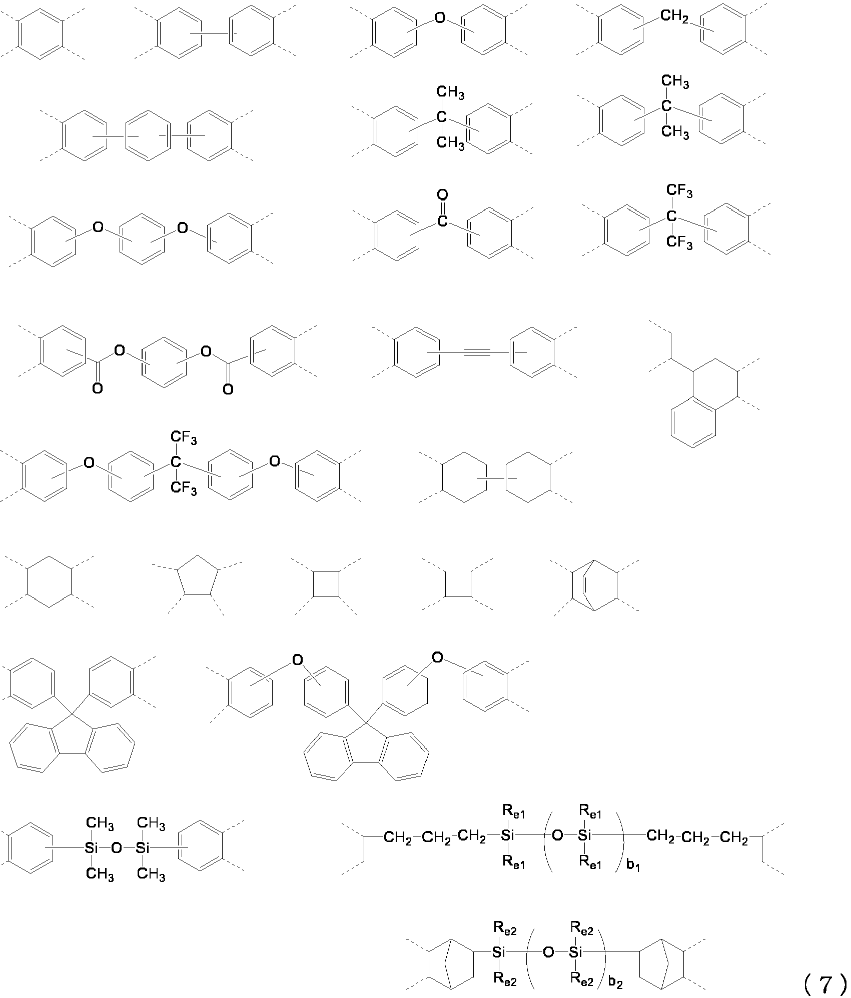

In the formulae, each of Rₑ₁ and Rₑ₂ independently represents a methyl group or a phenyl group; "b₁" and "b₂" represent an integer of 1 to 20; and a dotted line represents a bonding arm.

Y in the above general formula (5) represents a divalent organic group, and is not limited as long as it is a divalent organic group. Y preferably represents a divalent organic group having 6 to 40 carbon atoms, and more preferably represents a divalent cyclic organic group containing 1 to 4 aromatic rings or aliphatic rings having a substituent, or a divalent aliphatic group or a siloxane group having no cyclic structure. Examples of more suitable Y include any of structures represented by the following formulae (8) or (9). Furthermore, Y may have one kind of structure or a combination of two or more kinds of structures.

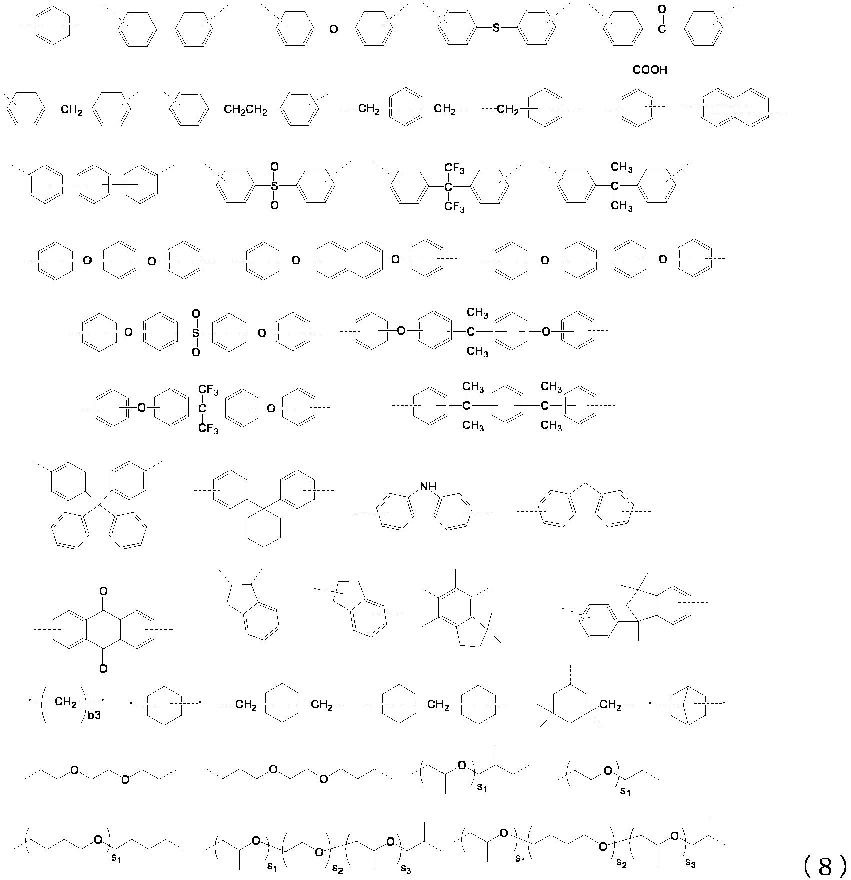

In the formulae, "b3" represents an integer of 1 to 20; "s₁" represents an integer of 1 to 40; each of "s₂" and "s₃" independently represents an integer of 0 to 40; and a dotted line represents a bonding arm. 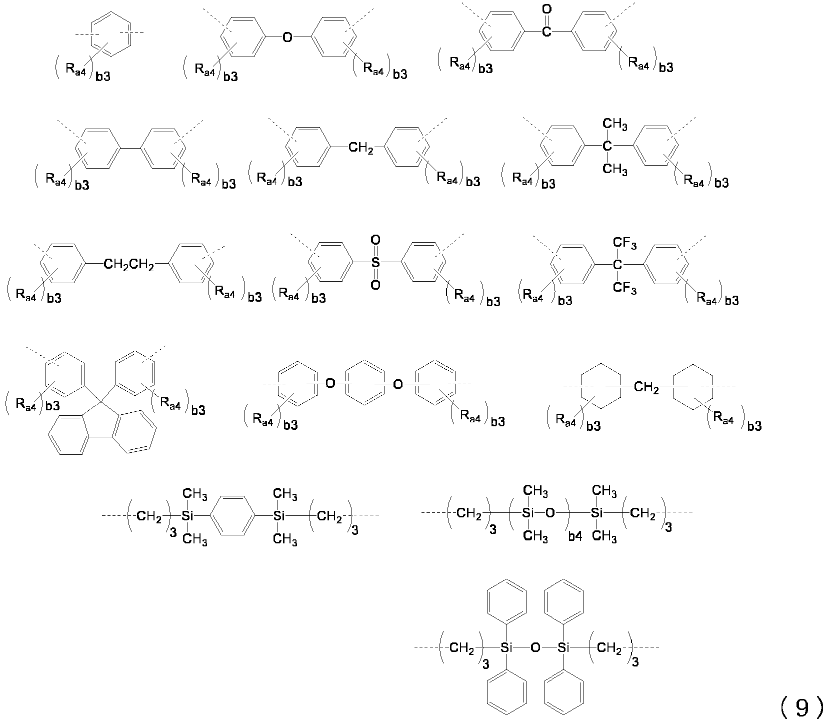 In the formulae, "b3" represents an integer of 1 to 4; Rₐ₄ represents a fluorine atom, a methyl group, an ethyl group, a propyl group, a n-butyl group, a methoxy group, an ethoxy group, a propoxy group, a butoxy group, or a trifluoromethyl group, and Rₐ₄ may be identical to or different from each other when "b3" is equal to or greater than 2; "b4" represents an integer of 1 to 40; and a dotted line represents a bonding arm.

Each of R¹ and R² in the above general formula (5) independently represents a hydrogen atom or a monovalent organic group, where the monovalent organic group can be a linear, branched, or cyclic alkyl group having 1 to 6 carbon atoms, or the organic group represented by the above general formula (6), and at least one of R¹ and R² represents the organic group represented by the above general formula (6).

M¹ in the above general formula (6) is not limited as long as it is a hydrogen atom or a monovalent organic group having 1 to 3 carbon atoms, but preferably a hydrogen atom or a methyl group from the viewpoint of photosensitivity of the negative photosensitive resin composition.

M² and M³ in the above general formula (6) are not limited as long as each independently represents a hydrogen atom or a monovalent organic group having 1 to 3 carbon atoms, but preferably a hydrogen atom from the viewpoint of photosensitivity of the negative photosensitive resin composition.

"m" in the above general formula (6) represents an integer of 2 to 10, preferably an integer of 2 to 4 from the viewpoint of photosensitivity. Further preferably, "m" represents 2.

Additionally, the polymer compound of the present invention can further contain any one or more of structural units represented by the following general formulae (10) to (12), in addition to the structural unit represented by the above general formula (5), 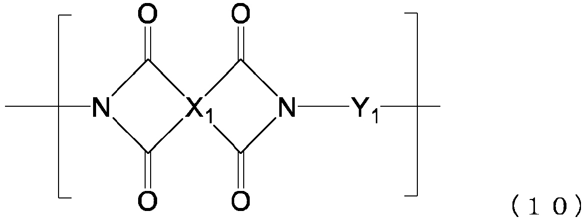
wherein X₁ represents a tetravalent organic group that is the same as or different from the X; and Y₁ represents a divalent organic group that is the same as or different from the Y, 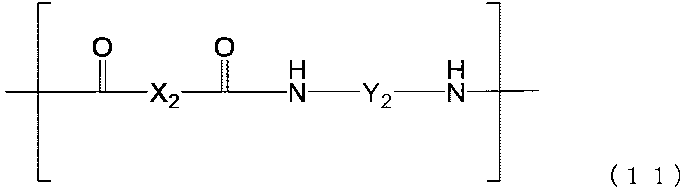
wherein X₂ represents a divalent organic group; and Y₂ represents a divalent organic group that is the same as or different from the Y, 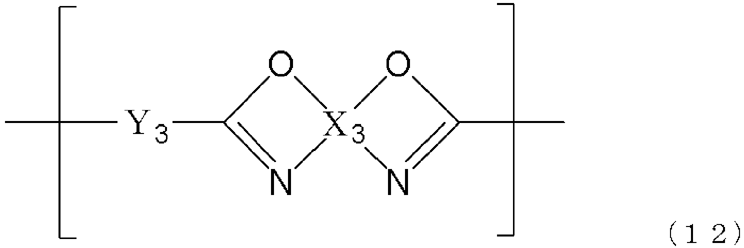
wherein Y₃ represents a divalent organic group that is the same as or different from the Y; and X₃ represents a tetravalent organic group.

X₁ in the above general formula (10) represents a tetravalent organic group, which may be the same as or different from the above **X.** X₁ is not limited as long as it is a tetravalent organic group. X₁ preferably represents a tetravalent alicyclic aliphatic group having 4 to 40 carbon atoms, or a tetravalent aromatic group having 6 to 40 carbon atoms, and may contain a siloxane skeleton. The tetravalent organic groups represented by the above formulae (7) are further preferred. Furthermore, X₁ may have one kind of structure or a combination of two or more kinds of structures.

Y₁ in the above general formula (10) represents a divalent organic group, which may be the same as or different from the above Y. Y₁ is not limited as long as it is a divalent organic group. Y₁ preferably represents a divalent organic group having 6 to 40 carbon atoms, and more preferably represents a divalent cyclic organic group containing 1 to 4 aromatic rings or aliphatic rings having a substituent, or a divalent aliphatic group or a siloxane having no cyclic structure. Examples of more suitable Y₁ include the organic groups represented by the above formulae (8) or (9). Furthermore, Y₁ may have one kind of structure or a combination of two or more kinds of structures.

The resin composition that includes the polymer compound containing the structural unit represented by the above general formula (10) is preferable because it can improve mechanical strength, adhesin to a substrate, and heat resistance of a cured film obtained by pattern formation. The structural unit (10) is also preferable because ring closure reaction is not required during post curing, allowing relatively decreased curing reaction temperature.

X₂ in the above general formula (11) represents a divalent organic group, and is not limited as long as it is a divalent organic group. X₂ preferably represents a divalent organic group having 4 to 40 carbon atoms and having a chain aliphatic structure, a divalent alicyclic aliphatic group having 4 to 40 carbon atoms, or a divalent aromatic group having 6 to 40 caron atoms. Divalent organic groups represented by the following formulae (11-1) are further preferred. Furthermore, X₂ may have one kind of structure or a combination of two or more kinds of structures.

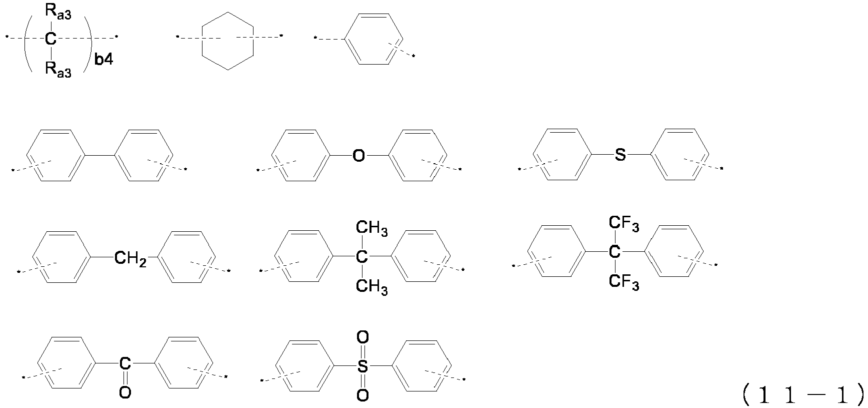

In the formulae, Rₐ₃ each independently represents a hydrogen atom, a fluorine atom, or an alkyl group having 1 to 6 carbon atoms; "b4" represents an integer of 1 to 30; and a dotted line represents a bonding arm.

Y₂ in the above general formula (11) represents a divalent organic group, which may be the same as or different from the above Y. Y₂ is not limited as long as it is a divalent organic group. Y₂ preferably represents a divalent organic group having 6 to 40 carbon atoms, which is a divalent cyclic organic group containing 1 to 4 aromatic rings or aliphatic rings having a substituent, or a divalent aliphatic group or a siloxane group having no cyclic structure.

More preferable examples thereof include the structures represented by the above formulae (8) or (9). Furthermore, Y₂ may have one kind of structure or a combination of two or more kinds of structures.

Y₃ in the above general formula (12) represents a divalent organic group, which may be the same as or different from the above Y. Y₃ is not limited as long as it is a divalent organic group. Y₃ preferably represents a divalent organic group having 4 to 40 carbon atoms and having a chain aliphatic structure, a divalent alicyclic aliphatic group having 4 to 40 carbon atoms, or a divalent aromatic group having 6 to 40 carbon atoms. The divalent organic groups represented by the above formulae (11-1) are further preferred. Furthermore, Y₃ may have one kind of structure or a combination of two or more kinds of structures.

X₃ in the above general formula (12) represents a tetravalent organic group, and is not limited as long as it is a tetravalent organic group. X₃ preferably represents a tetravalent organic group having 6 to 40 carbon atoms, and more preferably represents a tetravalent cyclic organic group containing 1 to 4 aromatic rings or aliphatic rings having a substituent, or a tetravalent aliphatic group or a siloxane group having no cyclic structure. Examples of more suitable X₃ include structures represented by the following formulae (15). Furthermore, X₃ may have one kind of structure or a combination of two or more kinds of structures.

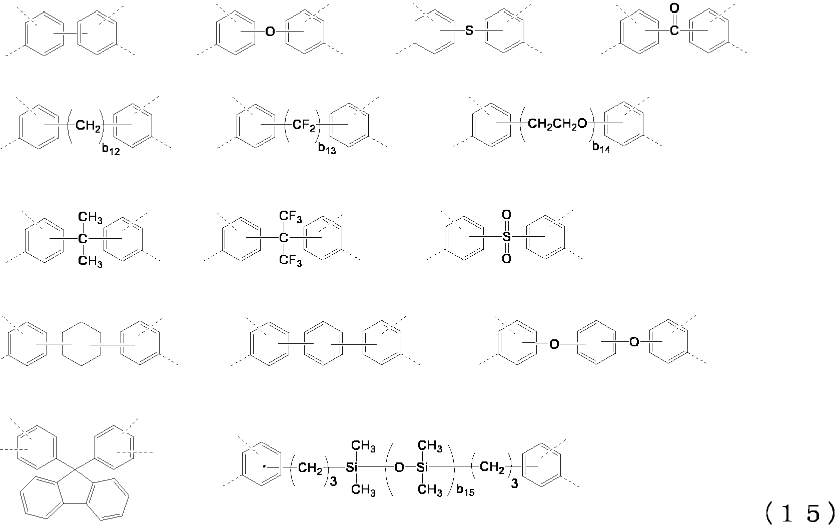

In the formulae, "b₁₂", "b₁₃". and "b₁₄" represent an integer of 1 to 10; "b₁₅" represents an integer of 1 to 20; and a dotted line represents a bonding arm.

The resin composition that includes the polymer containing the structural unit represented by the above general formula (12) is preferable because it can improve mechanical strength, adhesion to a substrate, and heat resistance of a cured film obtained by pattern formation. It is also preferable to contain the structure represented by the general formula (12) such that ring closure reaction is not required during post curing, allowing relatively decreased curing reaction temperature.

A suitable molecular weight of the polymer compound of the present invention is preferably 5,000 to 100,000, more preferably 7,000 to 50,000. The molecular weight of 5,000 or more makes it easy to form the photosensitive resin composition including the polymer compound of the present invention into a film having a desired film thickness on a substrate, whereas the molecular weight of 100,000 or less leads to proper viscosity of the photosensitive resin composition and also makes it easy to form a film thereof. Incidentally, in the present invention, the weight-average molecular weight is a value in terms of polystyrene determined by gel permeation chromatography (GPC) .

### Method for Producing Polymer Compound

The polymer compound (A) contained in the negative photosensitive resin composition of the present invention preferably contains a structural unit represented by the following general formula (5), 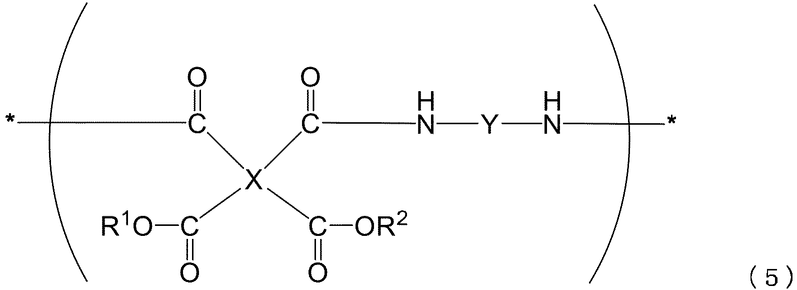
wherein X represents a tetravalent organic group; Y represents a divalent organic group; each of R¹ and R² independently represents a hydrogen atom or a monovalent organic group, and at least one of R¹ and R² represents a group represented by the following general formula (6), 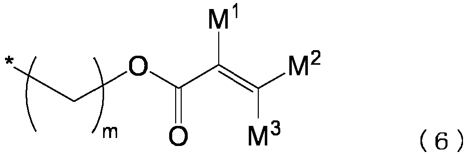
wherein each of M¹, M², and M³ independently represents a hydrogen atom or an organic group having 1 to 3 carbon atoms; "m" represents an integer of 2 to 10; and * represents a bond.

The polymer containing the structural unit represented by the above general formula (5) can be obtained by reacting a tetracarboxylic acid diester compound represented by the following general formula (16) with diamine represented by the following general formula (17), 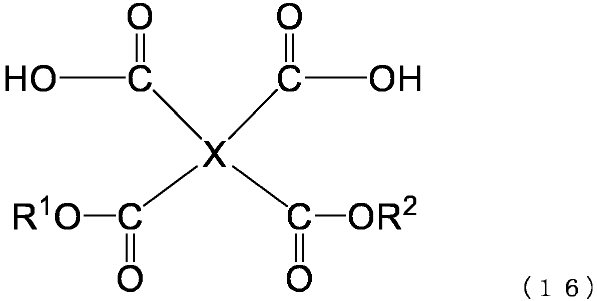
wherein X, R¹, and R² are as defined above,

   **H₂N-Y-NH₂** (1 7)
wherein Y is as defined above.

In the above general formula (16), at least one of R¹ and R² represents the organic group represented by the above general formula (6), while it is possible to introduce the organic group represented by the above general formula (6) by reacting tetracarboxylic dianhydride represented by the following general formula (18) with a compound having a hydroxyl group at its terminal represented by the following general formula (19) in the presence of a basic catalyst such as pyridine. Here, X in the above general formula (5) (for example, the tetravalent organic groups represented by the above formulae (7)) is derived from the tetracarboxylic dianhydride represented by the following general formula (18), and the organic group represented by the above general formula (6) can be introduced into the compound having a hydroxyl group at its terminal represented by the following general formula (19).

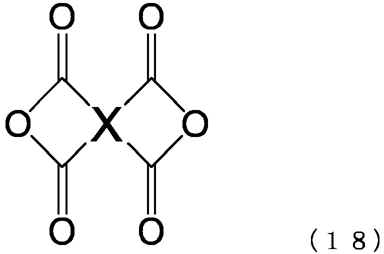

In the formula, X represents a tetravalent organic group, and is synonymous with X in the above general formula (5).

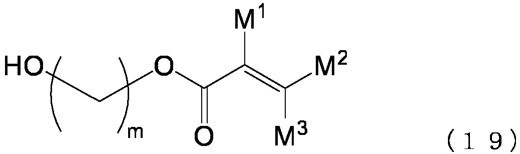

In the formula, M¹, M², M³, and "m" are respectively synonymous with M¹, M², M³, and "m" in the above general formula (6).

Suitable examples of the tetracarboxylic dianhydride represented by the above general formula (18) include aromatic acid dianhydride, alicyclic acid dianhydride, aliphatic acid dianhydride, siloxane skeleton-containing acid dianhydride, and the like.

Examples of the aromatic acid dianhydride include, but are not limited to, pyromellitic dianhydride, 3,3',4,4'-biphenyltetracarboxylic dianhydride, 2,3,3',4'-biphenyltetracarboxylic dianhydride, 2,3,2',3'-biphenyltetracarboxylic dianhydride, 3,3',4,4'-terphenyltetracarboxylic dianhydride, 3,3',4,4'-oxyphthalic dianhydride, 2,3,3',4'-oxyphthalic dianhydride, 2,3,2',3'-oxyphthalic dianhydride, diphenylsulfone-3,3',4,4'-tetracarboxylic dianhydride, benzophenone-3,3',4,4'-tetracarboxylic dianhydride, 2,2-bis(3,4-dicarboxyphenyl)propane dianhydride, 2,2-bis(2,3-dicarboxyphenyl)propane dianhydride, 1,1-bis(3,4-dicarboxyphenyl)ethane dianhydride, 1,1-bis(2,3-dicarboxyphenyl)ethane dianhydride, bis(3,4-dicarboxyphenyl)methane dianhydride, bis(2,3-dicarboxyphenyl)methane dianhydride, 1,4-(3,4-dicarboxyphenoxy)benzene dianhydride, p-phenylenebis(trimellitic monoester anhydride), bis(1,3-dioxo-1,3-dihydroisobenzfuran-5-carboxylic acid)1,4-phenylene, 2,2-bis(4-(4-aminophenoxy)phenyl)propane, 1,2,5,6-naphthalenetetracarboxylic dianhydride, 2,3,6,7-naphthalenetetracarboxylic dianhydride, 9,9-bis(3,4-dicarboxyphenyl)fluorene dianhydride, 9,9-bis(4-(3,4-dicarboxyphenoxy) phenyl) fluorene dianhydride, 2,3,5,6-pyridinetetracarboxylic dianhydride, 3,4,9,10-perylenetetracarboxylic dianhydride, 2,2-bis(3,4-dicarboxyphenyl)hexafluoropropane dianhydride, 2,2-bis(4-(3,4-dicarboxybenzoyloxy)phenyl)hexafluoropropane dianhydride, 1,6-difluoropyromellitic dianhydride, 1-trifluoromethylpyromellitic dianhydride, 1,6-ditrifluoromethylpyromellitic dianhydride, 2,2'-bis(trifluoromethyl)-4,4'-bis(3,4-dicarboxyphenoxy)biphenyl dianhydride, 2,2'-bis[(dicarboxyphenoxy)phenyl]propane dianhydride, 2,2'-bis[(dicarboxyphenoxy)phenyl]hexafluoropropane dianhydride, acid dianhydride compounds obtained by substituting these aromatic rings with an alkyl group, an alkoxy group, a halogen atom, or the like, etc.

Examples of the alicyclic acid dianhydride include, but are not limited to, 1,2,3,4-cyclobutanetetracarboxylic dianhydride, 1,2,3,4-cyclopentanetetracarboxylic dianhydride, 1,2,4,5-cyclohexanetetracarboxylic dianhydride, 1,2,4,5-cyclopentanetetracarboxylic dianhydride, 1,2,3,4-tetramethyl-1,2,3,4-cyclobutanetetracarboxylic dianhydride, 1,2-dimethyl-1,2,3,4-cyclobutanetetracarboxylic dianhydride, 1,3-dimethyl-1,2,3,4-cyclobutanetetracarboxylic dianhydride, 1,2,3,4-cycloheptanetetracarboxylic dianhydride, 2,3,4,5-tetrahydrofuran tetracarboxylic dianhydride, 3,4-dicarboxy-1-cyclohexylsuccinic dianhydride, 2,3,5-tricarboxycyclopentylacetic dianhydride, 3,4-dicarboxy-1,2,3,4-tetrahydro-1-naphthalenesuccinic dianhydride, bicyclo[3,3,0]octane-2,4,6,8-tetracarboxylic dianhydride, bicyclo[4,3,0]nonane-2,4,7,9-tetracarboxylic dianhydride, bicyclo[4,4,0]decane-2,4,7,9-tetracarboxylic dianhydride, bicyclo[4,4,0]decane-2,4,8,10-tetracarboxylic dianhydride, tricyclo[6,3,0,02,6]undecane-3,5,9,11-tetracarboxylic dianhydride, bicyclo[2,2,2]octane-2,3,5,6-tetracarboxylic dianhydride, bicyclo[2,2,2]oct-7-ene-2,3,5,6-tetracarboxylic dianhydride, bicyclo[2,2,1]heptanetetracarboxylic dianhydride, bicyclo[2,2,1]heptane-5-carboxymethyl-2,3,6-tricarboxylic dianhydride, 7-oxabicyclo[2,2,1]heptane-2,4,6,8-tetracarboxylic dianhydride, octahydronaphthalene-1,2,6,7-tetracarboxylic dianhydride, tetradecahydroanthracene-1,2,8,9-tetracarboxylic dianhydride, 3,3',4,4'-dicyclohexanetetracarboxylic dianhydride, 3,3',4,4'-oxydicyclohexanetetracarboxylic dianhydride, 5-(2,5-dioxotetrahydro-3-furanyl)-3-methyl-3-cyclohexene-1,2-dicarboxylic dianhydride, "RIKACID" (registered trademark) BT-100 (trade name, manufactured by New Japan Chemical **Co.,** Ltd.) and derivatives thereof, as well as acid dianhydride compounds obtained by substituting these alicyclic rings with an alkyl group, an alkoxy group, a halogen atom, or the like, etc.

Examples of the aliphatic acid dianhydride include, but are not limited to, 1,2,3,4-butanetetracarboxylic dianhydride, 1,2,3,4-pentanetetracarboxylic dianhydride, derivatives thereof, etc.

Examples of the siloxane skeleton-containing acid dianhydride include, but are not limited to, 1,3-bis(3,4-dicarboxyphenyl)-1,1,3,3-tetramethyldisiloxane dianhydride, 3,3'-((1,1,3,3-tetramethyl-1,3-disiloxanediyl)di-3,1-propanediyl)bis(dihydro-2,5-furandione), derivatives thereof, etc.

These aromatic acid dianhydride, alicyclic acid dianhydride, aliphatic acid dianhydride, and siloxane skeleton-containing acid dianhydride can be used alone or in combination of two or more kinds thereof.

M¹ in the above general formula (19) is not limited as long as it is a hydrogen atom or a monovalent organic group having 1 to 3 carbon atoms. M¹ preferably represents a hydrogen atom or a methyl group from the view point of photosensitivity of the negative photosensitive resin composition.

M² and M³ in the above general formula (19) are not limited as long as each independently represents a hydrogen atom or a monovalent organic group having 1 to 3 carbon atoms, but preferably a hydrogen atom from the viewpoint of photosensitivity of the negative photosensitive resin composition.

"m" in the above general formula (19) represents an integer of 2 to 10, preferably an integer of 2 to 4 from the viewpoint of photosensitivity. More preferably, "m" represents 2.

Examples of a suitable compound as the compound having a hydroxyl group at its terminal represented by the above general formula (19) include 2-acryloyloxyethyl alcohol, 1-acryloyloxy-3-propyl alcohol, 2-methacryloyloxyethyl alcohol, 1-methacryloyloxy-3-propyl alcohol, and the like.

Moreover, R¹ and R² in the above general formula (5) may be a linear, branched, or cyclic alkyl group having 1 to 6 carbon atoms. As a method for introducing a linear, branched, or cyclic alkyl group having 1 to 6 carbon atoms into the above general formula (5) (i.e. making R¹ and R² a linear, branched, or cyclic alkyl group having 1 to 6 carbon atoms), a linear, branched, or cyclic alcohol having 1 to 6 carbon atoms is simultaneously added in the reaction between the compound having a hydroxyl group at its terminal represented by the above general formula (19) and the tetracarboxylic dianhydride in the presence of a basic catalyst such as pyridine.

Suitable examples of the alcohol usable in this event include methanol, ethanol, 1-propanol, 2-propanol, 1-butanol, 2-butanol, 1-pentanol, 2-pentanol, 3-pentanol, neopentyl alcohol, 1-hexanol, 2-hexanol, 3-hexanol, cyclopentanol, cyclohexanol, and the like.

In the reaction between the tetracarboxylic dianhydride represented by the above general formula (18) and the compound having a hydroxyl group at its terminal represented by the above general formula (19), the tetracarboxylic dianhydride represented by the above general formula (18) and the compound having a hydroxyl group at its terminal represented by the above general formula (19) are stirred, dissolved, and mixed in a reaction solvent at a reaction temperature of 20 to 50°C for 4 to 10 hours in the presence of a basic catalyst such as pyridine, thereby allowing half-esterification reaction of the acid dianhydride to proceed to obtain a solution in which the desired tetracarboxylic acid diester compound represented by the above general formula (16) is dissolved in the reaction solvent.

The tetracarboxylic acid diester compound thus obtained may be isolated, or the obtained solution may be directly used for the reaction with diamine in the subsequent step as described later.

The above reaction solvent is preferably a solvent capable of well dissolving the tetracarboxylic acid diester compound and the polymer having the structural unit of the polyimide precursor obtained by the subsequent polycondensation reaction between the tetracarboxylic acid diester compound and diamines. Examples thereof include N-methyl-2-pyrrolidone, N,N-dimethylacetamide, N,N-dimethylformamide, dimethyl sulfoxide, tetramethylurea, γ-butyrolactone, and the like. Further, ketones, esters, lactones, ethers, halogenated hydrocarbons, hydrocarbons, and the like are also usable. Specific examples thereof include acetone, methyl ethyl ketone, methyl isobutyl ketone, cyclohexanone, methyl acetate, ethyl acetate, butyl acetate, diethyl oxalate, ethylene glycol dimethyl ether, diethylene glycol dimethyl ether, tetrahydrofuran, dichloromethane, 1,2-dichloroethane, 1,4-dichlorobutane, chlorobenzene, o-dichlorobenzene, hexane, heptane, benzene, toluene, xylene, and the like. These may be used alone or in mixture of two or more thereof as necessary.

Suitable examples of the diamine represented by the above general formula (17) include, but are not limited to, (2-methyl-4-amino)phenyl-4-aminobenzoate, (3-methyl-4-amino)phenyl-4-aminobenzoate, (2-ethyl-4-amino)phenyl-4-aminobenzoate, (3-ethyl-4-amino)phenyl-4-aminobenzoate, (2-propyl-4-amino)phenyl-4-aminobenzoate, (3-propyl-4-amino)phenyl-4-aminobenzoate, (2-isopropyl-4-amino)phenyl-4-aminobenzoate, (3-isopropyl-4-amino)phenyl-4-aminobenzoate, (2-butyl-4-amino)phenyl-4-aminobenzoate, (3-butyl-4-amino)phenyl-4-aminobenzoate, (2-isobutyl-4-amino)phenyl-4-aminobenzoate, (3-isobutyl-4-amino)phenyl-4-aminobenzoate, (2-pentyl-4-amino)phenyl-4-aminobenzoate, (3-pentyl-4-amino)phenyl-4-aminobenzoate, (2-hexyl-4-amino)phenyl-4-aminobenzoate, (3-hexyl-4-amino)phenyl-4-aminobenzoate, (2-methoxy-4-amino)phenyl-4-aminobenzoate, (3-methoxy-4-amino)phenyl-4-aminobenzoate, (2-ethoxy-4-amino)phenyl-4-aminobenzoate, (3-ethoxy-4-amino)phenyl-4-aminobenzoate, (2-propoxy-4-amino)phenyl-4-aminobenzoate, (3-propoxy-4-amino)phenyl-4-aminobenzoate, (2-butoxy-4-amino)phenyl-4-aminobenzoate, (3-butoxy-4-amino)phenyl-4-aminobenzoate, (2-pentoxy-4-amino)phenyl-4-aminobenzoate, (3-pentoxy-4-amino)phenyl-4-aminobenzoate, (2-phenyl-4-amino)phenyl-4-aminobenzoate, (3-phenyl-4-amino)phenyl-4-aminobenzoate, (2-methylphenyl-4-amino)phenyl-4-aminobenzoate, (3-methylphenyl-4-amino)phenyl-4-aminobenzoate, (2-ethylphenyl-4-amino)phenyl-4-aminobenzoate, (3-ethylphenyl-4-amino)phenyl-4-aminobenzoate, (2-propylphenyl-4-amino)phenyl-4-aminobenzoate, (3-propylphenyl-4-amino)phenyl-4-aminobenzoate, (2-butylphenyl-4-amino)phenyl-4-aminobenzoate, (3-butylphenyl-4-amino)phenyl-4-aminobenzoate, (2-fluorophenyl-4-amino)phenyl-4-aminobenzoate, (3-fluorophenyl-4-amino)phenyl-4-aminobenzoate, (2-chlorophenyl-4-amino)phenyl-4-aminobenzoate, (3-chlorophenyl-4-amino)phenyl-4-aminobenzoate, (2-bromophenyl-4-amino)phenyl-4-aminobenzoate, (3-bromophenyl-4-amino)phenyl-4-aminobenzoate, (2-methoxyphenyl-4-amino)phenyl-4-aminobenzoate, (3-methoxyphenyl-4-amino)phenyl-4-aminobenzoate, (2-ethoxyphenyl-4-amino)phenyl-4-aminobenzoate, (3-ethoxyphenyl-4-amino)phenyl-4-aminobenzoate, (2-ethoxyphenyl-4-amino)phenyl-4-aminobenzoate, (2-aminophenyl-4-amino)phenyl-4-aminobenzoate, (3-aminophenyl-4-amino)phenyl-4-aminobenzoate, (2-nitrophenyl-4-amino)phenyl-4-aminobenzoate, (3-nitrophenyl-4-amino)phenyl-4-aminobenzoate, (2-cyanophenyl-4-amino)phenyl-4-aminobenzoate, (3-cyanophenyl-4-amino)phenyl-4-aminobenzoate, (2-phenylethyl-4-amino)phenyl-4-aminobenzoate, (3-phenylethyl-4-amino)phenyl-4-aminobenzoate, (2-phenylamino-4-amino)phenyl-4-aminobenzoate, (3-phenylamino-4-amino)phenyl-4-aminobenzoate, (2-(4,4'-biphenyl)-4-amino)phenyl-4-aminobenzoate, (3-(4,4'-biphenyl)-4-amino)phenyl-4-aminobenzoate, (2-naphthyl-4-amino)phenyl-4-aminobenzoate, (3-naphthyl-4-amino)phenyl-4-aminobenzoate, (2-methylphenoxy-4-amino)phenyl-4-aminobenzoate, (3-methylphenoxy-4-amino)phenyl-4-aminobenzoate, (2-ethylphenoxy-4-amino)phenyl-4-aminobenzoate, (3-ethylphenoxy-4-amino)phenyl-4-aminobenzoate, (2-propylphenoxy-4-amino)phenyl-4-aminobenzoate, (3-propylphenoxy-4-amino)phenyl-4-aminobenzoate, (2-methoxyphenoxy-4-amino)phenyl-4-aminobenzoate, (3-methoxyphenoxy-4-amino)phenyl-4-aminobenzoate, (2-ethoxyphenoxy-4-amino)phenyl-4-aminobenzoate, (3-ethoxyphenoxy-4-amino)phenyl-4-aminobenzoate, (2-benzyl-4-amino)phenyl-4-aminobenzoate, (3-benzyl-4-amino)phenyl-4-aminobenzoate, (2-methylbenzyl-4-amino)phenyl-4-aminobenzoate, (3-methylbenzyl-4-amino)phenyl-4-aminobenzoate, (2-ethylbenzyl-4-amino)phenyl-4-aminobenzoate, (3-ethylbenzyl-4-amino)phenyl-4-aminobenzoate, (2-propylbenzyl-4-amino)phenyl-4-aminobenzoate, (3-propylbenzyl-4-amino)phenyl-4-aminobenzoate, (2-methoxybenzyl-4-amino)phenyl-4-aminobenzoate, (3-methoxybenzyl-4-amino)phenyl-4-aminobenzoate, (2-ethoxybenzyl-4-amino)phenyl-4-aminobenzoate, (3-ethoxybenzyl-4-amino)phenyl-4-aminobenzoate, (2-aminobenzyl-4-amino)phenyl-4-aminobenzoate, (3-aminobenzyl-4-amino)phenyl-4-aminobenzoate, (2-nitrobenzyl-4-amino)phenyl-4-aminobenzoate, (3-nitrobenzyl-4-amino)phenyl-4-aminobenzoate, (2-cyanobenzyl-4-amino)phenyl-4-aminobenzoate, (3-cyanobenzyl-4-amino)phenyl-4-aminobenzoate, (2-benzyloxy-4-amino)phenyl-4-aminobenzoate, (3-benzyloxy-4-amino)phenyl-4-aminobenzoate, (2-methylbenzyloxy-4-amino)phenyl-4-aminobenzoate, (3-methylbenzyloxy-4-amino)phenyl-4-aminobenzoate, (2-ethylbenzyloxy-4-amino)phenyl-4-aminobenzoate, (3-ethylbenzyloxy-4-amino)phenyl-4-aminobenzoate, (2-propylbenzyloxy-4-amino)phenyl-4-aminobenzoate, (3-propylbenzyloxy-4-amino)phenyl-4-aminobenzoate, (2-methoxybenzyloxy-4-amino)phenyl-4-aminobenzoate, (3-methoxybenzyloxy-4-amino)phenyl-4-aminobenzoate, (2-ethoxybenzyloxy-4-amino)phenyl-4-aminobenzoate, (3-ethoxybenzyloxy-4-amino)phenyl-4-aminobenzoate, 4-(4-aminophenoxy)-3-methylbenzenamine, 4-(4-aminophenoxy)-2-methylbenzenamine, 4-(4-aminophenoxy)-3-ethylbenzenamine, 4-(4-aminophenoxy)-2-ethylbenzenamine, 4-(4-aminophenoxy)-3-propylbenzenamine, 4-(4-aminophenoxy)-2-propylbenzenamine, 4-(4-aminophenoxy)-3-isopropylbenzenamine, 4-(4-aminophenoxy)-2-isopropylbenzenamine, 4-(4-aminophenoxy)-3-butylbenzenamine, 4-(4-aminophenoxy)-2-butylbenzenamine, 4-(4-aminophenoxy)-3-isobutylbenzenamin, 4-(4-aminophenoxy)-2-isobutylbenzenamine,

4-(4-aminophenoxy)-3-pentylbenzenamine, 4-(4-aminophenoxy)-2-pentylbenzenamine, 4-(4-aminophenoxy)-3-hexylbenzenamine, 4-(4-aminophenoxy)-2-hexylbenzenamine, 4-(4-aminophenoxy)-3-(trifluoromethyl)benzenamine, 4-(4-aminophenoxy)-2-(trifluoromethyl)benzenamine, 4-(4-aminophenoxy)-3-methoxybenzenamine, 4-(4-aminophenoxy)-2-methoxybenzenamine, 4-(4-aminophenoxy)-3-ethoxybenzenamine, 4-(4-aminophenoxy)-2-ethoxybenzenamine, 4-(4-aminophenoxy)-3-propoxybenzenamine, 4-(4-aminophenoxy)-2-propoxybenzenamine, 4-(4-aminophenoxy)-3-butoxybenzenamine, 4-(4-aminophenoxy)-2-butoxybenzenamine, 4-(4-aminophenoxy)-3-phenylbenzenamine, 4-(4-aminophenoxy)-2-phenylbenzenamine, 4-(4-aminophenoxy)-3-methylphenylbenzenamine, 4-(4-aminophenoxy)-2-methylphenylbenzenamine, 4-(4-aminophenoxy)-3-ethylphenylbenzenamine, 4-(4-aminophenoxy)-2-ethylphenylbenzenamine, 4-(4-aminophenoxy)-3-propylphenylbenzenamine, 4-(4-aminophenoxy)-2-propylphenylbenzenamine, 4-(4-aminophenoxy)-3-butylphenylbenzenamine, 4-(4-aminophenoxy)-2-butylphenylbenzenamine, 4-(4-aminophenoxy)-3-fluorophenylbenzenamine, 4-(4-aminophenoxy)-2-fluorophenylbenzenamine, 4-(4-aminophenoxy)-3-chlorophenylbenzenamine, 4-(4-aminophenoxy)-2-chlorophenylbenzenamine, 4-(4-aminophenoxy)-3-bromophenylbenzenamine, 4-(4-aminophenoxy)-2-bromophenylbenzenamine, 4-(4-aminophenoxy)-3-methoxyphenylbenzenamine, 4-(4-aminophenoxy)-2-methoxyphenylbenzenamine, 4-(4-aminophenoxy)-3-ethoxyphenylbenzenamine, 4-(4-aminophenoxy)-2-ethoxyphenylbenzenamine, 4-(4-aminophenoxy)-3-(phenylethyl)phenylbenzenamine, 4-(4-aminophenoxy)-2-(phenylethyl)phenylbenzenamine, 4-(4-aminophenoxy)-3-naphthylphenylbenzenamine, 4-(4-aminophenoxy)-2-naphthylphenylbenzenamine, 4-(4-aminophenoxy)-3-benzylphenylbenzenamine, 4-(4-aminophenoxy)-2-benzylphenylbenzenamine, 4-((4-aminophenyl)thio)-3-methylbenzenamine, 4-((4-aminophenyl)thio)-2-methylbenzenamine, 4-((4-aminophenyl)thio)-3-ethylbenzenamine, 4-((4-aminophenyl)thio)-2-ethylbenzenamine, 4-((4-aminophenyl)thio)-3-propylbenzenamine, 4-((4-aminophenyl)thio)-2-propylbenzenamine, 4-((4-aminophenyl)thio)-3-isopropylbenzenamine, 4-((4-aminophenyl)thio)-2-isopropylbenzenamine, 4-((4-aminophenyl)thio)-3-butylbenzenamine, 4-((4-aminophenyl)thio)-2-butylbenzenamine, 4-((4-aminophenyl)thio)-3-isobutylbenzenamine, 4-((4-aminophenyl)thio)-2-isobutylbenzenamine, 4-((4-aminophenyl)thio)-3-(trifluoromethyl)benzenamine, 4-((4-aminophenyl)thio)-2-(trifluoromethyl)benzenamine, 4-((4-aminophenyl)thio)-3-methoxybenzenamine, 4-((4-aminophenyl)thio)-2-methoxybenzenamine, 4-((4-aminophenyl)thio)-3-ethoxybenzenamine, 4-((4-aminophenyl)thio)-2-ethoxybenzenamine, 4-((4-aminophenyl)thio)-3-propoxybenzenamine, 4-((4-aminophenyl)thio)-2-propoxybenzenamine, 4-((4-aminophenyl)thio)-3-isopropoxybenzenamine, 4-((4-aminophenyl)thio)-2-isopropoxybenzenamine, 4-((4-aminophenyl)thio)-3-butoxybenzenamine, 4-((4-aminophenyl)thio)-2-butoxybenzenamine, 4-((4-aminophenyl)thio)-3-phenylbenzenamine, 4-((4-aminophenyl)thio)-2-phenylbenzenamine, 4-((4-aminophenyl)thio)-3-naphtylbenzenamine, 4-((4-aminophenyl)thio)-2-naphtylbenzenamine, 4-((4-aminophenyl)thio)-3-methoxyphenylbenzenamine, 4-((4-aminophenyl)thio)-2-methoxyphenylbenzenamine, 4-((4-aminophenyl)methyl)-3-methylbenzenamine, 4-((4-aminophenyl)methyl)-2-methylbenzenamine, 4-((4-aminophenyl)methyl)-3-ethylbenzenamine, 4-((4-aminophenyl)methyl)-2-ethylbenzenamine, 4-((4-aminophenyl)methyl)-3-propylbenzenamine, 4-((4-aminophenyl)methyl)-2-propylbenzenamine, 4-((4-aminophenyl)methyl)-3-isopropylbenzenamine, 4-((4-aminophenyl)methyl)-2-isopropylbenzenamine, 4-((4-aminophenyl)methyl)-3-butylbenzenamine, 4-((4-aminophenyl)methyl)-2-butylbenzenamine, 4-((4-aminophenyl)methyl)-3-isobutylbenzenamine, 4-((4-aminophenyl)methyl)-2-isobutylbenzenamine, 4-((4-aminophenyl)methyl)-3-(trifluoromethyl)benzenamine, 4-((4-aminophenyl)methyl)-2-(trifluoromethyl)benzenamine, 4-((4-aminophenyl)methyl)-3-methoxybenzenamine, 4-((4-aminophenyl)methyl)-2-methoxybenzenamine, 4-((4-aminophenyl)methyl)-3-ethoxybenzenamine, 4-((4-aminophenyl)methyl)-2-ethoxybenzenamine, 4-((4-aminophenyl)methyl)-3-propoxybenzenamine, 4-((4-aminophenyl)methyl)-2-propoxybenzenamine, 4-((4-aminophenyl)methyl)-3-isopropoxybenzenamine, 4-((4-aminophenyl)methyl)-2-isopropoxybenzenamine, 4-((4-aminophenyl)methyl)-3-butoxybenzenamine, 4-((4-aminophenyl)methyl)-2-butoxybenzenamine, 4-((4-aminophenyl)methyl)-3-phenylbenzenamine, 4-((4-aminophenyl)methyl)-2-phenylbenzenamine, 4-((4-aminophenyl)methyl)-3-naphthylbenzenamine, 4-((4-aminophenyl)methyl)-2-naphtylbenzenamine, 4-((4-aminophenyl)methyl)-3-methoxyphenylbenzenamine, 4-((4-aminophenyl)methyl)-2-methoxyphenylbenzenamine, (4-amino-2-methylphenyl)(4-aminophenyl)methanone, (4-amino-2-ethylphenyl)(4-aminophenyl)methanone, (4-amino-2-propylphenyl) (4-aminophenyl)methanone, (4-amino-2-isopropylphenyl) (4-aminophenyl)methanone, (4-amino-2-butylphenyl) (4-aminophenyl)methanone, (4-amino-2-(trifluoromethyl)phenyl)(4-aminophenyl)methanone, 4-amino-2-methoxyphenyl)(4-aminophenyl)methanone, 4-amino-2-ethoxyphenyl)(4-aminophenyl)methanone, (4-amino-2-(phenyl)phenyl)(4-aminophenyl)methanone, and (4-amino-2-(methoxyphenyl)phenyl)(4-aminophenyl)methanone.

Here, the polymer compound having the polyimide precursor containing the structural unit represented by the above general formula (5) can be obtained by, for example, reacting the tetracarboxylic acid diester compound represented by the above general formula (16) with the diamine represented by the above general formula (17) in the presence of a dehydration condensation agent. In other words, the tetracarboxylic acid diester compound represented by the above general formula (16) is used for the reaction in a dissolved state in the above reaction solvent, and a known dehydration condensation agent (for example, dicyclohexylcarbodiimide, 1-ethoxycarbonyl-2-ethoxy-1,2-dihydroquinoline, 1,1-carbonyldioxy-di-1,2,3-benzotriazole, N,N'-disuccinimidyl carbonate, etc.) is added to and mixed with this reaction solution under ice cooling to convert the tetracarboxylic acid diester compound represented by the above general formula (16) into polyanhydride; then, the diamine represented by the above general formula (17), which is separately dissolved or dispersed in a solvent, is added dropwise thereto, followed by polycondensation, thereby yielding the polymer compound having the polyimide precursor containing the structural unit represented by the above general formula (5).

Further, as another method in which the tetracarboxylic acid diester compound represented by the above general formula (16) is reacted with the diamine compound represented by the above general formula (17) to obtain the polymer compound having the polyimide precursor containing the structural unit represented by the above general formula (5), there is a synthesis method in which the tetracarboxylic acid diester compound represented by the above general formula (16) is converted into an acid chloride by using a chlorinating agent such as thionyl chloride or dichlorooxalic acid, and reacted with the diamine represented by the above general formula (17).

For the reaction in which the above-described tetracarboxylic acid diester compound is converted into an acid chloride by using a chlorinating agent, a basic compound may be used. As this basic compound, for example, pyridine, 4-dimethylaminopyridine, triethylamine, or the like can be used.

Next, by reacting the obtained acid chloride of the tetracarboxylic acid diester compound with the diamine represented by the above general formula (17) in the presence of a basic catalyst, the intended polymer compound having the polyimide precursor containing the structural unit represented by the above general formula (5) can be obtained. In this event, examples of the basic catalyst include pyridine, dimethylaminopyridine, 1,8-diazabicyclo[5.4.0]undec-7-ene, 1,5-diazabicyclo[4.3.0]non-5-ene, and the like.

In the method for producing the polymer compound having the polyimide precursor to be used in the negative photosensitive resin composition of the present invention, a solvent used in the process through the acid chloride is preferably a solvent that well dissolves the tetracarboxylic acid diester compound and the acid chloride thereof, as well as the polymer of the polyimide precursor obtained by polycondensation reaction with diamines, and a solvent similar to those described above is usable. Specific examples thereof include N-methyl-2-pyrrolidone, N,N-dimethylacetamide, N,N-dimethylformamide, dimethyl sulfoxide, tetramethylurea, hexamethylphosphoric triamide, γ-butyrolactone, and the like. Besides the polar solvents, ketones, esters, lactones, ethers, halogenated hydrocarbons, hydrocarbons, and the like are also usable. Examples thereof include acetone, diethyl ketone, methyl ethyl ketone, methyl isobutyl ketone, cyclohexanone, methyl acetate, ethyl acetate, butyl acetate, diethyl oxalate, diethyl malonate, diethyl ether, ethylene glycol dimethyl ether, diethylene glycol dimethyl ether, tetrahydrofuran, dichloromethane, 1,2-dichloroethane, 1,4-dichlorobutane, trichloroethane, chlorobenzene, o-dichlorobenzene, hexane, heptane, octane, benzene, toluene, xylene, and the like. These organic solvents may be used alone or in combination of two or more.

Further, as described above, the polymer compound having the polyimide precursor to be used in the negative photosensitive resin composition of the present invention can further contain a structural unit represented by the following general formula (10), in addition to the structural unit represented by the above general formula (5), 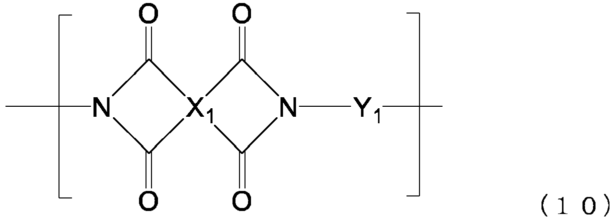 wherein X₁ and Y₁ are as defined above.

The polymer containing the structural unit represented by the above general formula (10) can be obtained by reacting tetracarboxylic dianhydride represented by the following general formula (20) with diamine represented by the following general formula (21). The polymer containing the structural unit (10) can be obtained by firstly reacting the tetracarboxylic dianhydride represented by the following general formula (20) with the diamine represented by the following general formula (21) to synthesize amide acid, and then performing chemical imidization or imidization through thermal dehydration.

The structural unit (10) can be produced by dissolving the diamine in a solvent having a high boiling point and high polarity, such as γ-butyrolactone and N-methyl-2-pyrrolidone, then adding the acid anhydride thereto and reacting the resultant at 0 to 80°C, preferably 10 to 50°C to form amid acid, followed by chemical imidization in which imidization reaction is performed, for example, by adding acetic anhydride and pyridine, or imidization through thermal dehydration in which a nonpolar solvent such as xylene is added and imidization reaction is performed while removing water from the reaction system by heating to 100 to 200°C, preferably 130 to 180°C.

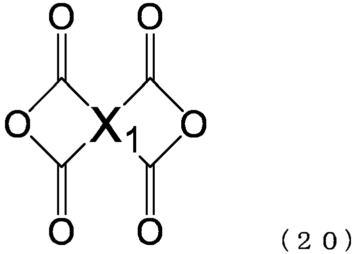

In **the** formula, X₁ is as defined above.

H₂N-Y₁-NH₂ (21)

In the formula, Y₁ is as defined above.

Suitable examples of the tetracarboxylic dianhydride represented by the above general formula (20) include the examples of the tetracarboxylic dianhydride represented by the above general formula (18).

Suitable examples of the diamine represented by the above general formula (21) include the examples of the diamine represented by the above general formula (17).

Further, as described above, the polymer compound having the polyimide precursor to be used in the negative photosensitive resin composition of the present invention can further contain a structural unit represented by the following general formula (11), in addition to the structural unit represented by the above general formula (5), 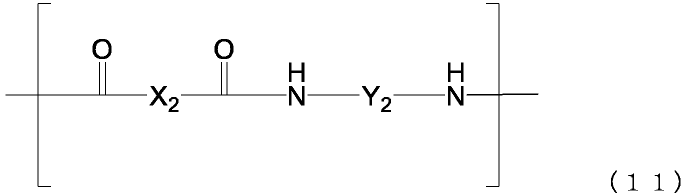 wherein X₂ and Y₂ are as defined above.

The polymer containing the structural unit represented by the above general formula (11) can be obtained according to the same reaction procedure as the structural unit (5). In other words, the polymer can be obtained by reacting a dicarboxylic acid compound represented by the following general formula (22) in the presence of a dehydration condensation agent or converting the dicarboxylic acid compound into an acid chloride by using a chlorinating agent, followed by reaction with diamine represented by the general formula (23).

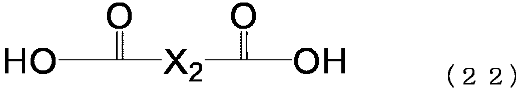

In the formula, X₂ is as defined above.

H₂N-Y₂-NH₂ (23)

In the formula, Y₂ is as defined above.

Examples of the dicarboxylic acid compound represented by the above general formula (22) include malonic acid, dimethylmalonic acid, ethylmalonic acid, isopropylmalonic acid, di-n-butylmalonic acid, succinic acid, tetrafluorosuccinic acid, methylsuccinic acid, 2,2-dimethylsuccinic acid, 2,3-dimethylsuccinic acid, dimethylmethylsuccinic acid, glutaric acid, hexafluoroglutaric acid, 2-methylglutaric acid, **3-**methylglutaric acid, 2,2-dimethylglutaric acid, **3,3-**dimethylglutaric acid, 3-ethyl-3-methylglutaric acid, adipic acid, octafluoroadipic acid, 3-methyladipic acid, octafluoroadipic acid, pimelic acid, 2,2,6,6-tetramethylpimelic acid, suberic acid, dodecafluorosuberic acid, azelaic acid, sebacic acid, hexadecafluorosebacic acid, 1,9-nonanedioic acid, dodecanedioic acid, tridecanedioic acid, tetradecanedioic acid, pentadecanedioic acid, hexadecanedioic acid, heptadecanedioic acid, octadecanedioic acid, nonadecanedioic acid, eicosanedioic acid, heneicosanedioic acid, docosanedioic acid, tricosanedioic acid, tetracosanedioic acid, pentacosanedioic acid, hexacosanedioic acid, heptacosanedioic acid, octacosanedioic acid, nonacosanedioic acid, triacontanedioic acid, hentriacontanedioic acid, dotriacontanedioic acid, diglycolic acid, and the like.

Furthermore, examples of the dicarboxylic acid compound having an aromatic ring include, but are not limited to, phthalic acid, isophthalic acid, terephthalic acid, 4,4'-diphenyl ether dicarboxylic acid, 3,4'-diphenyl ether dicarboxylic acid, **3,3'-**diphenyl ether dicarboxylic acid, 4,4'-biphenyldicarboxylic acid, 3,4'-biphenyldicarboxylic acid, 3,3'-biphenyldicarboxylic acid, 4,4'-benzophenone dicarboxylic acid, 3,4'-benzophenone dicarboxylic acid, 3,3'-benzophenone dicarboxylic acid, 4,4'-hexafluoroisopropylidene dibenzoic acid, 4,4'-dicarboxydiphenylamide, 1,4-phenylenediethanoic acid, bis(4-carboxyphenyl)sulfide, 2,2-bis(4-carboxyphenyl)-1,1,1,3,3,3-hexafluoropropane, bis(4-carboxyphenyl)tetraphenyldisiloxane, bis(4-carboxyphenyl)tetramethyldisiloxane, bis(4-carboxyphenyl)sulfone, bis(4-carboxyphenyl)methane, 5-tert-butylisophthalic acid, 5-bromoisophthalic acid, 5-fluoroisophthalic acid, 5-chloroisophthalic acid, 2,2-bis-(p-carboxyphenyl)propane, 2,6-naphthalenedicarboxylic acid, and the like. Furthermore, these may be used alone or in mixture.

Suitable examples of the diamine represented by the above general formula (23) include the examples of the diamine represented by the above general formula (17).

Further, as described above, the polymer compound having the polyimide precursor to be used in the negative photosensitive resin composition of the present invention can further contain a structural unit represented by the following general formula (12), in addition to the structural unit represented by the above general formula (5), 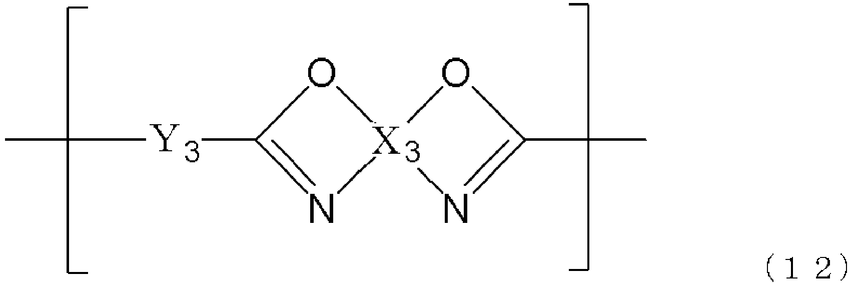 wherein X₃ and Y₃ are as defined above.

The polymer containing the structural unit represented by the above general formula (12) can be obtained by reacting a dicarboxylic acid compound represented by the following general formula (24) in the presence of a dehydration condensation agent or converting the dicarboxylic acid compound into an acid chloride by using a chlorinating agent, reacting the resultant with a dihydroxydiamine compound represented by the following general formula (25) to synthesize hydroxyamide (polyoxazole precursor), and thereafter forming an oxazole ring through a thermal dehydration process.

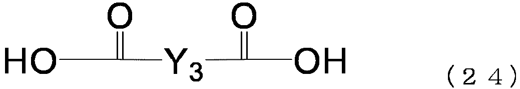

In the formula, Y₃ is as defined above.

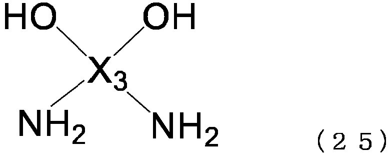

In the formula, X₃ is as defined above.

Suitable examples of the dicarboxylic acid compound represented by the above general formula (24) include the examples of the dicarboxylic acid compound represented by the above general formula (22).

Examples of the dihydroxydiamine compound represented by the above general formula (25) include, but are not limited to, 3,3'-diamino-4,4'-dihydroxybiphenyl, 3,3'-diamino-4,4'-dihydroxybiphenyl ether, 2,2'-bis(3-amino-4-hydroxyphenyl)sulfide, 2,2'-bis (3-amino-4-hydroxyphenyl) ketone, 3,3'-diamino-4,4'-dihydroxyphenyl methane, 1,2-bis(3-amino-4-hydroxyphenyl)ethane, 2,2'-bis(3-amino-4-hydroxyphenyl)difluoromethane, 4,4'-(1,1,2,2,3,3-hexafluoro-1,3-propanediyl)bis(2-aminophenol), 2,2'-bis(3-amino-4-hydroxyphenyl)propane, 2,2'-bis(3-amino-4-hydroxyphenyl)hexafluoropropane, 2,2'-bis(3-amino-4-hydroxyphenyl)sulfone, 1,1-bis(3-amino-4-hydroxyphenyl)cyclohexane, 4,4'-(1,4-phenylenebis(oxy))bis(2-aminophenol), 9,9-bis(3-amino-4-hydroxyphenyl)fluorene, and the like. Furthermore, these may be used alone or in mixture.

### (Molecular Weight of Polymer and Introduction of Terminal Blocking Agent)

A suitable molecular weight of the polymer compound is preferably 5,000 to 100,000, more preferably 7,000 to 50,000. The molecular weight of 5,000 or more makes it easy to form the negative photosensitive resin composition of the present invention using the above polymer into a film having a desired film thickness on a substrate, whereas the molecular weight of 100,000 or less leads to proper viscosity of the negative photosensitive resin composition, causing no problems in film formation.

Both terminals of the above polymer may be blocked with a terminal blocking agent in order to control the molecular weight during the condensation polymerization reaction and suppress change in the molecular weight, **i.e.** gelation, of the obtained polymer over time. Examples of the terminal blocking agent which reacts with the acid anhydride include monoamine, monohydric alcohol, and the like. Further, examples of the terminal blocking agent which reacts with the diamine compound include acid anhydrides, monocarboxylic acids, monoacid chloride compounds, monoactive ester compounds, dicarbonate esters, vinyl ethers, and the like. Yet further, various organic groups can be introduced as terminal groups by the reaction of the terminal blocking agent.

Examples of the monoamine used as the blocking agent for the terminals of the acid anhydride group include, but are not limited to, aniline, 5-amino-8-hydroxyquinoline, 4-amino-8-hydroxyquinoline, 1-hydroxy-8-aminonaphthalene, 1-hydroxy-7-aminonaphthalene, 1-hydroxy-6-aminonaphthalene, 1-hydroxy-5-aminonaphthalene, 1-hydroxy-4-aminonaphthalene, 1-hydroxy-3-aminonaphthalene, 1-hydroxy-2-aminonaphthalene, 1-amino-7-hydroxynaphthalene, 2-hydroxy-7-aminonaphthalene, 2-hydroxy-6-aminonaphthalene, 2-hydroxy-5-aminonaphthalene, 2-hydroxy-4-aminonaphthalene, 2-hydroxy-3-aminonaphthalene, 1-amino-2-hydroxynaphthalene, 1-carboxy-8-aminonaphthalene, 1-carboxy-7-aminonaphthalene, 1-carboxy-6-aminonaphthalene, 1-carboxy-5-aminonaphthalene, 1-carboxy-4-aminonaphthalene, 1-carboxy-3-aminonaphthalene, 1-carboxy-2-aminonaphthalene, 1-amino-7-carboxynaphthalene, 2-carboxy-7-aminonaphthalene, 2-carboxy-6-aminonaphthalene, 2-carboxy-5-aminonaphthalene, 2-carboxy-4-aminonaphthalene, 2-carboxy-3-aminonaphthalene, 1-amino-2-carboxynaphthalene, 2-aminonicotinic aid, 4-aminonicotinic aid, 5-aminonicotinic aid, 6-aminonicotinic aid, 4-aminosalicylic acid, 5-aminosalicylic acid, 6-aminosalicylic acid, ameride, 2-aminobenzoic acid, 3-aminobenzoic acid, 4-aminobenzoic acid, 2-aminobenzenesulfonic acid, 3-aminobenzenesulfonic acid, 4-aminobenzenesulfonic acid, 3-amino-4,6-dihydroxypyrimidine, 2-aminophenol, 3-aminophenol, 4-aminophenol, 5-amino-8-mercaptoquinoline, 4-amino-8-mercaptoquinoline, 1-mercapto-8-aminonaphthalene, 1-mercapto-7-aminonaphthalene, 1-mercapto-6-aminonaphthalene, 1-mercapto-5-aminonaphthalene, 1-mercapto-4-aminonaphthalene, 1-mercapto-3-aminonaphthalene, 1-mercapto-2-aminonaphthalene, 1-amino-7-mercaptonaphthalene, 2-mercapto-7-aminonaphthalene, 2-mercapto-6-aminonaphthalene, 2-mercapto-5-aminonaphthalene, 2-mercapto-4-aminonaphthalene, 2-mercapto-3-aminonaphthalene, 1-amino-2-mercaptonaphthalene, 3-amino-4,6-dimercaptopyrimidine, 2-aminothiophenol, 3-aminothiophenol, 4-aminothiophenol, 2-ethynylaniline, 3-ethynylaniline, 4-ethynylaniline, 2,4-diethynylaniline, 2,5-diethynylaniline, 2,6-diethynylaniline, 3,4-diethynylaniline, 3,5-diethynylaniline, 1-ethynyl-2-aminonaphthalene, 1-ethynyl-3-aminonaphthalene, 1-ethynyl-4-aminonaphthalene, 1-ethynyl-5-aminonaphthalene, 1-ethynyl-6-aminonaphthalene, 1-ethynyl-7-aminonaphthalene, 1-ethynyl-8-aminonaphthalene, 2-ethynyl-1-aminonaphthalene, 2-ethynyl-3-aminonaphthalene, 2-ethynyl-4-aminonaphthalene, 2-ethynyl-5-aminonaphthalene, 2-ethynyl-6-aminonaphthalene, 2-ethynyl-7-aminonaphthalene, 2-ethynyl-8-aminonaphthalene, 3,5-diethynyl-1-aminonaphthalene, 3,5-diethynyl-2-aminonaphthalene, 3,6-diethynyl-1-aminonaphthalene, 3,6-diethynyl-2-aminonaphthalene, 3,7-diethynyl-1-aminonaphthalene, 3,7-diethynyl-2-aminonaphthalene, 4,8-diethynyl-1-aminonaphthalene, 4,8-diethynyl-2-aminonaphthalene, 4-fluoroaniline, 3-fluoroaniline, 2-fluoroaniline, 2,4-difluoroaniline, 3,4-difluoroaniline, 2,4,6-trifluoroaniline, 2,3,4-trifluoroaniline, pentafluoroaniline, and the like. These may be used alone or in combination of two or more.

Meanwhile, examples of the monohydric alcohol used as the blocking agent for the terminals of the acid anhydride group include, but are not limited to, methanol, ethanol, 1-propanol, 2-propanol, 1-butanol, 2-butanol, 1-pentanol, 2-pentanol, 3-pentanol, 1-hexanol, 2-hexanol, 3-hexanol, 1-heptanol, 2-heptanol, 3-heptanol, 1-octanol, 2-octanol, 3-octanol, 1-nonanol, 2-nonanol, 1-decanol, 2-decanol, 1-undecanol, 2-undecanol, 1-dodecanol, 2-dodecanol, 1-tridecanol, 2-tridecanol, 1-tetradecanol, 2-tetradecanol, 1-pentadecanol, 2-pentadecanol, 1-hexadecanol, 2-hexadecanol, 1-heptadecanol, 2-heptadecanol, 1-octadecanol, 2-octadecanol, 1-nonadecanol, 2-nonadecanol, 1-icosanol, 2-methyl-1-propanol, 2-methyl-2-propanol, 2-methyl-1-butanol, 3-methyl-1-butanol, 2-methyl-2-butanol, 3-methyl-2-butanol, 2-propyl-1-pentanol, 2-ethyl-1-hexanol, 4-methyl-3-heptanol, 6-methyl-2-heptanol, 2,4,4-trimethyl-1-hexanol, 2,6-dimethyl-4-heptanol, isononyl alcohol, 3,7-dimethyl-3-octanol, 2,4-dimethyl-1-heptanol, 2-heptylundecanol, ethylene glycol monoethyl ether, ethylene glycol monomethyl ether, ethylene glycol monobutyl ether, propylene glycol 1-methyl ether, diethylene glycol monoethyl ether, diethylene glycol monomethyl ether, diethylene glycol monobutyl ether, cyclopentanol, cyclohexanol, cyclopentane monomethylol, cyclopentane monomethylol, dicyclopentane monomethylol, tricyclodecane monomethylol, norborneol, terpineol, and the like. Furthermore, these may be used alone or in combination of two or more.

Examples of the acid anhydrides, monocarboxylic acids, monoacid chloride compounds, and monoactive ester compounds used as the blocking agent for the amino group terminal include: acid anhydrides such as phthalic anhydride, maleic anhydride, nadic anhydride, cyclohexane dicarboxylic anhydride, and 3-hydroxyphthalic anhydride; monocarboxylic acids such as 2-carboxyphenol, 3-carboxyphenol, 4-carboxyphenol, 2-carboxythiophenol, 3-carboxythiophenol, 4-carboxythiophenol, 1-hydroxy-8-carboxynaphthalene, 1-hydroxy-7-carboxynaphthalene, 1-hydroxy-6-carboxynaphthalene, 1-hydroxy-5-carboxynaphthalene, 1-hydroxy-4-carboxynaphthalene, 1-hydroxy-3-carboxynaphthalene, 1-hydroxy-2-carboxynaphthalene, 1-mercapto-8-carboxynaphthalene, 1-mercapto-7-carboxynaphthalene, 1-mercapto-6-carboxynaphthalene, 1-mercapto-5-carboxynaphthalene, 1-mercapto-4-carboxynaphthalene, 1-mercapto-3-carboxynaphthalene, 1-mercapto-2-carboxynaphthalene, 2-carboxybenzenesulfonic acid, 3-carboxybenzenesulfonic acid, 4-carboxybenzenesulfonic acid, 2-ethynylbenzoic acid, 3-ethynylbenzoic acid, 4-ethynylbenzoic acid, 2,4-diethynylbenzoic acid, 2,5-diethynylbenzoic acid, 2,6-diethynylbenzoic acid, 3,4-diethynylbenzoic acid, 3,5-diethynylbenzoic acid, 2-ethynyl-1-naphthoic acid, 3-ethynyl-1-naphthoic acid, 4-ethynyl-1-naphthoic acid, 5-ethynyl-1-naphthoic acid, 6-ethynyl-1-naphthoic acid, 7-ethynyl-1-naphthoic acid, 8-ethynyl-1-naphthoic acid, 2-ethynyl-2-naphthoic acid, 3-ethynyl-2-naphthoic acid, 4-ethynyl-2-naphthoic acid, 5-ethynyl-2-naphthoic acid, 6-ethynyl-2-naphthoic acid, 7-ethynyl-2-naphthoic acid, and 8-ethynyl-2-naphthoic acid, and monoacid chloride compounds obtained by acid chlorination of these carboxy groups; monoacid chloride compounds obtained by acid chlorination of only a monocarboxylic group of dicarboxylic acid, such as terephthalic acid, phthalic acid, maleic acid, cyclohexanedicarboxylic acid, 3-hydroxyphthalic acid, 5-norbornene-2,3-dicarboxylic acid, 1,2-dicarboxynaphthalene, 1,3-dicarboxynaphthalene, 1,4-dicarboxynaphthalene, 1,5-dicarboxynaphthalene, 1,6-dicarboxynaphthalene, 1,7-dicarboxynaphthalene, 1,8-dicarboxynaphthalene, 2,3-dicarboxynaphthalene, 2,6-dicarboxynaphthalene, and 2,7-dicarboxynaphthalene; monoactive ester compounds obtained by reaction of a monoacid chloride compound with N-hydroxybenzotriazole or N-hydroxy-5-norbornene-2,3-dicarboxyimide; and the like.

Examples of the dicarbonate ester compound used as the blocking agent for the amino group terminal include di-tert-butyl dicarbonate, dibenzyl dicarbonate, dimethyl dicarbonate, diethyl dicarbonate, and the like.

Examples of the vinyl ether compound used as the blocking agent for the amino group terminal include butyl vinyl ether, cyclohexyl vinyl ether, ethyl vinyl ether, 2-ethylhexyl vinyl ether, isobutyl vinyl ether, isopropyl vinyl ether, n-propyl vinyl ether, tert-butyl vinyl ether, benzyl vinyl ether, and the like.

Examples of other compounds used as the blocking agent for the amino group terminal include: benzoyl chloride; chloroformates such as fluorenylmethyl chloroformate, 2,2,2-trichloroethyl chloroformate, tert-butyl chloroformate, n-butyl chloroformate, isobutyl chloroformate, benzyl chloroformate, allyl chloroformate, ethyl chloroformate, and isopropyl chloroformate; isocyanate compounds such as butyl isocyanate, 1-naphthyl isocyanate, octadecyl isocyanate, and phenyl isocyanate; methanesulfonic acid chloride, p-toluenesulfonic acid chloride, and the like.

A proportion of the blocking agent for the terminals of the acid anhydride group to be introduced is preferably in the range of 0.1 to 60 mol%, particularly preferably 5 to 50 mol%, and further preferably 5 to 20 mol% relative to a total amount of the tetracarboxylic dianhydride component and the dicarboxylic acid component. Further, a proportion of the blocking agent for the amino group terminal to be introduced is preferably in the range of 0.1 to 100 mol%, particularly preferably 5 to 90 mol%, relative to the diamine component. Yet further, a plurality of different terminal groups may be introduced by reacting a plurality of terminal blocking agents.

### Component (D)

Next, a nitrogen-containing organic compound represented by the following general formula (1) as the component (D) of the present invention will be described, 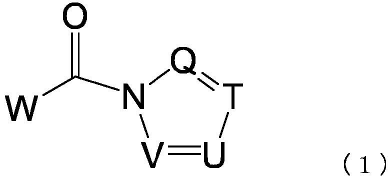
wherein Q represents a nitrogen atom or a carbon atom having a R^{q} group; T represents a nitrogen atom or a carbon atom having a R^{t} group; U represents a nitrogen atom or a carbon atom having a R^{u} group; V represents a nitrogen atom or a carbon atom having a R^{v} group; the R^{q}, R^{t}, R^{u}, and R^{v} groups each represents a hydrogen atom, a linear, branched, or cyclic alkyl group having 1 to 15 carbon atoms, an aryl group having 6 to 15 carbon atoms, a halogen atom, or a nitro group, and the R^{q} group and the R^{t} group, the R^{t} group and the R^{u} group, or the R^{u} group and the R^{v} group optionally bond together to form a ring with a carbon atom attached thereto; and W represents any structure of the following general formulae (2) to (4), 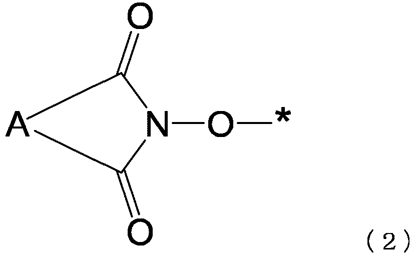
wherein A represents a divalent organic group; and * represents a bond, 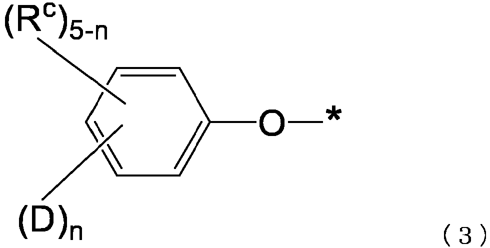
wherein D represents a halogen atom or a nitro group; R^{c} represents a hydrogen atom, a linear, branched, or cyclic alkyl group having 1 to 15 carbon atoms, or an aryl group having 6 to 15 carbon atoms; "n" represents an integer of 3 to 5 when D represents a halogen atom, and represents 1 when D represents a nitro group; and * represents a bond, 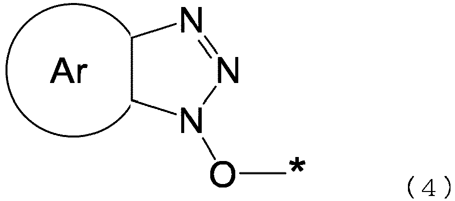
wherein Ar represents a substituted or unsubstituted aromatic ring structure, or a heterocyclic structure having a heteroatom; and * represents a bond.

In other words, the nitrogen-containing organic compound represented by the above general formula (1) can be represented by the following general formulae (1-1) to (1-9), 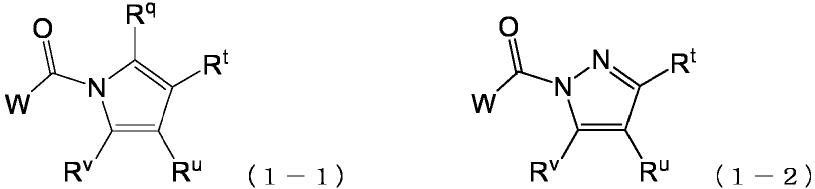 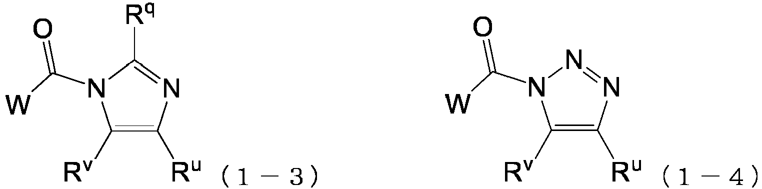 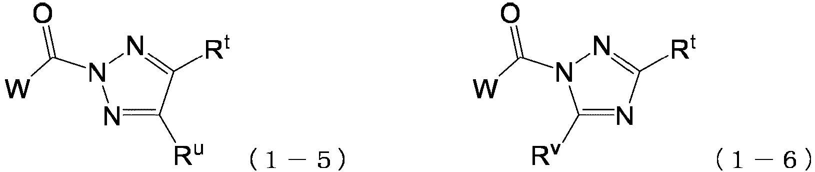 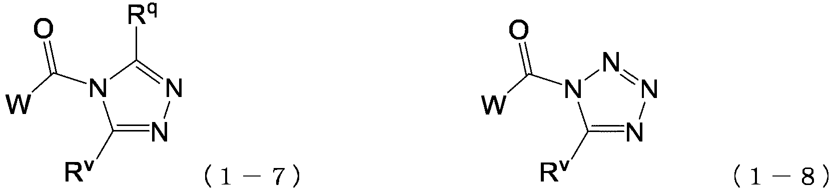 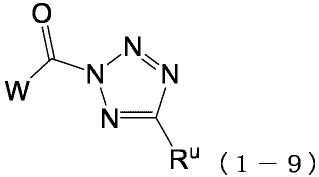 wherein R^{q}, R^{t}, R^{u}, and R^{v} groups, as well as W are synonymous with those in the above general formula (1).

The R^{q}, R^{t}, R^{u}, and R^{v} groups each represents a hydrogen atom, a linear, branched, or cyclic alkyl group having 1 to 15 carbon atoms, an aryl group having 6 to 15 carbon atoms, a halogen atom, or a nitro group. Each of them preferably represents a hydrogen atom, a linear, branched, or cyclic alkyl group having 1 to 6 carbon atoms, an aryl group having 6 to 15 carbon atoms, a halogen atom, or a nitro group. Further preferably, each of them represents a hydrogen atom, a methyl group, an ethyl group, a n-propyl group, a n-butyl group, a tert-butyl group, a phenyl group, or a nitro group.

The R^{q} and R^{t} groups substituted on the adjacent carbon atoms may bond together to form a ring with a carbon atom attached thereto. Similarly, the R^{t} and R^{u} groups, and the R^{u} and R^{v} groups substituted on the adjacent carbon atoms may bond together to form a ring with a carbon atom attached thereto. The ring structure formed by them with the carbon atom attached thereto may form an alicyclic structure or aromatic ring structure having 6 to 20 carbon atoms. The alicyclic structure or aromatic ring structure having 6 to 12 carbon atoms is preferred. Furthermore, the ring structure formed by them with the carbon atom attached thereto forms a benzene ring structure, in other words, the ring structure is preferably any of the following general formulae (1-10) to (1-16). 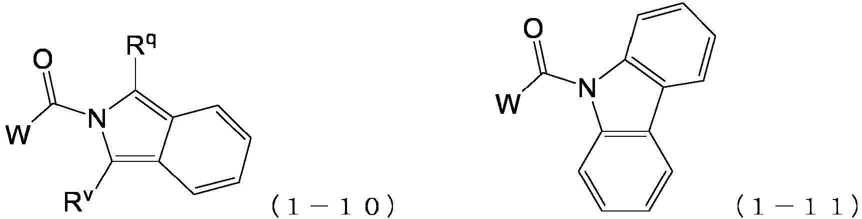 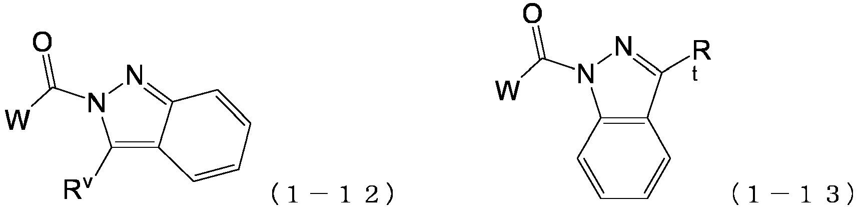 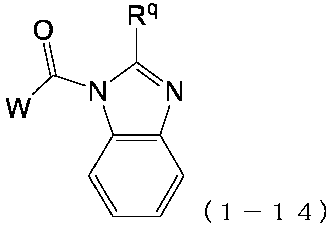 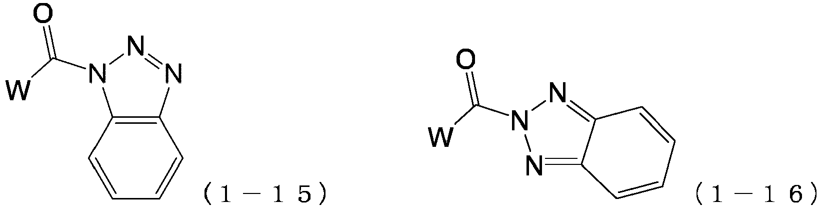 In the formulae, R^{q}, R^{t}, R^{u}, and R^{v} groups as well as W are synonymous with those in the above general formula (1).

The ring structure formed by them with the carbon atom attached thereto is most preferably the benzene ring structure as described above.

Also in this case, W in the above general formula (1) of the component (D) is preferably an organic group represented by the following general formula (2), 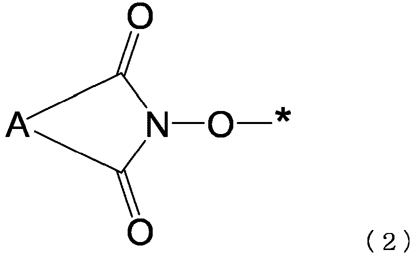 wherein A represents a divalent organic group; and * represents a bond.

Furthermore, W in the above general formula (1) of the component (D) is preferably an organic group represented by the following general formula (2-1), 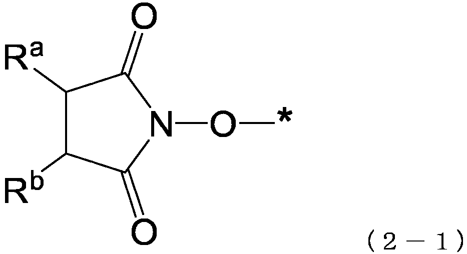 wherein a R^{a} group and a R^{b} group represent a hydrogen atom, a linear, branched, or cyclic alkyl group having 1 to 15 carbon atoms, or an aryl group having 6 to 15 carbon atoms, or the R^{a} group and the R^{b} group optionally bond together to form a ring with a carbon atom attached thereto; and * represents a bond.

Suitable examples of the organic group represented by the above general formula (2) or (2-1) as W in the above general formula (1) of the component (D) include organic groups of the following general formulae (2-3), 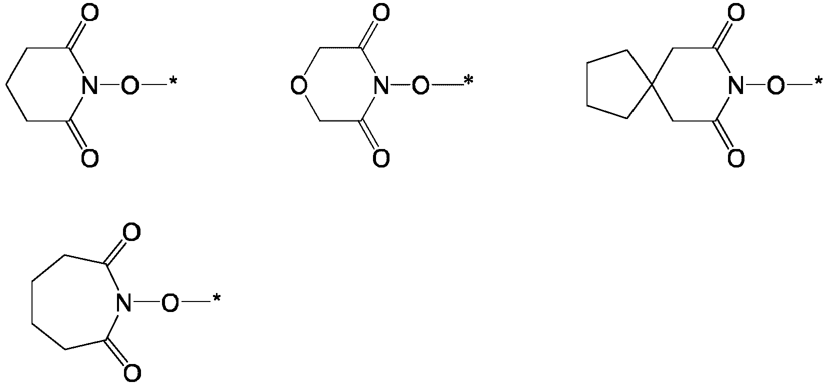 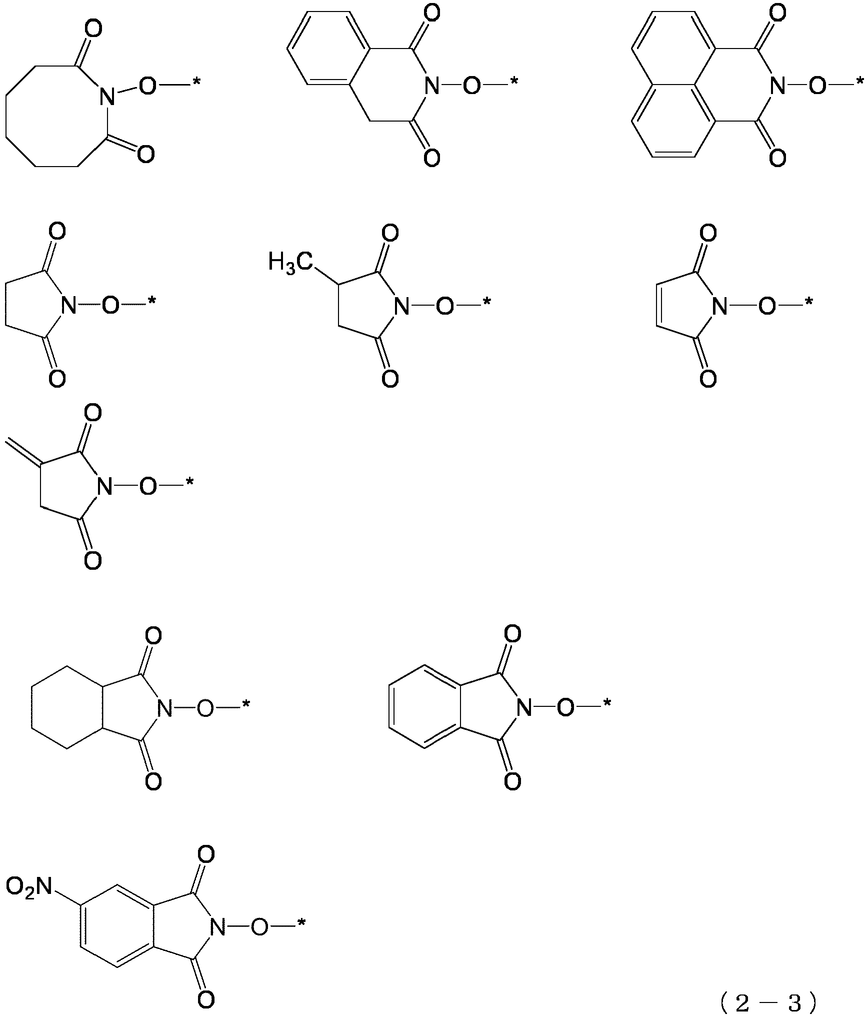 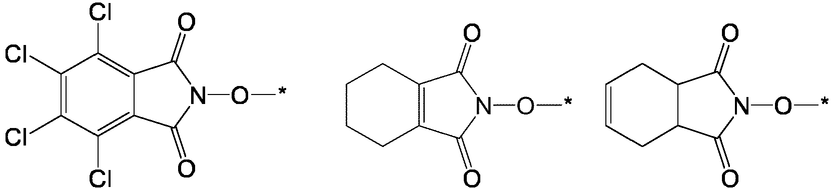 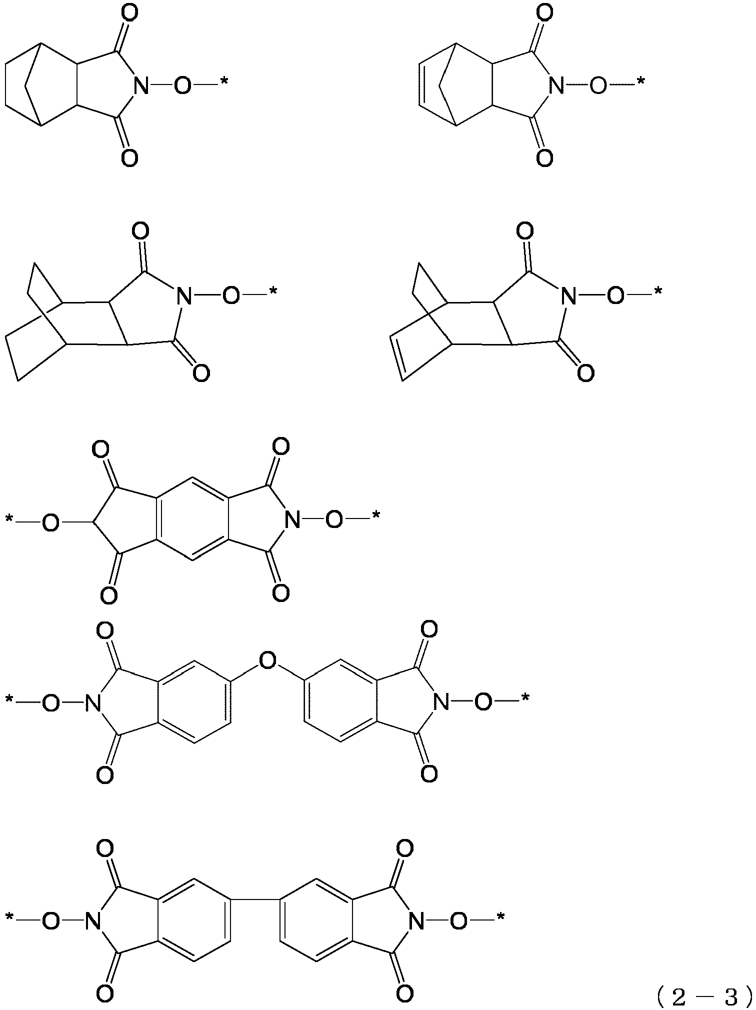 wherein * represents a bond.

Further examples of the suitable nitrogen-containing organic compound having the organic group represented by the above formula (2) include the following compounds.

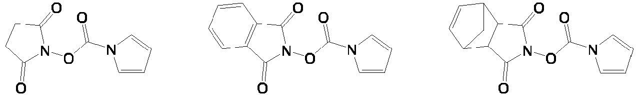

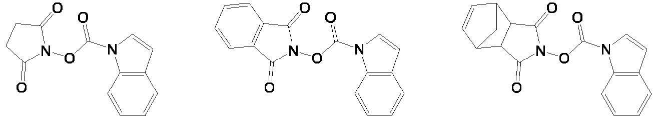

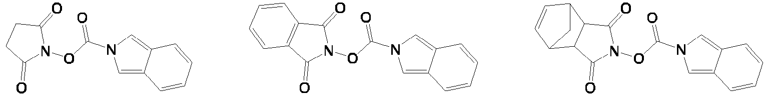

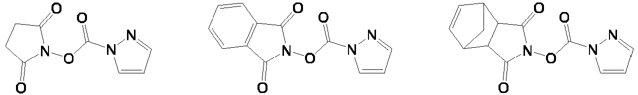

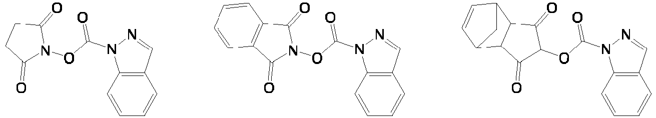

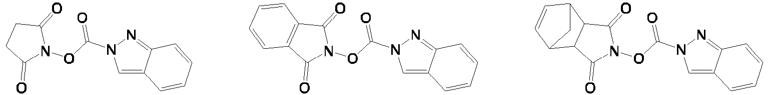

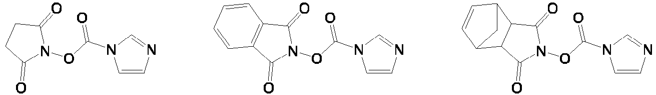

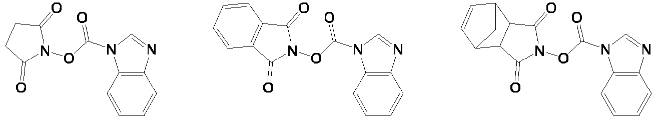

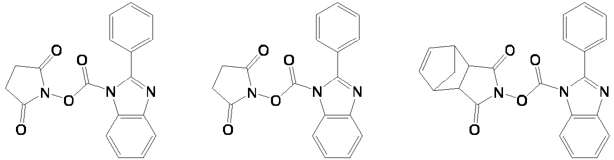

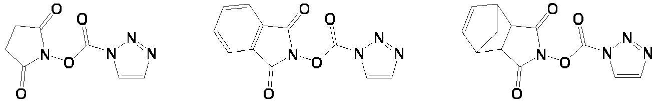

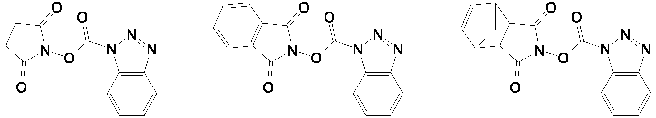

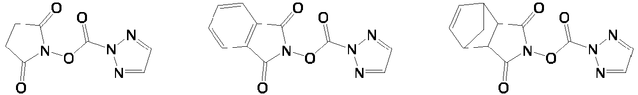

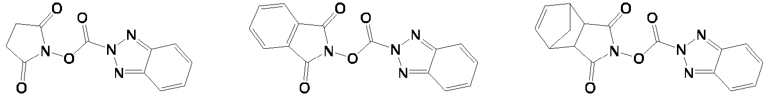

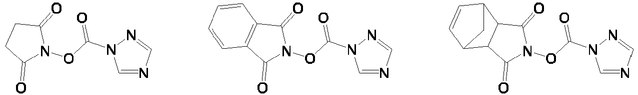

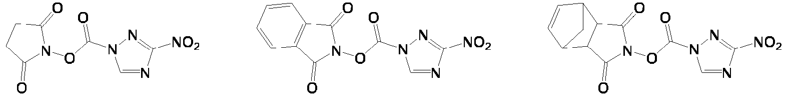

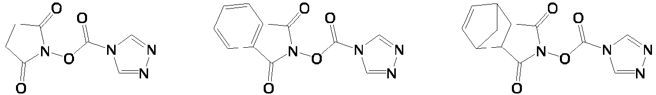

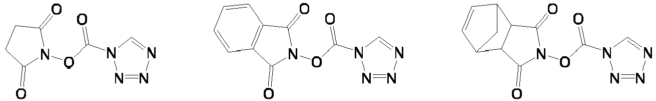

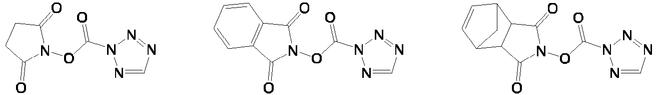

When W is the organic group represented by the above general formula (2), (2-1), or (2-3), the nitrogen-containing organic compound represented by the above general formula (1) has a structure in which a nitrogen atom thereof is protected by an imidooxycarbonyl group. The nitrogen-containing organic compound having the organic group represented by the above general formula (2-1) as W enables decomposition and decarboxylation at a temperature of 200°C or lower in a heating process, thereby generating not only an azole compound capable of facilitating imide ring closure reaction, but also a N-hydroxyimide compound, which is an active esterification agent capable of facilitating imide ring closure reaction. Accordingly, imide ring closure can lead to imidization at 200°C or lower.

Next, a case where W in the above general formula (1) of the component (D) is an organic compound represented by the following general formula (3) will be described. In the above general formula (1) of the component (D), W preferably has a structure of the following general formula (3), 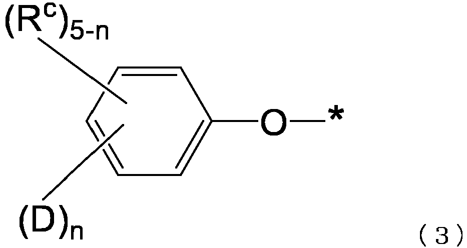 wherein D represents a halogen atom or a nitro group; R^{c} represents a hydrogen atom, a linear, branched, or cyclic alkyl group having 1 to 15 carbon atoms, or an aryl group having 6 to 15 carbon atoms; "n" represents an integer of 3 to 5 when D represents a halogen atom, and represents 1 when D represents a nitro group; and * represents a bond.

Examples of the suitable organic group of the above general formula (3) as W in the above general formula (1) of the component (D) include the following general formulae (3-3), 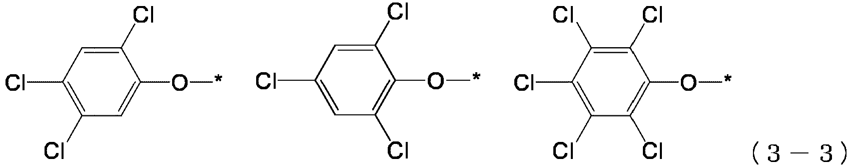 wherein * represents a bond.

Furthermore, W in the above general formula (1) of the component (D) is preferably an organic group represented by the following general formula (3-1) or (3-2), 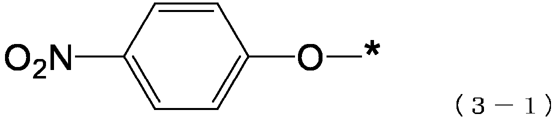 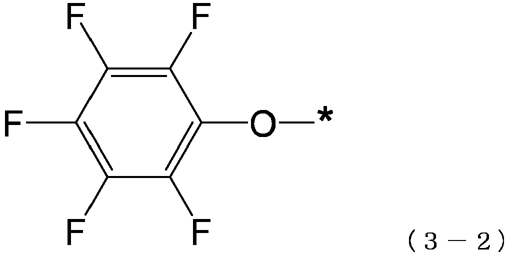 wherein * represents a bond.

A more suitable example is the nitrogen-containing organic compound having the organic group represented by the above general formula (3-1) or (3-2) as W in the above general formula (1) of the Component (D) because of availability of raw materials, safety of the compound, less toxicity, etc.

Further examples of the suitable nitrogen-containing organic compound having the organic group represented by the above formula (3) include the following compounds.

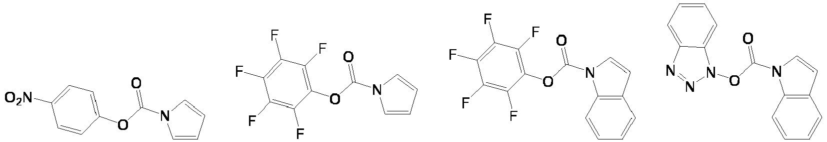

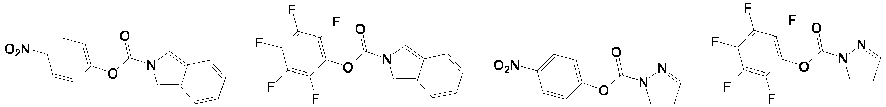

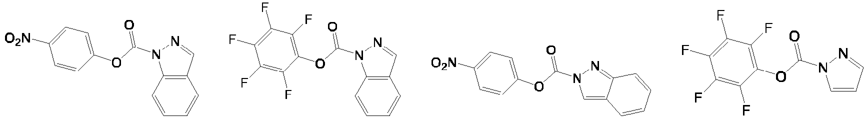

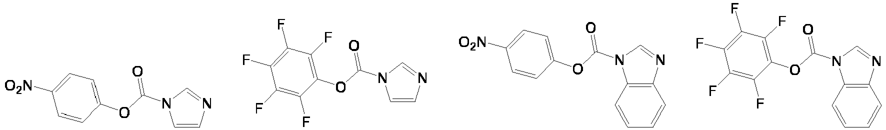

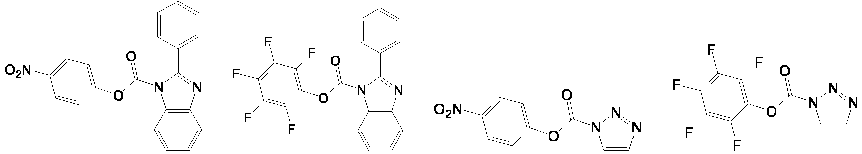

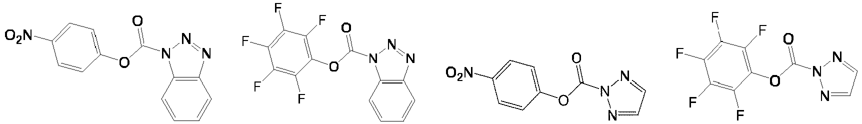

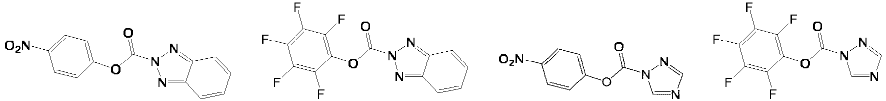

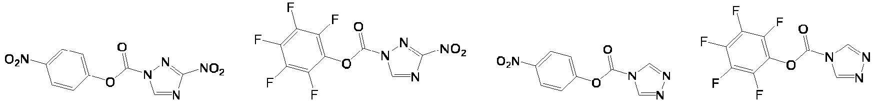

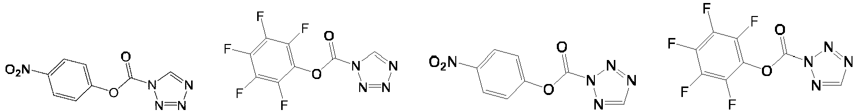

When W is the organic group represented by the above general formula (3-1), the nitrogen-containing organic compound represented by the above general formula (1) has a structure in which a nitrogen atom thereof is protected by a 4-nitrophenyloxycarbonyl group. The nitrogen-containing organic compound having the organic group represented by the above general formula (3-1) as W enables decomposition and decarboxylation at a temperature of 200°C or lower in a heating process, thereby generating not only an azole compound capable of facilitating imide ring closure reaction, but also 4-nitrophenol which is an active esterification agent capable of facilitating imide ring closure reaction. Accordingly, imide ring closure can lead to imidization at 200°C or lower.

Meanwhile, when W is the organic group represented by the above general formula (3-2), the nitrogen-containing organic compound represented by the above general formula (1) has a structure in which a nitrogen atom thereof is protected by a pentafluorophenyloxycarbonyl group. The nitrogen-containing organic compound having the organic group represented by the above general formula (3-2) as W enables decomposition and decarboxylation at a temperature of 200°C or lower in a heating process, thereby generating not only an azole compound capable of facilitating imide ring closure reaction, but also pentafluorophenol which is an active esterification agent capable of facilitating imide ring closure reaction. Accordingly, imide ring closure can lead to imidization at 200°C or lower.

Next, a case where W in the above general formula (1) of the component (D) has a structure represented by the following general formula (4) will be described. W in the above general formula (1) of the component (D) preferably has the structure represented by the following general formula (4), 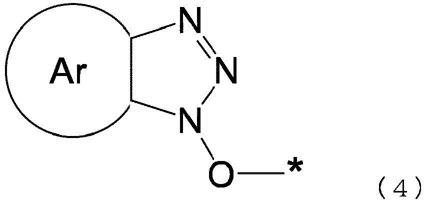 wherein Ar represents a substituted or unsubstituted aromatic ring structure, or a heterocyclic structure having a heteroatom; and * represents a bond.

The suitable organic group of the above general formula (4) can be represented by the following general formula (4-1). That is, W in the above general formula (1) of the component (D) is preferably an organic group represented by the following general formula (4-1), 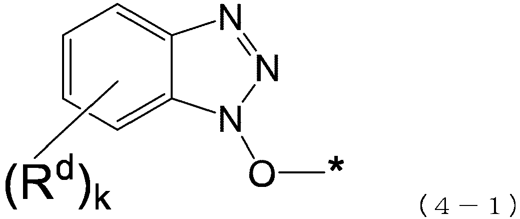 wherein a R^{d} group represents a linear, branched, or cyclic alkyl group having 1 to 15 carbon atoms and optionally having a halogen atom, or an aryl group having 6 to 15 carbon atoms; "k" represents an integer of 0 to 4; and * represents a bond.

The suitable organic group of the above general formula (4) can be represented by the following general formula (4-2), 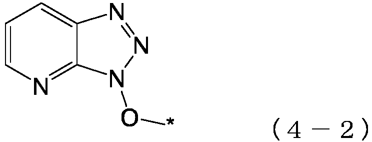 wherein * represents a bond.

Specific examples of the organic group represented by the above general formula (4-1) include organic groups represented by the following general formulae (4-3). That is, W in the above general formula (1) of the component (D) is preferably any of the organic groups represented by (4-3) below, 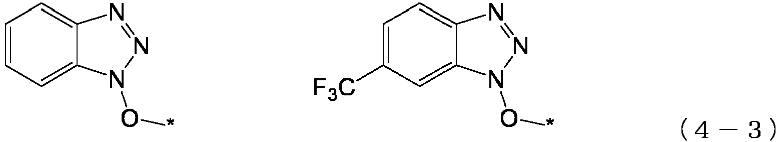 wherein * represents a bond.

The organic compound having any of the organic groups represented by the above general formulae (4-3) as W in the above general formula (1) of the component (D) is more desirable because raw materials thereof can be easily obtained and storage stability of the negative photosensitive resin composition of the present invention including the organic compound is less prone to degradation.

Examples of the more desirable nitrogen-containing organic compound having the organic group represented by the above formula (4) include the following compounds.

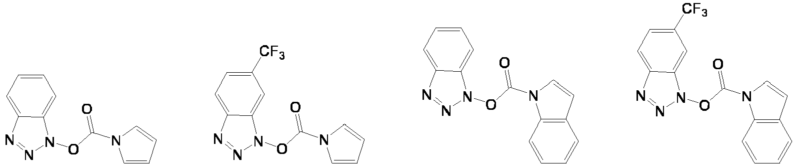

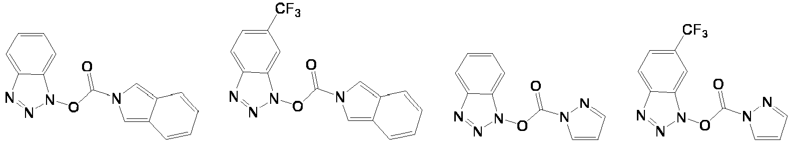

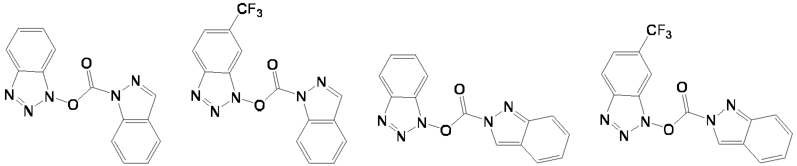

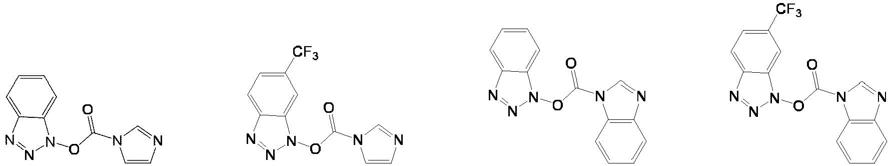

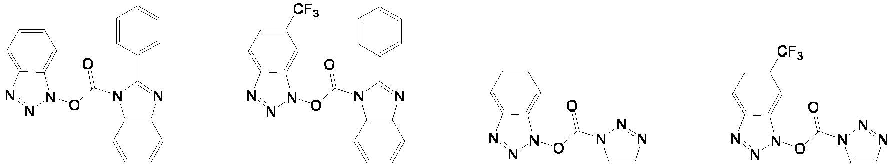

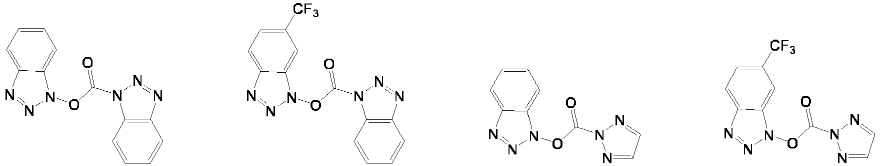

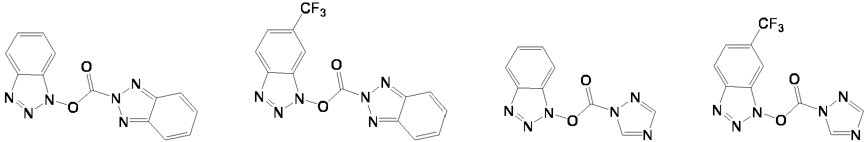

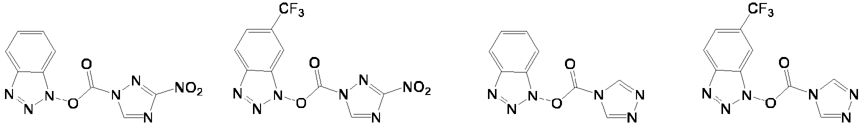

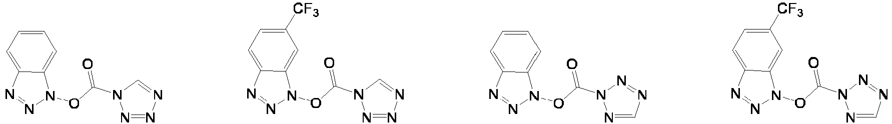

When W is the organic group represented by the above general formula (4-1), the nitrogen-containing organic compound represented by the above general formula (1) has a structure in which a nitrogen atom thereof is protected by a 1-benztriazoleoxycarbonyl group. The nitrogen-containing organic compound having the organic group represented by the above general formula (4-1) as W enables decomposition and decarboxylation at a temperature of 200°C or lower in a heating process, thereby generating not only an azole compound capable of facilitating imide ring closure reaction, but also a 1-hydroxybenztriazole compound, which is an active esterification agent capable of facilitating imide ring closure reaction. Accordingly, imide ring closure can lead to imidization at 200°C or lower.

The nitrogen-containing organic compound represented by the above general formula (1) can be obtained, for example, by a method shown in the following reaction formulae (26), (27), and (28), but the method is not limited thereto.

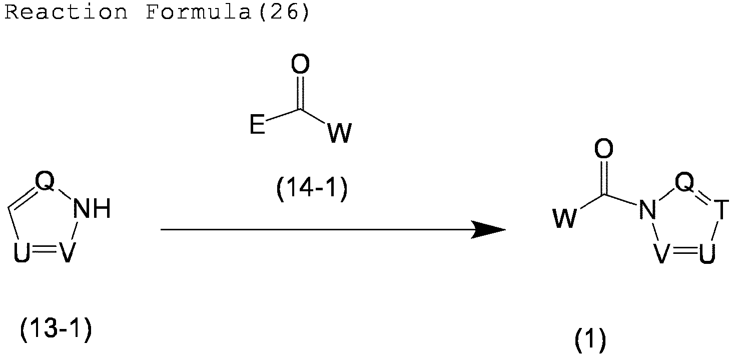

### (In the above reaction formula (26), Q, T, U, V, and W are as defined above. In the above formula (14-1), E represents a halogen atom or the same group as represented by W.)

As shown in the above reaction formula (26), the nitrogen-containing organic compound of the above general formula (1) can be obtained by reaction between an azole derivative of the above general formula (13-1) and carbonyl halide (halocarbonate esters) of the above general formula (14-1), which includes W having the same structure as described above. In this case, the above general formula (14-1) is a halocarbonate ester compound into which the structures of the above general formulae (2) to (4) can be introduced, and can be represented by the following general formulae (2-4), (3-4), and (4-4), 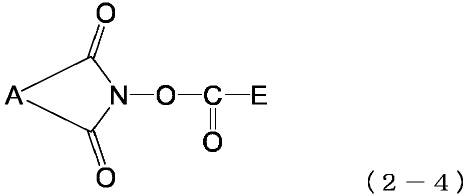 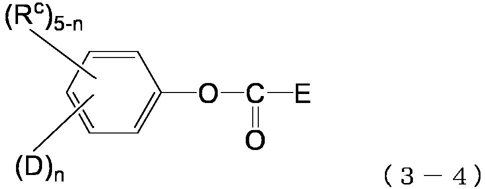 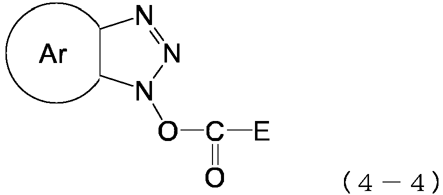 wherein A, D, Ar, R^{c}, "n", and E are as defined above.

In the case of using the azole derivative (13-1) and the halocarbonate esters (14-1) in the above reaction formula (26), the reaction may be performed by sequentially or simultaneously adding the azole derivative (13-1), the halocarbonate esters corresponding to the above general formulae (2-4), (3-4), and (4-4), a base such as triethylamine, pyridine, 2,6-lutidine, and N,N-dimethylaniline without a solvent or into a solvent such as methylene chloride, acetonitrile, diethyl ether, tetrahydrofuran, N,N-dimethylformamide, toluene, and hexane, and cooling or heating as necessary.

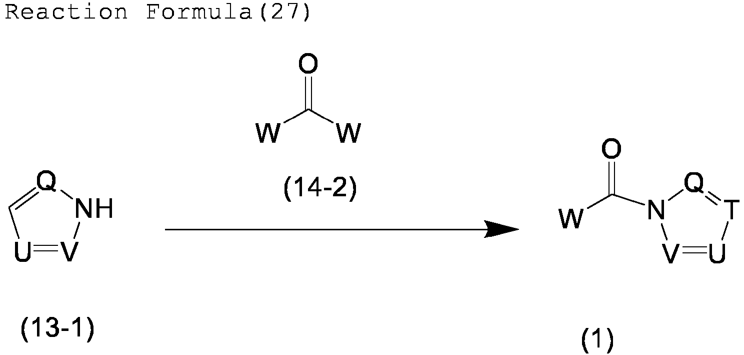

### (In the above reaction formula (27), Q, T, U, V, and W are as defined above.)

As shown in the above reaction formula (27), the nitrogen-containing organic compound of the above general formula (1) can be obtained by reaction between the azole derivative of the above general formula (13-1) and carbonate having two Ws (carbonate diesters having two Ws) of the above general formula (14-2), where W represents the same organic group as described above. In this case, the above general formula (14-2) represents a carbonate diester compound into which the structures of the above general formulae (2) to (4) can be introduced, and can be represented by the following general formulae (2-5), (3-5), and (4-5), 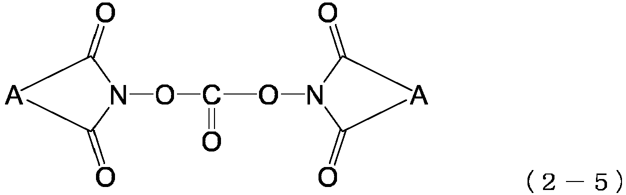 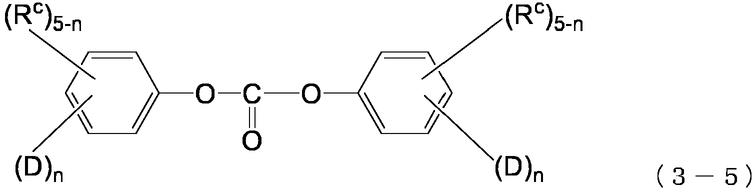 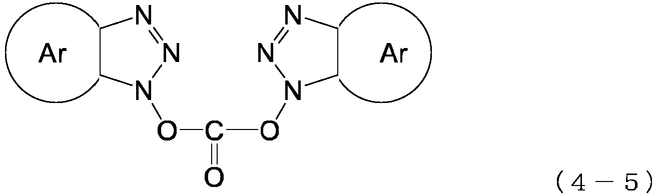 wherein A, D, Ar, R^{c}, and "n" are as defined above.

In the case of using the azole derivative (13-1) and the carbonate diesters (14-2) in the above reaction formula (27), the reaction may be performed by sequentially or simultaneously adding the azole derivative (13-1), the carbonate diesters (14-2), a base such as triethylamine, pyridine, 2,6-lutidine, and N,N-dimethylaniline into a solvent such as methylene chloride, acetonitrile, diethyl ether, tetrahydrofuran, N,N-dimethylformamide, toluene, and hexane, and cooling or heating as necessary. 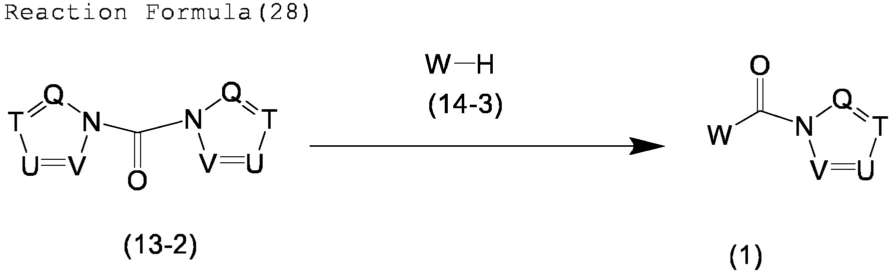 In the above reaction formula (28), Q, T, U, V, and W are as defined above.

Yet further, the nitrogen-containing organic compound of the above general formula (1) can be obtained by reaction between diazole carbonyl of the above general formula (13-2) and a hydroxy group-containing compound of the above general formula (14-3) in which W representing the same organic group as described above is attached to a hydrogen atom. In this case, the above general formula (14-3) represents a hydroxy group-containing compound into which the structures of the above general formulae (2) to (4) can be introduced, and can be represented by the following general formulae (2-6), (3-6), and (4-6), 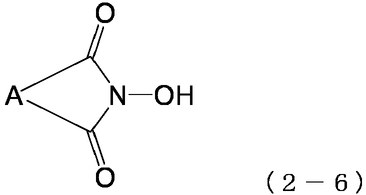 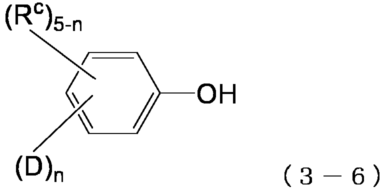 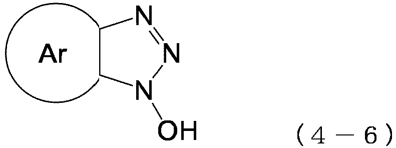 wherein A, D, Ar, R^{c}, and "n" are as defined above.

In the case of using the reaction between the diazole carbonyl (13-2) and the hydroxy group-containing compound (14-3) in which W representing the same organic group as described above is attached to a hydrogen atom in the above reaction formula (28), the reaction may be performed by sequentially or simultaneously adding the diazole carbonyl (13-2) and the hydroxy group-containing compound (14-3) into a solvent such as methylene chloride, acetonitrile, diethyl ether, tetrahydrofuran, N,N-dimethylformamide, toluene, and hexane, and cooling or heating as necessary.

A use amount of the halocarbonate ester (14-1) shown in the above reaction formula (26) or the carbonate diesters (14-2) shown in the above reaction formula (27) varies depending on conditions, but is preferably 1.0 to 5.0 mole, particularly 1.0 to 2.0 mole, per mole of the raw material, i.e. the azole derivative (13-1), for example. A use amount of the base varies depending on conditions, but is preferably 0 to 5.0 mole, particularly 0 to 2.0 mole, per mole of the raw material, i.e. the azole derivative (13-1), for example. In view of the yield, a reaction time is preferably determined by monitoring the reaction by gas chromatography (GC) or silica gel thin-layer chromatography (TLC) to complete the reaction. The reaction time is usually about 0.5 to 24 hours. The desired nitrogen-containing organic compound (1) can be obtained from the reaction mixture by common aqueous treatment, and if necessary, can be purified according to usual methods such as distillation, chromatography, and recrystallization. Alternatively, it may be possible to perform the purification after separating salts generated by the reaction by filtration, or directly purify the reaction liquid, without the subsequent aqueous treatment.

Meanwhile, a use amount of the hydroxy group-containing compound (14-3) shown in the above reaction formula (28), where W representing the same organic group as described above is attached to a hydrogen atom, varies depending on conditions, but is preferably 1.0 to 5.0 mole, particularly 1.0 to 2.0 mole, per mole of the raw material, i.e. the diazole carbonyl (13-2), for example. A use amount of the base varies depending on conditions, but is preferably 0 to 5.0 mole, particularly 0 to 2.0 mole, per mole of the raw material, i.e. the diazole carbonyl (13-2), for example. In view of the yield, a reaction time is preferably determined by monitoring the reaction by gas chromatography (GC) or silica gel thin-layer chromatography (TLC) to complete the reaction. The reaction time is usually about 0.5 to 24 hours. The desired nitrogen-containing organic compound (1) can be obtained from the reaction mixture by common aqueous treatment, and if necessary, can be purified according to usual methods such as distillation, chromatography, and recrystallization. Alternatively, it may be possible to perform the purification after separating salts generated by the reaction by filtration, or directly purify the reaction liquid, without the subsequent aqueous treatment.

Meanwhile, the nitrogen-containing organic compound as the component (D) is preferably contained in an amount of 1 to 10 parts by mass relative to 100 parts by mass of the component (A).

When the amount of the nitrogen-containing organic compound as the component (D) is 10 parts by mass or less, the added nitrogen-containing compound does not function as a plasticizer, causing no thermal deformation, i.e. thermal flow, in a formed pattern, nor damage to pattern formation. Additionally, after curing, a glass transition temperature (Tg.) of the resulting cured film never decreases.

### Component (C)

Next, (C) a photoinitiator will be described.

As the photoinitiator (C), compounds conventionally used as a photoinitiator for UV-curing can be optionally selected. Examples thereof preferably include, but are not limited to: benzophenone and benzophenone derivatives such as methyl o-benzoyl benzoate, 4-benzoyl-4'-methyl diphenyl ketone, dibenzyl ketone, and fluorenone; acetophenone derivatives such as 2,2'-diethoxyacetophenone, 2-hydroxy-2-methylpropiophenone, and 1-hydroxycyclohexyl phenyl ketone; thioxanthone and thioxanthone derivatives such as 2-methylthioxanthone, 2-isopropylthioxanthone, and diethylthioxanthone; benzyl and benzyl derivatives such as benzyl dimethyl ketal and benzyl-β-methoxyethyl acetal; benzoin and benzoin derivatives such as benzoin methyl ether; oximes such as 1-phenyl-1,2-butanedione-2-(O-methoxycarbonyl)oxime, 1-phenyl-1,2-propanedione-2-(O-methoxycarbonyl)oxime, 1-phenyl-1,2-propanedione-2-(O-ethoxycarbonyl)oxime, 1-phenyl-1,2-propanedione-2-(O-benzoyl)oxime, 1,3-diphenylpropanetrione-2-(O-ethoxycarbonyl)oxime, and 1-phenyl-3-ethoxypropanetrione-2-(O-benzoyl)oxime; N-arylglycines such as N-phenylglycine; peroxides such as benzoyl peroxide; aromatic imidazoles; and the like. Furthermore, these can be used alone or in mixture of two or more. Among the above photoinitiators (C), oximes are more preferred, particularly in view of sensitiveness to light.

The photoinitiator (C) is blended in an amount of 0.1 parts by mass to 20 parts by mass, preferably 2 parts by mass to 15 parts by mass from the viewpoint of sensitiveness to light, relative to 100 parts by mass of the polymer of the present invention having the structural unit of the polyimide precursor as the base resin (A). When the photoinitiator (C) is blended in an amount of 0.1 parts by mass or more relative to 100 parts by mass of the base resin (A), the photosensitive resin composition has excellent sensitiveness to light, while the blending amount of 20 parts by mass or less leads to an excellent curing property of the photosensitive resin composition to form a thick film.

### Component (E)

Next, (E) a solvent of the negative photosensitive resin composition of the present invention will be described.

The selectable organic solvent is not limited as long as it is capable of dissolving the base resin (A), the photoinitiator (C), and the nitrogen-containing organic compound (D) represented by the general formula (1). Examples of the solvent (E) include: ketones such as cyclohexanone, cyclopentanone, and methyl-2-n-amyl ketone; alcohols such as 3-methoxybutanol, 3-methyl-3-methoxybutanol, 1-methoxy-2-propanol, and 1-ethoxy-2-propanol; ethers such as propylene glycol monomethyl ether, ethylene glycol monomethyl ether, propylene glycol monoethyl ether, ethylene glycol monoethyl ether, propylene glycol dimethyl ether, and diethylene glycol dimethyl ether; esters such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, propylene glycol-mono-tert-butyl ether acetate, and γ-butyrolactone; and the like. One or more of them can be used. In particular, ethyl lactate, cyclohexanone, cyclopentanone, propylene glycol monomethyl ether acetate, γ-butyrolactone, or a mixed solvent thereof is preferable.

The above solvent is blended in an amount of preferably 50 to 2,000 parts by mass, particularly preferably 100 to 1,000 parts by mass, relative to 100 parts by mass of the total blending amount of the base resin (A) and the photoinitiator **(C).**

### Component (B)

The negative photosensitive resin composition of the present invention preferably further includes (B) a polymerizable compound having two or more ethylenically unsaturated groups.

By containing such a polymerizable compound having two or more ethylenically unsaturated groups in one molecule, it is possible to facilitate crosslinking of the component **(A)** by photopolymerization in an exposed portion, thereby improving the contrast between the exposed portion and an unexposed portion.

The polymerizable compound having two or more ethylenically unsaturated groups (B) is preferably a (meth)acryl compound, and examples thereof preferably include, but are not limited to, ethylene glycol diacrylate, ethylene glycol dimethacrylate, polyethylene glycol diacrylate (the number of each ethylene glycol unit is 2 to 20), polyethylene glycol dimethacrylate (the number of each ethylene glycol unit is 2 to 20), poly(1,2-propylene glycol)diacrylate, poly(1,2-propylene glycol)dimethacrylate, 1,6-hexanediol diacrylate, neopentyl glycol diacrylate, pentaerythritol diacrylate, trimethylolpropane triacrylate, pentaerythritol triacrylate, dipentaerythritol hexaacrylate, tetramethylolpropane tetraacrylate, tetraethylene glycol diacrylate, 1,6-hexanediol dimethacrylate, neopentyl glycol dimethacrylate, pentaerythritol dimethacrylate, trimethylolpropane trimethacrylate, pentaerythritol trimethacrylate, dipentaerythritol hexamethacrylate, tetramethylolpropane tetramethacrylate, glycerol diacrylate, glycerol dimethacrylate, methylenebisacrylamide, N-methylolacrylamide, ethylene glycol diglycidyl ether-methacrylic acid adduct, glycerol diglycidyl ether-acrylic acid adduct, bisphenol A diglycidyl ether-acrylic acid adduct, bisphenol A diglycidyl ether-methacrylic acid adduct, N,N'-bis(2-methacryloyloxyethyl)urea, and the like.

The polymerizable compound having two or more ethylenically unsaturated groups (B) is blended in an amount of preferably 1 to 100 parts by weight, further preferably within a range of 3 to 50 parts by weight, relative to 100 parts by mass of the polymer compound having the structural unit of the polyimide precursor of the present invention. When the amount is within the range of 1 to 100 parts by weight, the intended effect can sufficiently be obtained. Note that as the copolymerizable monomer, one kind of the compound or a mixture of a plurality of kinds of compounds may be used.

### Component (F)

The negative photosensitive resin composition of the present invention can further include, as (F) a thermal crosslinking agent component, one kind or two or more kinds of crosslinking agents selected from an amino condensate modified with formaldehyde or formaldehyde-alcohol, a phenol compound having two or more methylol groups or alkoxymethylol groups on average in one molecule, a compound in which a hydrogen atom of a hydroxyl group of polyhydric phenol is substituted with a glycidyl group, a compound in which a hydrogen atom of a hydroxyl group of polyhydric phenol or a hydroxyl group of polyhydric alcohol is substituted with a substituent represented by the following formula (F-1), and a compound containing two or more nitrogen atoms and having a glycidyl group represented by the following formula (F-2), 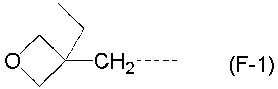 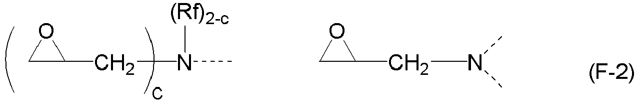 wherein a dotted line represents a bonding arm; Rf represents a linear, branched, or cyclic alkyl group having 1 to 6 carbon atoms; and "c" represents 1 or **2.**

Examples of the amino condensate modified with formaldehyde or formaldehyde-alcohol include melamine condensates modified with formaldehyde or formaldehyde-alcohol, and urea condensates modified with formaldehyde or formaldehyde-alcohol.

The melamine condensate modified with formaldehyde or formaldehyde-alcohol is prepared, for example, by firstly modifying a melamine monomer with formalin into a methylol form according to a known method, or further modifying it with alcohol into an alkoxy form, thereby yielding a modified melamine represented by the following general formula (23). Note that the above alcohol is preferably lower alcohol, for example, alcohol having 1 to 4 carbon atoms. 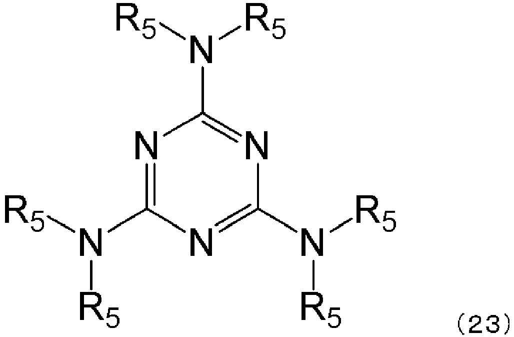 In the formula, R₅ may be identical to or different from each other, and represents a methylol group, an alkoxymethyl group containing an alkoxy group having 1 to 4 carbon atoms, or a hydrogen atom, provided that at least one R₅ represents a methylol group or the alkoxymethyl group.

Examples of the R₅ include alkoxymethyl groups such as methylol group, methoxymethyl group, and ethoxymethyl group, a hydrogen atom, etc.

Specific examples of the modified melamine represented by the above general formula (23) include trimethoxy methyl monomethylol melamine, dimethoxy methyl monomethylol melamine, trimethylol melamine, hexamethylol melamine, hexa methoxy methylol melamine, and the like.

Next, the modified melamine represented by the above general formula (23) or a multimer thereof (for example, an oligomer such as a dimer or trimer) is subjected to addition condensation polymerization with formaldehyde according to a usual method until a desired molecular weight is obtained, thereby obtaining the melamine condensate modified with formaldehyde or formaldehyde-alcohol.

Furthermore, the urea condensate modified with formaldehyde or formaldehyde-alcohol is prepared, for example, by modifying a urea condensate having a desired molecular weight with formaldehyde into a methylol form according to a known method, or further modifying it with alcohol into an alkoxy form.

Specific examples of the urea condensate modified with formaldehyde or formaldehyde-alcohol include methoxymethylated urea condensates, ethoxymethylated urea condensates, propoxymethylated urea condensates, and the like.

Incidentally, it is also possible to use one kind or two or more kinds of these modified melamine condensates and modified urea condensates.

Then, examples of the phenol compound having two or more methylol groups or alkoxymethylol groups on average in one molecule include (2-hydroxy-5-methyl)-1,3-benzenedimethanol, 2,2',6,6'-tetramethoxymethylbisphenol A, compounds represented by the following formulae (F-3) to (F-8), and the like.

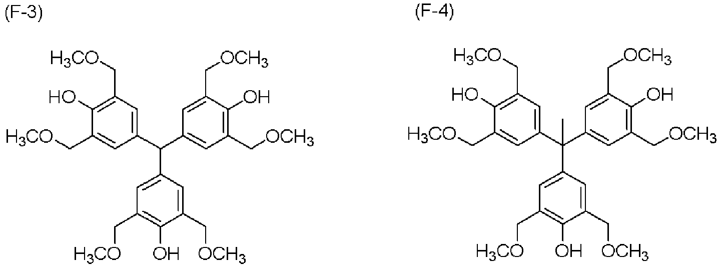

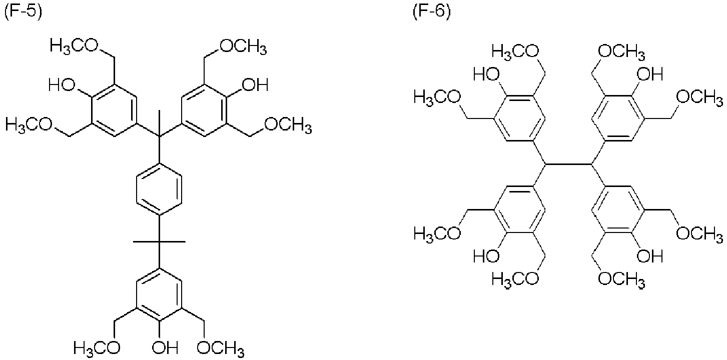

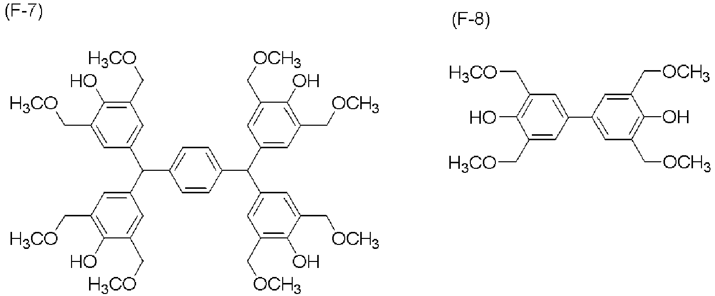

Note that the above crosslinking agents can be used alone or in combination of two or more.

Meanwhile, examples of the compound in which a hydrogen atom of a hydroxyl group of polyhydric phenol is substituted with a glycidyl group include compounds obtained by reacting a hydroxyl group of bisphenol A, tris(4-hydroxyphenyl)methane, or 1,1,1-tris(4-hydroxyphenyl)ethane with epichlorohydrin in the presence of a base. Suitable examples of the compound in which a hydrogen atom of a hydroxyl group of polyhydric phenol is substituted with a glycidyl group include compounds represented by the following formulae (F-9) to (F-15), 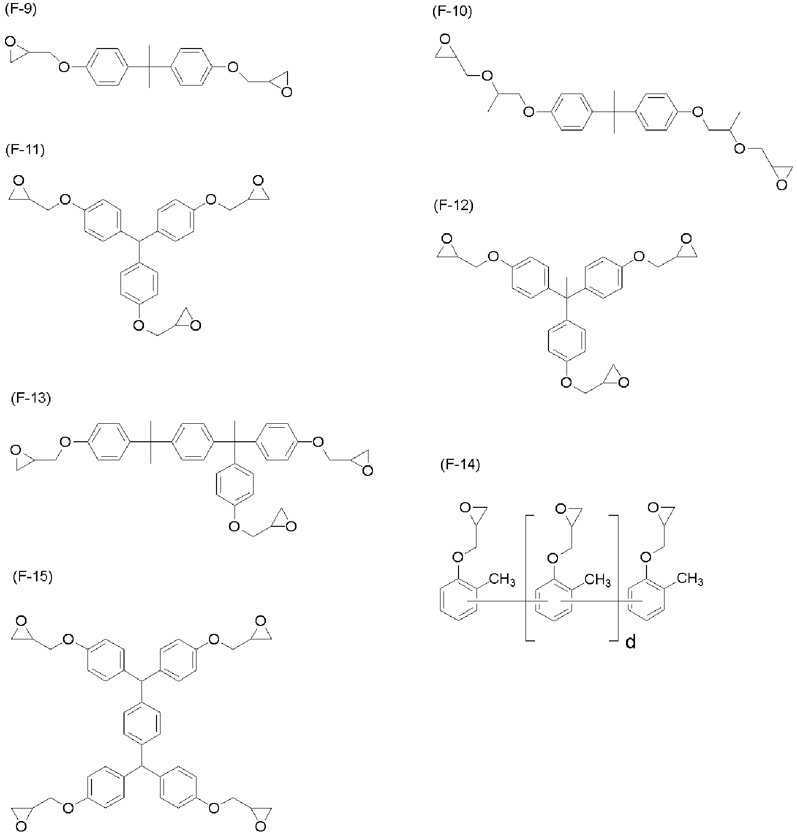 wherein "d" satisfies 2≤d≤3.

Additionally, besides the compounds of the above formulae (F-9) to (F-15), preferable examples include EPICLON 850-S, EPICLON HP-4032, EPICLON HP-7200, EPICLON HP-820, EPICLON HP-4700, EPICLON EXA-4710, EPICLON HP-4770, EPICLON EXA-859CRP, EPICLON EXA-4880, EPICLON EXA-4850, EPICLON EXA-4816, EPICLON EXA-4822 (all trade names, manufactured by DIC Corporation), RIKARESIN BPO-20E, RIKARESIN BEO-60E (both trade names, manufactured by New Japan Chemical **Co.,** Ltd.), EP-4003S, EP-40005, EP-4000S, EP-4000L (all trade names, manufactured by ADEKA Corporation), jER828EL, YX7105 (both trade names, manufactured by Mitsubishi Chemical Corporation), and the like.

One kind or two kinds of these compounds in which a hydroxyl group of polyhydric phenol is substituted with a glycidoxy group (compound in which a hydrogen atom of a hydroxyl group of polyhydric phenol is substituted with a glycidyl group) can be used as the crosslinking agent.

An example of the compound in which a hydrogen atom of a hydroxyl group of polyhydric phenol is substituted with a substituent represented by the following formula (F-1) is a compound containing the two or more substituents as represented by the following formula (F-16), 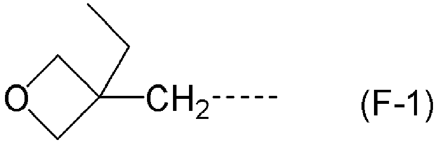 wherein a dotted line represents an attachment point, 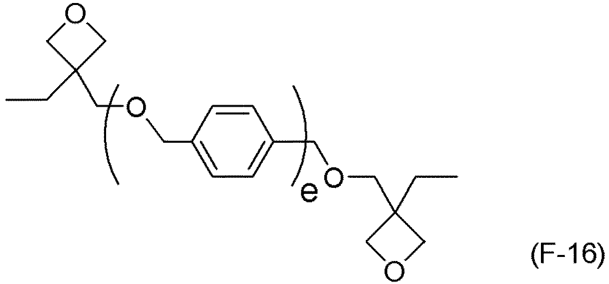 wherein "e" satisfies 1≤e≤3.

Additionally, besides the compounds of the above formulae (F-9) to (F-16), preferable examples include 3-ethyl-3-hydroxymethyl oxetane, 1,4-bis{[(3-ethyl-3-oxetanyl)methoxy]methyl}benzene, 3-ethyl-3-(2-ethylhexylmethyl)oxetane, 1,4-benzenedicarboxylic acid-bis[(3-ethyl-3-oxetanyl)methyl]ester, Aron Oxetane series manufactured by TOAGOSEI CO., LTD., and the like.

Meanwhile, an example of the compound containing two or more nitrogen atoms and having a glycidyl group represented by the following formula (F-2) is a compound represented by the following formula (F-17), 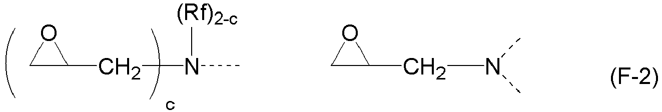
wherein a dotted line represents an attachment point; Rf represents a linear, branched, or cyclic alkyl group having 1 to 6 carbon atoms; and "c" represents 1 or 2, 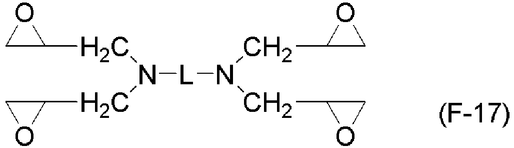
wherein L represents a linear, branched, or cyclic alkylene group having 2 to 12 carbon atoms, or a divalent aromatic group.

Examples of the compound represented by the above formula (F-17) include compounds represented by the following formulae (F-18) to (F-21).

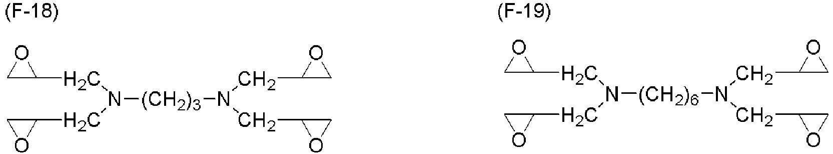

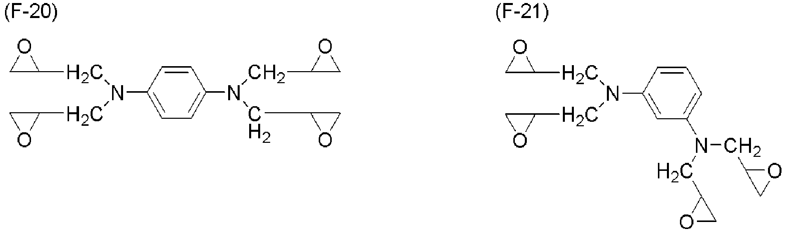

Meanwhile, as the compound containing two or more nitrogen atoms and having a glycidyl group represented by the above formula (F-2), compounds represented by the following formulae (F-22) and (F-23) can be suitably used.

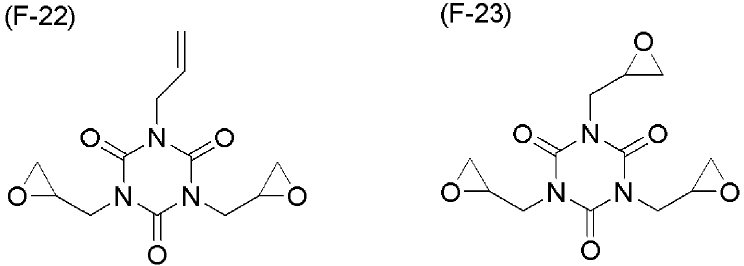

One kind or two kinds of these compounds containing two or more nitrogen atoms and having a glycidyl group represented by the above formula (F-2) can be used as the crosslinking agent.

An epoxy group has a great distortion in the ring and has high reactivity, while oxetane has high basicity and is easily bonded to an acid. It has been reported that reactivity in cation polymerization is remarkably improved by combining an epoxy group with an oxetanyl group.

The component (F) is a component that causes crosslinking reaction in post curing after pattern formation using the negative photosensitive resin composition of the present invention, thereby further enhancing strength of a cured material. Such component (F) has a weight-average molecular weight of preferably 150 to 10,000 and particularly preferably 200 to 3,000 from the viewpoints of a photocuring property and heat resistance.

In the negative photosensitive resin composition of the present invention, the component (F) is blended in an amount of preferably 0.5 to 100 parts by mass, particularly preferably 1 to 80 parts by mass, relative to 100 parts by mass of the component (A).

### Component (G)

The negative photosensitive resin composition of the present invention preferably further includes (G) an antioxidant. By containing the antioxidant as the component (G), it is possible to prevent unnecessary crosslinking between the components (A) or between the components (A) and (B) during patterning, and improve the contrast. Additionally, due to an anticorrosion effect on a metal material, it is possible to prevent oxidation of metal by water from the outside, a photoacid generator, a thermal acid generator, etc., and accompanying decrease in adhesion and peeling off.

Here, specific examples of the usable antioxidant (G) preferably include hindered phenol antioxidants, phosphorus antioxidants, and sulfur antioxidants. However, the antioxidant (G) is not limited thereto. Furthermore, these antioxidants (G) can be used alone or in combination of two or more.

Among the specific examples of the antioxidant (G), further examples of the hindered phenol antioxidants include pentaerythritol tetrakis[3-(3,5-di-tert-butyl-4-hydroxyphenyl)propionate] (BASF Japan Ltd., Irganox 1010 (trade name)), thiodiethylene bis[3-(3,5-di-tert-butyl-4-hydroxyphenyl)propionate] (BASF Japan Ltd., Irganox 1035 (trade name)), octadecyl[3-(3,5-di-tert-butyl-4-hydroxyphenyl)propionate] (BASF Japan Ltd., Irganox 1076 (trade name)), octyl-1-3,5-di-tert-butyl-4-hydroxyhydrocinnamic acid (BASF Japan Ltd., Irganox 1135 (trade name)), 4,6-bis(octylthiomethyl-o-cresol) (BASF Japan Ltd., Irganox 1520L), Sumilizer GA80 (manufactured by Sumitomo Chemical Co., Ltd., trade name), Adekastab AO-20 (manufactured by ADEKA Corporation, trade name), Adekastab AO-30 (manufactured by ADEKA Corporation, trade name), Adekastab AO-40 (manufactured by ADEKA Corporation, trade name), Adekastab AO-50 (manufactured by ADEKA Corporation, trade name), Adekastab AO-60 (manufactured by ADEKA Corporation, trade name), Adekastab AO-80 (manufactured by ADEKA Corporation, trade name), Adekastab AO-330 (manufactured by ADEKA Corporation, trade name), the hindered phenol antioxidant described in WO 2017/188153 A1, and the like.

Among the specific examples of the antioxidant (G), further examples of the phosphorus antioxidants include triphenyl phosphite, tris(methylphenyl)phosphite, triisooctyl phosphite, tridecyl phosphite, tris(2-ethylhexyl)phosphite, tris(nonylphenyl)phosphite, tris(octylphenyl)phosphite, tris[decylpoly(oxyethylene)phosphite, tris(cyclohexylphenyl)phosphite, tricyclohexyl phosphite, tri(decyl)thiophosphite, triisodecyl thiophosphite, phenyl-bis(2-ethylhexyl)phosphite, phenyl-diisodecyl phosphite, tetradecylpoly(oxyethylene)-bis(ethylphenyl)phosphate, phenyl-dicyclohexyl phosphite, phenyl-diisooctyl phosphite, phenyl-di(tridecyl)phosphite, diphenyl-cyclohexyl phosphite, diphenyl-isooctyl phosphite, diphenyl-2-ethylhexyl phosphite, diphenyl-isodecyl phosphite, diphenyl-cyclohexylphenyl phosphite, diphenyl-(tridecyl)thiophosphite, and the like.

Among the specific examples of the antioxidant (G), further examples of the sulfur antioxidants include Adekastab AO-412S (manufactured by ADEKA Corporation, trade name), AO-503S (manufactured by ADEKA Corporation, trade name), Sumilizer TP-D (manufactured by Sumitomo Chemical Co., Ltd., trade name), and the like.

The sulfur antioxidants and the phosphorus antioxidants can be expected to have an effect of decomposing peroxide.

Furthermore, the antioxidant (G) is contained in an amount of preferably 0.1 to 10 parts by mass, more preferably 0.2 to 5 parts by mass, relative to 100 parts by mass of the polymer of the component (A). When the amount is 0.1 parts by mass or more, adhesion to a metal material is improved and peeling off is also prevented. In addition, when the amount is 10 parts by mass or less, developability of the composition and toughness of a cured film never deteriorate.

### Component (H)

The negative photosensitive resin composition of the present invention preferably further includes (H) a silane compound. The negative photosensitive resin composition of the present invention preferably includes a metal adhesiveness improver for improving adhesiveness to a metal material used in an electrode, wiring, etc. Examples of the metal adhesiveness improver include a silane compound and the like.

Examples of the silane compound include the compound described in paragraph 0167 of WO 2015/199219 A1, the compounds described in paragraphs 0062 to 0073 of JP 2014-191002 A, the compounds described in paragraphs 0063 to 0071 of WO 2011/080992 A1, the compounds described in paragraphs 0060 to 0061 of JP 2014-191252 A, the compounds described in paragraphs 0045 to 0052 of JP 2014-041264 A, and the compounds described in paragraph 0055 of WO 2014/097594 A1. Furthermore, as described in paragraphs 0050 to 0058 of JP 2011-128358 A, it is also preferable to use two or more kinds of different silane coupling agents.

Here, the usable silane compound (H) preferably contains an alkoxysilyl group, but is not particularly limited thereto. Further, specific suitable examples include the following: γ-glycidoxypropyltriethoxysilane, γ-glycidoxypropyltrimethoxysilane, 2-(3,4-epoxycyclohexyl)ethyltrimethoxysilane, bis(2-hydroxyethyl)-3-aminopropyl-triethoxysilane, γ-aminopropyltrimethoxysilane, γ-aminopropyltriethoxysilane, vinyltriethoxysilane, vinyltrimethoxysilane, γ-methacryloxypropyltrimethoxysilane, γ-acryloxypropyltrimethoxysilane, 3-mercaptopropyltrimethoxysilane, 3-isocyanatepropyltriethoxysilane, bis(2-hydroxyethyl)-3-aminopropyltriethoxysilane, triethoxysilylpropylethyl carbamate, 3-(triethoxysilyl)propylsuccinic anhydride, phenyltriethoxysilane, phenyltrimethoxysilane, N-phenyl-3-aminopropyltrimethoxysilane, 3-triethoxysilyl-N-(1,3-dimethylbutylidene)propylamine, the silane compound containing an amide group described in JP 6414060 B, the silane compound containing a thiourea group described in WO 2016/140024 A1 and JP 5987984 B, the silane compound containing a thiol group described in JP 2017-044964 A, and the like. However, the silane compound (H) is not limited thereto. Furthermore, these silane compounds (H) can be used alone or in combination of two or more.

Furthermore, it is also preferable to use compounds represented by the following formulae (H-1) to (H-7) as the silane coupling agent.

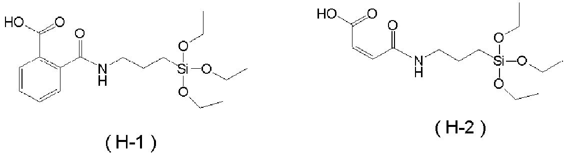

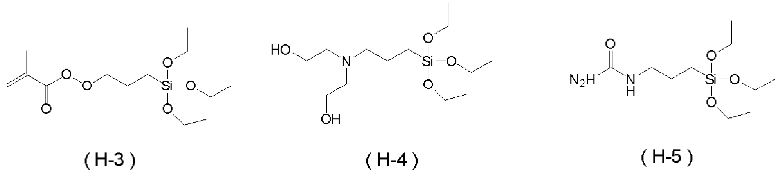

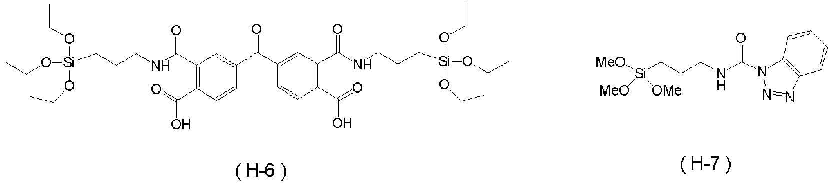

The silane compound (H) as the metal adhesiveness improver is contained in an amount of preferably 0.1 to 30 parts by mass, more preferably 0.5 to 15 parts by mass, and further preferably 0.5 to 5 parts by mass relative to 100 parts by mass of the polymer compound having the structural unit of the polyimide precursor used in the negative photosensitive resin composition of the present invention. The amount equal to or more than the above lower limit leads to favorable adhesiveness between a cured film and a metal layer after a curing process, whereas the amount equal to or less than the above upper limit leads to favorable heat resistance and mechanical properties of the cured film after the curing process. One kind or two or more kinds of the silane compounds (H) as the metal adhesiveness improver may be used. When two or more kinds thereof are used, the total amount thereof is preferably within the above range.

### Component (I)

In the present invention, (I) a polymerization inhibitor is preferably further included. As the polymerization inhibitor (I), a heat polymerization inhibitor can be added in order to improve stability of viscosity and sensitivity to light of the composition solution during storage. A known heat polymerization inhibitor is usable according to the object of the present invention. Examples thereof include hydroquinone, N-nitrosodiphenylamine, p-tert-butylcatechol, phenothiazine, N-phenylnaphthylamine, ethylenediaminetetraacetic acid, 1,2-cyclohexanediaminetetraacetic acid, glycol ether diamine tetraacetic acid, 2,6-di-tert-butyl-p-methylphenol, 5-nitroso-8-hydroxyquinoline, 1-nitroso-2-naphthol, 2-nitroso-1-naphthol, 2-nitroso-5-(N-ethyl-N-sulfopropylamino)phenol, N-nitroso-N-phenylhydroxylamine ammonium salt, N-nitroso-N(1-naphthyl)hydroxylamine ammonium salt, and the like. An amount of the polymerization inhibitor (I) to be added to the negative photosensitive resin composition of the present invention is preferably within a range of 0.005 to 5 parts by weight relative to 100 parts by mass of the polymer compound having the structural unit of the polyimide precursor used in the negative photosensitive resin composition of the present invention.

### Others

Additionally, the negative photosensitive resin composition of the present invention may further include other components, besides the polymer compound having the polyimide precursor structure (A), the photoinitiator (C), and the nitrogen-containing organic compound (D) represented by the general formula (1). Examples of other components include (J) a sensitizer, (K) a migration inhibitor, (L) a surfactant, etc.

Examples of the sensitizer (J) include Michler's Ketone, 4,4'-bis(diethylamino)benzophenone, 2,5-bis(4'-diethylaminobenzal)cyclopentane, 2,6-bis(4'-diethylaminobenzal)cyclohexanone, 2,6-bis(4'-diethylaminobenzal)-4-methylcyclohexanone, 4,4'-bis(dimethylamino)chalcone, 4,4'-bis(diethylamino)chalcone, p-dimethylamino cinnamylidene indanone, p-dimethylamino benzylideneindanone, 2-(p-dimethylaminophenyl biphenylene)-benzothiazole, 2-(p-dimethylaminophenyl vinylene)benzothiazole, 2-(p-dimethylaminophenyl vinylene)isonaphthothiazole, 1,3-bis(4'-dimethylaminobenzal)acetone, 1,3-bis(4'-diethylaminobenzal)acetone, 3,3'-carbonyl-bis(7-diethylaminocoumarin), 3-acetyl-7-dimethylaminocoumarin, 3-ethoxycarbonyl-7-dimethylaminocoumarin, 3-benzyloxycarbonyl-7-dimethylaminocoumarin, 3-methoxycarbonyl-7-diethylaminocoumarin, 3-ethoxycarbonyl-7-diethylaminocoumarin, N-phenyl-N'-ethyl ethanolamine, N-phenyldiethanolamine, N-p-tolyldiethanolamine, N-phenylethanolamine, 4-morpholinobenzophenone, isoamyl dimethylamino benzoate, isoamyl diethylamino benzoate, 2-mercaptobenzimidazole, 1-phenyl-5-mercaptotetrazole, 2-mercaptobenzothiazole, 2-(p-dimethylamino styryl)benzoxazole, 2-(p-dimethylaminostyryl)benzthiazole, 2-(p-dimethylaminostyryl)naphtho(1,2-d)thiazole, and 2-(p-dimethylaminobenzoyl) styrene. These can be used alone or in combination of 2 to 5 kinds thereof.

Furthermore, the sensitizer (J) is blended in an amount of preferably 0.05 to 20 parts by mass, more preferably 0.1 to 10 parts by mass, relative to 100 parts by mass of the polymer of the component (A).

The negative photosensitive resin composition of the present invention preferably further includes the migration inhibitor (K). By containing the migration inhibitor, it is possible to effectively prevent migration of metal ions derived from a metal layer (metal wiring) into a curable resin composition layer.

Examples of the migration inhibitor (K) include, but are not particularly limited to, compounds having a heterocycle (pyrrole ring, furan ring, thiophene ring, imidazole ring, oxazole ring, thiazole ring, pyrazole ring, isoxazole ring, isothiazole ring, tetrazole ring, pyridine ring, pyridazine ring, pyrimidine ring, pyrazine ring, piperidine ring, piperazine ring, morpholine ring, 2H-pyran ring and 6H-pyran ring, triazine ring), compounds having thioureas and a sulfanyl group, hindered phenol compounds, salicylic acid derivative compounds, and hydrazide derivative compounds. In particular, triazole compounds such as 1,2,4-triazole and benzotriazole, and tetrazole compounds such as 1H-tetrazole and 5-phenyltetrazole can be preferably used.

It is also possible to use an ion trapping agent, which captures anions such as a halogen ion, as the migration inhibitor (K).

It is possible to use other migration inhibitors such as the corrosion inhibitors described in paragraph 0094 of JP 2013-01571 A, the compounds described in paragraphs 0073 to 0076 of JP 2009-283711 A, the compounds described in paragraph 0052 of JP 2011-059656 A, the compounds described in paragraphs 0114, 0116, and 0118 of JP 2012-194520 A, and the compounds described in paragraph 0166 of WO 2015/199219 A1.

Specific examples of the migration inhibitor include the following compounds.

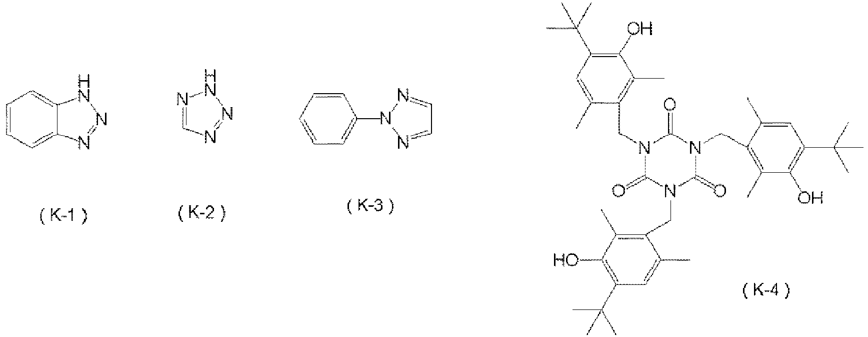

When the negative photosensitive resin composition of the present invention includes the migration inhibitor, the migration inhibitor is contained in an amount of preferably 0.01 to 5.0 mass%, more preferably 0.05 to 2.0 mass%, and further preferably 0.1 to 1.0 mass% relative to 100 parts by mass of the polymer compound having the structural unit of the polyimide precursor used in the negative photosensitive resin composition of the present invention.

Only one kind or two or more kinds of migration inhibitors may be used. When two or more kinds of migration inhibitors are used, the total amount thereof is preferably within the above range.

The surfactant (L) is preferably a nonionic surfactant, for example, a fluorochemical surfactant. Specific examples thereof include perfluoroalkyl polyoxyethylene ethanol, fluorinated alkyl ester, perfluoroalkylamine oxide, fluorine-containing organosiloxane compounds, and the like.

Commercially available surfactants can be used as these surfactants. Examples thereof include Fluorad "FC-4430" (manufactured by Sumitomo 3M Limited), Surflon "S-141" and "S-145" (both manufactured by AGC Inc.), UNIDYNE "DS-401", "DS-4031", and "DS-451" (all manufactured by DAIKIN INDUSTRIES, LTD.), Megafac "F-8151" (manufactured by DIC Corporation), "X-70-093" (manufactured by Shin-Etsu Chemical Co., Ltd.), and the like. Among them, Fluorad "FC-4430" (manufactured by Sumitomo 3M Limited) and "X-70-093" (manufactured by Shin-Etsu Chemical Co., Ltd.) are preferred.

Further, the surfactant (L) is preferably blended in an amount of 0.01 to 0.05 parts by mass relative to 100 parts by mass of the polymer of the component (A). The amount within this range has the advantage of improving application performance onto a substrate without impairing patterning performance or properties of a cured film.

### Patterning Process

Next, a patterning process of the negative photosensitive resin composition of the present invention will be described.

The present invention is a patterning process including the steps of:
(1) applying the negative photosensitive resin composition as described above onto a substrate to form a photosensitive material film;
(2) heating and thereafter exposing the photosensitive material film to a high-energy beam having a wavelength of 190 to 500 nm or an electron beam through a photomask; and
(3) performing development with a developer of an organic solvent after the exposing.

For the negative photosensitive resin composition of the present invention, known lithography techniques can be employed. For example, the negative photosensitive resin composition of the present invention can be applied onto a silicon wafer, a SiO₂ substrate, a SiN substrate, or a substrate having a formed pattern such as copper wiring by spin coating, and prebaked at 80 to 130°C for about 50 to 600 seconds to form a resist film having a thickness of 1 to 50 µm, preferably 1 to 30 µm, and further preferably 5 to 20 µm. Next, a mask for forming an intended pattern is held over the resist film, which is then irradiated with and exposed to a high-energy beam having a wavelength of 190 to 500 nm, such as i-line and g-line, at an exposure dose of about 1 to 5,000 mJ/cm², preferably about 100 to 2,000 mJ/cm².

Thereafter, development is performed. Development with an organic solvent is suitable for the negative photosensitive resin composition of the present invention. As a suitable organic solvent usable for the organic solvent development, the above-described solvents used for preparation of the photosensitive resin composition of the present invention can be employed. For example, ketones such as cyclohexanone and cyclopentanone, and further glycols such as propylene glycol monomethyl ether are preferred. The development can be performed by common methods such as a spray method and a paddle method, or by dipping in a developer, etc. Subsequently, cleaning, rinsing, drying, etc. can be performed as necessary, thereby obtaining a resist film having a desired pattern.

Furthermore, the obtained film having the pattern is post-cured using an oven or a hot plate at a temperature of 100 to 300°C, preferably 150 to 300°C, and further preferably 180 to 250°C. The post-curing temperature of 100 to 300°C enables to increase crosslinking density of the film of the photosensitive resin composition and remove remaining volatile components, and thus is preferable from the viewpoints of adhesion to a substrate, heat resistance, strength, and electrical properties. Further, the post-curing time can be 10 minutes to 10 hours.

The cured film obtained in this manner is excellent in adhesion to a substrate, heat resistance, electrical properties, mechanical strength, and chemical resistance, provides a semiconductor device with excellent reliability when used as a protective film, can prevent occurrence of cracks particularly during a temperature cycle test, and can be suitably used as a protective film for electric/electronic components, semiconductor devices, etc.

Thus, the present invention provides an interlayer insulating film or a surface protective film that is a cured film of the above-described negative photosensitive resin composition.

The protective film is effective for use as an insulator film for a semiconductor device including rewiring use, an insulator film for a multilayer printed substrate, a solder mask, a cover lay film, etc. due to its heat resistance, chemical resistance, and an insulation property.

The present invention further provides an electronic component including the above-described interlayer insulating film or the above-described surface protective film.

Such electronic component includes a protective film (interlayer insulating film or surface protective film) excellent in heat resistance, chemical resistance, and an insulation property, and thus has excellent reliability.

### EXAMPLE

Hereinafter, the present invention will be specifically described with reference to Synthesis Examples, Comparative Synthesis Examples, Examples, and Comparative Examples. However, the present invention is not limited to the following examples.

### I. Synthesis of Polymer Compound

A chemical structure and a name of a compound are shown below, which was used in the following Synthesis Examples of a polymer compound for use in the negative photosensitive resin composition of the present invention.

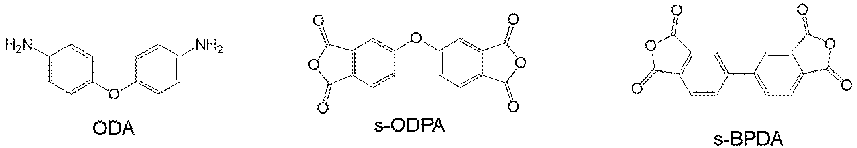

| | |
|---|---|
| ODA | 4,4'-diaminodiphenyl ether |
| s-ODPA | 3,3',4,4'-oxydiphthalic dianhydride |
| s-BPDA | 3,3',4,4'-biphenyltetracarboxylic dianhydride |

### Synthesis Example 1: Synthesis of Tetracarboxylic Acid Diester Compound (X-1)

Into a 3-L flask equipped with a stirrer and a thermometer, 100 g (322 mmol) of 3,3',4,4'-oxydiphthalic dianhydride (s-ODPA), 65.2 g (644 mmol) of triethylamine, 39.3 g (322 mmol) of N,N-dimethyl-4-aminopyridine, and 400 g of γ-butyrolactone were added. 83.8 g (644 mmol) of hydroxyethyl methacrylate (HEMA) was added dropwise thereto under stirring at room temperature, and then stirring was carried out at room temperature for 24 hours. Thereafter, 370 g of 10% hydrochloric acid aqueous solution was added dropwise under ice cooling to stop the reaction. To the reaction liquid, 800 g of 4-methyl-2-pentanone was added, and the organic layer was separated and then washed six times with 600 g of water. The solvent of the obtained organic layer was distilled off, thereby obtaining 180 g of a tetracarboxylic acid diester compound (X-1) having the following structure.

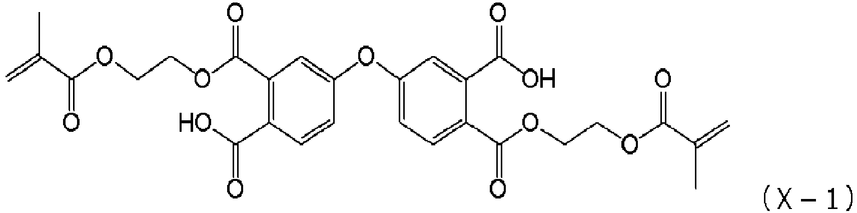

### Synthesis Example 2: Synthesis of Tetracarboxylic Acid Diester Compound (X-2)

With the same formulation as in Synthesis Example 1 except that the 3,3',4,4'-oxydiphthalic dianhydride (s-ODPA) was changed to 94.8 g (322 mmol) of 3,3',4,4'-biphenyltetracarboxylic dianhydride (s-BPDA), 172 g of a tetracarboxylic acid diester compound (X-2) having the following structure was obtained.

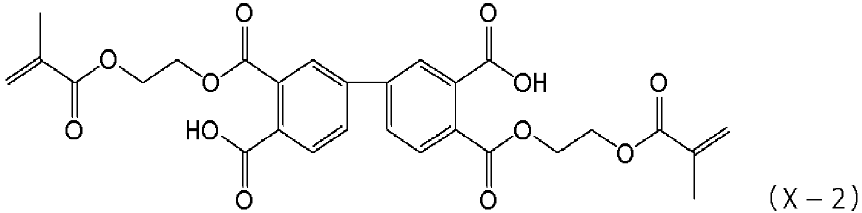

### Synthesis Example 3: Synthesis of Polyimide Precursor (A-1)

Into a 1-L flask equipped with a stirrer and a thermometer, 44.0 g (77.1 mmol) of (X-1) and 176 g of N-methyl-2-pyrrolidone were added and dissolved by stirring at room temperature. Next, 18.8 g (158.1 mmol) of thionyl chloride was added dropwise under ice cooling so as to maintain the temperature of the reaction solution at 10°C or lower, and stirred under ice cooling for two hours after completion of the dropwise addition. Subsequently, a solution prepared by dissolving 14.4 g (71.7 mmol) of 4,4'-diaminodiphenyl ether (ODA) and 25.0 g (316.2 mmol) of pyridine in 70 g of N-methyl-2-pyrrolidone was added dropwise under ice cooling so as to maintain the temperature of the reaction solution at 10°C or lower. After completion of the dropwise addition, the temperature was returned to room temperature, and this reaction liquid was added dropwise to 3L of water under stirring. A precipitate was separated by filtration, washed as appropriate, and then dried under reduced pressure at 40°C for 48 hours, thereby obtaining a polyimide precursor (A-1). A molecular weight of this polymer was measured by GPC using DMF as an eluent at a temperature of 40°C, resulting in a weight-average molecular weight of 24,000 in terms of polystyrene.

### Synthesis Example 4: Synthesis of Polyimide Precursor (A-2)

A polyimide precursor (A-2) was obtained in the same manner except that (X-1) shown in the above Synthesis Example 3 was changed to 42.8 g (77.1 mmol) of (X-2). A molecular weight of this polymer was measured by GPC using DMF as an eluent at a temperature of 40°C, resulting in a weight-average molecular weight of 23,000 in terms of polystyrene.

### II. Nitrogen-Containing Organic Compound

Compounds used in Synthesis Examples of the nitrogen-containing organic compound for use in the negative photosensitive resin composition of the present invention are shown below.
Azoles
   (13-1-1) imidazole
   (13-1-2) 1,2,4-triazole
   (13-1-3) benzimidazole
Carbonyl diazoles
   (13-2-1) 1,1'-carbonyldiimidazole
   (13-2-2) 1,1'-carbonyldi(1,2,4-triazole)
   (13-2-3) 1,1'-carbonyldibenzimidazole Halocarbonate esters
   (2-4-1) 4-nitrophenyl chloroformate
Carbonate diesters
   (2-5-1) di(N-succinimidyl)carbonate
   (3-5-1) bis(pentafluorophenyl)carbonate
Hydroxy group-containing compound, in which W in the above formula is attached to a hydrogen atom
   (2-6-1) N-hydroxyphthalimide
   (4-6-1) 1-hydroxy-benzotriazole
   (4-6-2) 1-hydroxy-6-(trifluoromethyl)benzotriazole

### Synthesis Example 5: Synthesis of 1H-Imidazole-1-Carboxylic Acid N-Hydroxysuccinimide Ester (D-1)

In a 300-ml flask equipped with a reflux condenser, a stirrer, and a thermometer, 62 mg (0.55 mmol) of 4-(N,N-dimethylamino)pyridine and 2.04 g (30.0 mmol) of imidazole (13-1-1) were dissolved in 50 mL of acetonitrile and stirred at 25°C under nitrogen. The resultant was added to 7.69 g (30.0 mmol) of di(N-succinimidyl)carbonate (2-5-1) in 50 mL of acetonitrile solution. Then, the solution was stirred at 25°C for 12 hours. After completion of the reaction, the reaction liquid was charged into 200 mL of cold water, and the organic layer was extracted by using 30 mL of ethyl acetate three times. The organic layer was further washed three times with 50 mL of cold water, dried over magnesium sulfate, then concentrated under reduced pressure, and crystallized by using petroleum ether to obtain 1H-imidazole-1-carboxylic acid N-hydroxysuccinimide ester (D-1) having the following structure (5.02 g, yield: 80.0%).

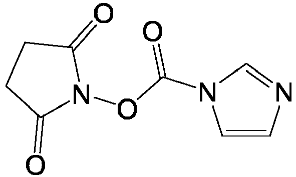

### (D-1) 1H-imidazole-1-carboxylic acid N-hydroxysuccinimide ester

### Synthesis Example 6: Synthesis of 1H-1,2,4-Triazole-1-Carboxylic Acid N-Hydroxysuccinimide Ester (D-2)

The imidazole (13-1-1) in Synthesis Example 5 was changed to 2.07 g of 1,2,4-triazole (13-1-2), and the reaction was carried out in the same manner to obtain 1H-1,2,4-triazole-1-carboxylic acid N-hydroxysuccinimide ester (D-2) having the following structure (4.92 g, yield: 78.1%).

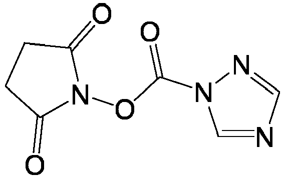

### (D-2) 1H-1,2,4-triazole-1-carboxylic acid N-hydroxysuccinimide ester

### Synthesis Example 7: Synthesis of 1H-Benzimidazole-1-Carboxylic Acid N-Hydroxysuccinimide Ester (D-3)

The imidazole (13-1-1) in Synthesis Example 5 was changed to 3.54 g of benzimidazole (13-1-3), and the reaction was carried out in the same manner to obtain 1H-benzimidazole-1-carboxylic acid N-hydroxysuccinimide ester (D-3) having the following structure (5.89 g, yield: 75.8%).

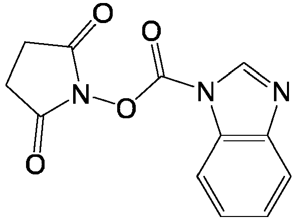

### (D-3) 1H-benzimidazole-1-carboxylic acid N-hydroxysuccinimide ester

### Synthesis Example 8: Synthesis of 1H-Imidazole-1-Carboxylic Acid N-Hydroxyphthalimide Ester (D-4)

In a 300-ml flask equipped with a reflux condenser, a stirrer, and a thermometer, 4.86 g (30.0 mmol) of 1,1'-carbonyldiimidazole (13-2-1) was dissolved in 50 mL of acetonitrile and stirred at 25°C under nitrogen. The resultant was added to 4.89 g (30.0 mmol) of N-hydroxyphthalimide (2-6-1) in 50 mL of acetonitrile solution.

Then, the solution was stirred at 25°C for 12 hours. After completion of the reaction, the reaction liquid was charged into 200 mL of cold water and the organic layer was extracted by using 30 mL of ethyl acetate three times. The organic layer was further washed three times with 50 mL of cold water, dried over magnesium sulfate, then concentrated under reduced pressure, and crystallized by using petroleum ether to obtain 1H-imidazole-1-carboxylic acid N-hydroxyphthalimide ester (D-4) having the following structure (5.48 g, yield: 71.0%).

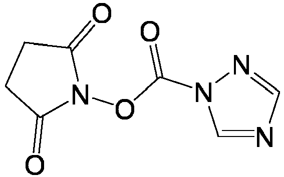

### (D-4) 1H-imidazole-1-carboxylic acid N-hydroxyphthalimide ester

### Synthesis Example 9: Synthesis of 1H-1,2,4-Triazole-1-Carboxylic Acid N-Hydroxyphthalimide Ester (D-5)

The 1,1'-carbonyldiimidazole (13-2-1) in Synthesis Example 8 was changed to 4.92 g of 1,1'-carbonyldi(1,2,4-triazole) (13-2-2), and the reaction was carried out in the same manner to obtain 1H-1,2,4-triazole-1-carboxylic acid N-hydroxyphthalimide ester (D-5) having the following structure (5.35 g, yield: 69.1%).

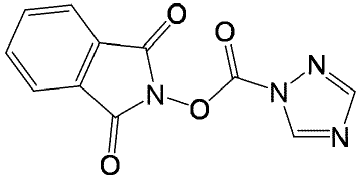

### (D-5) 1H-1,2,4-triazole-1-carboxylic acid N-hydroxyphthalimide ester

### Synthesis Example 10: Synthesis of 1H-Benzimidazole-1-Carboxylic Acid N-Hydroxyphthalimide Ester (D-6)

The 1,1'-carbonyldiimidazole (13-2-1) in Synthesis Example 8 was changed to 7.87 g of 1,1'-carbonyldibenzimidazole (13-2-3), and the reaction was carried out in the same manner to obtain 1H-benzimidazole-1-carboxylic acid N-hydroxyphthalimide ester (D-6) having the following structure (5.36 g, yield: 58.1%).

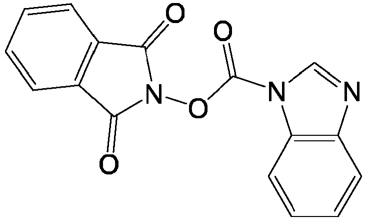

### (D-6) 1H-benzimidazole-1-carboxylic acid N-hydroxyphthalimide ester

### Synthesis Example 11: Synthesis of 1H-Imidazole-1-Carboxylic Acid 4-Nitrophenyl Ester (D-7)

In a 300-ml flask equipped with a reflux condenser, a stirrer, and a thermometer, 62 mg (0.55 mmol) of 4-(N,N-dimethylamino)pyridine and 2.04 g (30.0 mmol) of imidazole (13-1-1) were dissolved in 50 mL of methylene chloride, and stirred at 25°C under nitrogen. The resultant was added to 6.05 g (30.0 mmol) of 4-nitrophenyl chloroformate (2-4-1) in 50 mL of methylene chloride solution. Then, the solution was stirred at 25°C for 12 hours. After completion of the reaction, the reaction liquid was charged into 200 mL of cold water, and the organic layer was separated. The organic layer was further washed three times with 50 mL of cold water, dried over magnesium sulfate, then concentrated under reduced pressure, and crystallized by using petroleum ether to obtain 1H-imidazole-1-carboxylic acid 4-nitrophenyl ester (D-7) having the following structure (6.16 g, yield: 88.0%).

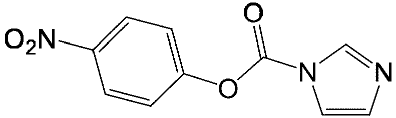

### (D-7) 1H-imidazole-1-carboxylic acid 4-nitrophenyl ester

### Synthesis Example 12: Synthesis of 1H-1,2,4-Triazole-1-Carboxylic Acid 4-Nitrophenyl Ester (D-8)

The imidazole (13-1-1) in Synthesis Example 11 was changed to 2.07 g of 1,2,4-triazole (13-1-2), and the reaction was carried out in the same manner to obtain 1H-1,2,4-triazole-1-carboxylic acid 4-nitrophenyl ester (D-8) having the following structure (6.13 g, yield: 87.7%).

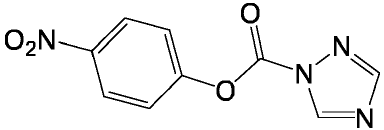

### (D-8) 1H-1,2,4-triazole-1-carboxylic acid 4-nitrophenyl ester

### Synthesis Example 13: Synthesis of 1H-Benzimidazole-1-Carboxylic Acid 4-Nitrophenyl Ester (D-9)

The imidazole (13-1-1) in Synthesis Example 11 was changed to 3.54 g of benzimidazole (13-1-3), and the reaction was carried out in the same manner but the condensation under reduced pressure was limited to Synthesis Example 11, thereby obtaining 1H-benzimidazole-1-carboxylic acid 4-nitrophenyl ester (D-9) having the following structure (6.70 g, yield: 78.6%) .

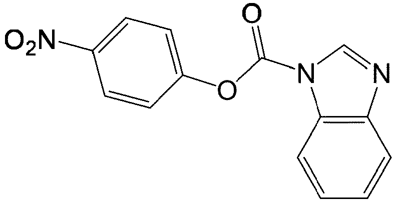

### (D-9) 1H-benzimidazole-1-carboxylic acid 4-nitrophenyl ester

### Synthesis Example 14: Synthesis of 1H-Imidazole-1-Carboxylic Acid Pentafluorophenyl Ester (D-10)

The di(N-succinimidyl)carbonate (2-5-1) in Synthesis Example 5 was changed to 11.82 g of bis(pentafluorophenyl)carbonate (3-5-1), and the reaction was carried out in the same manner to obtain 1H-imidazole-1-carboxylic acid pentafluorophenyl ester (D-10) having the following structure (3.95 g, yield: 56.4%).

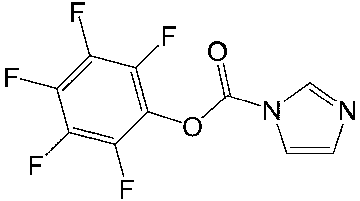

### (D-10) 1H-imidazole-1-carboxylic acid pentafluorophenyl ester

### Synthesis Example 15: Synthesis of 1H-1,2,4-Triazole-1-Carboxylic Acid Pentafluorophenyl Ester (D-11)

The imidazole (13-1-1) in Synthesis Example 14 was changed to 2.07 g of 1,2,4-triazole (13-1-2), and the reaction was carried out in the same manner to obtain 1H-1,2,4-triazole-1-carboxylic acid pentafluorophenyl ester (D-11) having the following structure (4.64 g, yield: 55.4%).

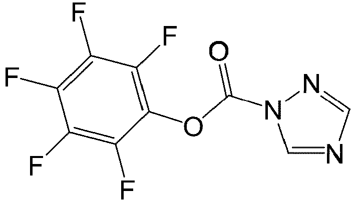

### (D-11) 1H-1,2,4-triazole-1-carboxylic acid pentafluorophenyl ester

### Synthesis Example 16: Synthesis of 1H-Benzimidazole-1-Carboxylic Acid Pentafluorophenyl Ester (D-12)

The imidazole (13-1-1) in Synthesis Example 14 was changed to 3.54 g of benzimidazole (13-1-3), and the reaction was carried out in the same manner to obtain 1H-benzimidazole-1-carboxylic acid pentafluorophenyl ester (D-12) having the following structure (5.15 g, yield: 52.3%).

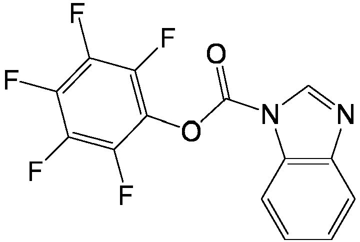

### (D-12) 1H-benzimidazole-1-carboxylic acid pentafluorophenyl ester

### Synthesis Example 17: Synthesis of 1H-Imidazole-1-Carboxylic Acid 1H-Benzotriazole-1-Ylester (D-13)

The N-hydroxyphthalimide (2-6-1) in Synthesis Example 8 was changed to 4.05 g of 1-hydroxy-benzotriazole (4-6-1), and the reaction was carried out in the same manner to obtain 1H-imidazole-1-carboxylic acid 1H-benzotriazole-1-ylester (D-13) having the following structure (3.44 g, yield: 50.0%).

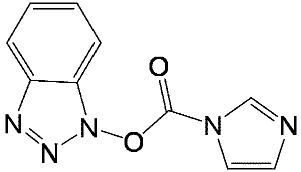

### (D-13) 1H-imidazole-1-carboxylic acid 1H-benzotriazole-1-ylester

### Synthesis Example 18: Synthesis of 1H-1,2,4-Triazole-1-Carboxylic Acid 1H-Benzotriazole-1-Ylester (D-14)

The 1,1'-carbonyldiimidazole (13-2-1) in Synthesis Example 17 was changed to 4.92 g of 1,1'-carbonyldi(1,2,4-triazole) (13-2-2), and the reaction was carried out in the same manner to obtain 1H-1,2,4-triazole-1-carboxylic acid 1H-benzotriazole-1-ylester (D-14) having the following structure (3.37 g, yield: 48.8%) .

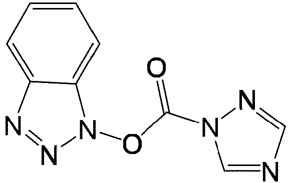

### (D-14) 1H-1,2,4-triazole-1-carboxylic acid 1H-benzotriazole-1-ylester

### Synthesis Example 19: Synthesis of 1H-Benzimidazole-1-Carboxylic Acid 1H-Benzotriazole-1-Ylester (D-15)

The 1,1'-carbonyldiimidazole (13-2-1) in Synthesis Example 17 was changed to 7.87 g of 1,1'-carbonyldibenzimidazole (13-2-3), and the reaction was carried out in the same manner to obtain 1H-benzimidazole-1-carboxylic acid 1H-benzotriazole-1-ylester (D-15) having the following structure (3.95 g, yield: 47.1%).

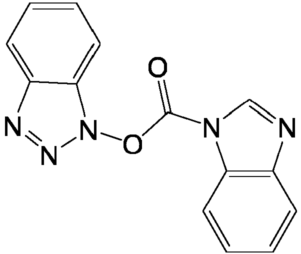

### (D-15) 1H-benzimidazole-1-carboxylic acid 1H-benzotriazole-1-ylester

### Synthesis Example 20: Synthesis of 1H-Imidazole-1-Carboxylic Acid 1H-6-(Trifluoromethyl)Benzotriazole-1-Ylester (D-16)

The 1-hydroxy-benzotriazole (4-6-1) in Synthesis Example 17 was changed to 6.09 g of 1-hydroxy-6-(trifluoromethyl)benzotriazole (4-6-2), and the reaction was carried out in the same manner to obtain 1H-imidazole-1-carboxylic acid 1H-6-(trifluoromethyl)benzotriazole-1-ylester (D-16) having the following structure (4.09 g, yield: 45.9%).

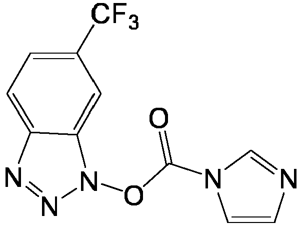

### (D-16) 1H-imidazole-1-carboxylic acid 1H-6-(trifluoromethyl)benzotriazole-1-ylester

### Synthesis Example 21: Synthesis of 1H-1,2,4-Triazole-1-Carboxylic Acid 1H-6-(Trifluoromethyl)Benzotriazole-1-Ylester (D-17)

The 1,1'-carbonyldiimidazole (13-2-1) in Synthesis Example 20 was changed to 4.92 g of 1,1'-carbonyldibenzimidazole (13-2-3), and the reaction was carried out in the same manner to obtain 1H-1,2,4-triazole-1-carboxylic acid 1H-6-(trifluoromethyl)benzotriazole-1-ylester (D-17) having the following structure (3.78 g, yield: 42.3%).

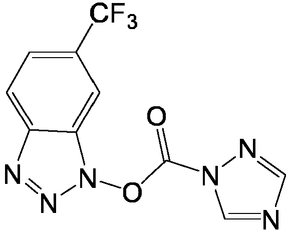

### (D-17) 1H-1,2,4-triazole-1-carboxylic acid 1H-6-(trifluoromethyl)benzotriazole-1-ylester

### Synthesis Example 22: Synthesis of 1H-Benzimidazole-1-Carboxylic Acid 1H-6-(Trifluoromethyl)Benzotriazole-1-Ylester (D-18)

The 1,1'-carbonyldiimidazole (13-2-1) in Synthesis Example 21 was changed to 7.87 g of 1,1'-carbonyldibenzimidazole (13-2-3), and the reaction was carried out in the same manner to obtain 1H-benzimidazole-1-carboxylic acid 1H-6-(trifluoromethyl)benzotriazole-1-ylester (D-18) having the following structure (4.18 g, yield: 40.1%).

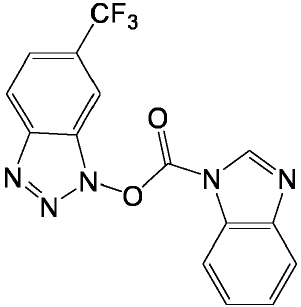

### (D-18) 1H-benzimidazole-1-carboxylic acid 1H-6-(trifluoromethyl)benzotriazole-1-ylester

### Comparative Synthesis Example 1: Synthesis of N-(Tert-Butoxycarbonyl)-2,6-Dimethylpiperidine (D-19)

In a 300-ml flask equipped with a reflux condenser, a stirrer, and a thermometer, 62 mg (0.51 mmol) of 4-(N,N-dimethylamino)pyridine and 6.55 g (30.0 mmol) of di-tert-butyl dicarbonate were stirred at 25°C under nitrogen. The resultant was added to 2.83 g (25.0 mmol) of 2,6-dimethylpiperidine in 100 mL of acetonitrile solution. Then, the solution was stirred at 25°C for 12 hours. After completion of the reaction, the reaction liquid was charged into 200 mL of cold water, and the organic layer was extracted by using 30 mL of ethyl acetate three times. The organic layer was further washed three times with 50 mL of cold water, dried over magnesium sulfate, then concentrated under reduced pressure, and crystallized by using petroleum ether to obtain an oil form of N-(tert-butoxycarbonyl)-2,6-dimethylpiperidine (D-19) having the following structure (4.95 g, yield: 80.1%).

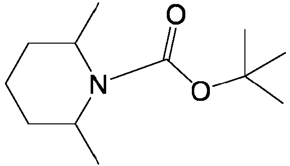

### (D-19) N-(tert-butoxycarbonyl)-2,6-dimethylpiperidine

### Comparative Synthesis Example 2: Synthesis of N-(Benzyloxycarbonyl)-2,6-Dimethylpiperidine (D-20)

In a 300-ml flask equipped with a reflux condenser, a stirrer, and a thermometer, 4.26 g (25.0 mmol) of benzyl chloroformate was added dropwise at 0°C to a mixture solution of 51 mg (0.51 mmol) of triethylamine, 2.83 g (25.0 mmol) of 2,6-dimethylpiperidine, and 70 g of tetrahydrofuran, followed by stirring at 50°C for 20 hours. After completion of the reaction, the reaction liquid was charged into 200 mL of cold water, and the organic layer was extracted by using 30 mL of ethyl acetate three times. The organic layer was further washed three times with 50 mL of cold water, dried over magnesium sulfate, then concentrated under reduced pressure, and crystallized by using petroleum ether to obtain N-(benzyloxycarbonyl)-2,6-dimethylpiperidine (D-20) having the following structure (1.87 g, yield: 30.2%).

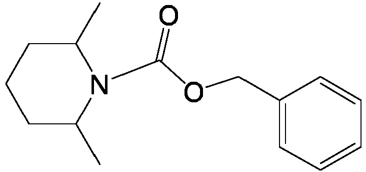

### (D-20) N-(benzyloxycarbonyl)-2,6-dimethylpiperidine

### Comparative Synthesis Example 3: Synthesis of N-(4-Nitrophenyloxycarbonyl)-2,6-Dimethylpiperidine (D-21)

The imidazole (13-1-1) in Synthesis Example 11 was changed to 3.40 g of 2,6-dimethylpiperidine, and the reaction was carried out in the same manner to obtain N-(4-nitrophenyloxycarbonyl)-2,6-dimethylpiperidine (D-21) having the following structure (5.74 g, yield: 80.2%).

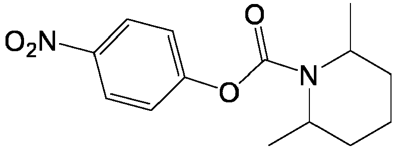

### (D-21) N-(4-nitrophenyloxycarbonyl)-2,6-dimethylpiperidine

### III. Imide Ring Closure Temperature

The polymer compound (A-1) synthesized as described above (100 parts by weight), the nitrogen-containing compounds (D-1)-(D-18) obtained as described above and shown in Table 1 respectively as (Example 1) to (Example 18) (5 parts by weight), and a photoinitiator (C-1): N-1919 manufactured by ADEKA Corporation (4.0 parts by weight) were dissolved in γ-butyrolactone (hereinafter, GBL) as a solvent. Thereafter, fine filtration was performed using a 1.0 µm Teflon (registered trademark) filter to prepare a negative photosensitive resin composition. Additionally, a composition was prepared as Comparative Example 1 without adding the nitrogen-containing compound.

Next, 5 mL of the obtained composition solution was dispensed onto a silicon substrate and the substrate was then rotated, in other words, the composition solution was applied by a spin coat method. Subsequently, prebaking was performed on a hot plate at 100°C for 3 minutes. The number of rotations during the application was adjusted such that the finished film thickness after the prebaking was 0.9 µm to 1.2 µm.

The entire face of the composition film applied onto the silicon substrate was exposed to i-line at an exposure dose of 600 mJ using an i-line stepper NSR-2205i11 manufactured by Nikon Corporation.

The cured film thus obtained was heated from 100°C to 250°C in 10°C increments for 1 hour. Subsequently, absorption intensity at each temperature in infrared spectroscopy was measured using FT-IR below. Additionally, the obtained cured film was heated at 300°C for 1 hour, and then absorption intensity was measured in the same manner.

### FT-IR Nicolet iN10 MX (ThermoFisher Scientific Inc.)

In the composition film, when the polymer compound of the polyimide precursor undergoes ring closure reaction toward polyimide, a C-N bond is newly formed. Hence, in IR spectrum, absorption intensity at 1379 cm⁻¹ originating from C-N stretching motion increases. On the other hand, a C-C double bond of a benzene ring does not change even after imidization, and thus, in IR spectrum, absorption intensity at 1552 cm⁻¹ originating from C-C stretching motion of the benzene ring does not change. This absorption intensity at 1552 cm⁻¹ of the C-C stretching motion of the benzene ring is used as internal standard, and absorption intensity at 1379 cm⁻¹ originating from C-N stretching motion can be indicated as the progress of ring closure reaction toward imide at each temperature, i.e. a degree of imidization, according to the following expression (30). Then, the progress of imidization at respective temperatures can be compared relatively with one another. $\begin{matrix}degree of \\ imidization\end{matrix} = \frac{\begin{matrix}absorption intensity at 1379 {cm}^{- 1} originating from \\ C - N stretching vibration\end{matrix}}{\begin{matrix}absorption intensity at 1552 {cm}^{- 1} originating from \\ C - C stretching motion of the benzene ring\end{matrix}}$

The degree of imidization of the cured film after heating at 300°C for 1 hour as determined by the above expression (30) can be considered as indicating that the ring closure reaction toward polyimide of the polymer compound of the polyimide precursor has progressed to completion. When the degree of imidization of the cured film determined by assigning different temperatures is equal to this degree of imidization of the cured film at 300°C, the temperature can be regarded as a temperature at which the imide ring closure reaction of the polyimide precursor in the composition film can proceed to completion.

In the cured film of the photosensitive resin composition, where the nitrogen-containing compounds (D-1) to (D-18) were respectively added to (Example 1) to (Example 18) described in Table 1, the lowest temperature at which the degree of imidization equaled to that of the cured film after heating at 300°C for 1 hour is indicated as an imide ring closure temperature of the composition film.

**[Table 1]**

| | Nitrogen-containing organic compound | Imide ring closure temperature |
|---|---|---|
| Example 1 | D-1 | 170°C |
| Example 2 | D-2 | 170°C |
| Example 3 | D-3 | 180°C |
| Example 4 | D-4 | 180°C |
| Example 5 | D-5 | 180°C |
| Example 6 | D-6 | 180°C |
| Example 7 | D-7 | 170°C |
| Example 8 | D-8 | 170°C |
| Example 9 | D-9 | 180°C |
| Example 10 | D-10 | 180°C |
| Example 11 | D-11 | 180°C |
| Example 12 | D-12 | 190°C |
| Example 13 | D-13 | 180°C |
| Example 14 | D-14 | 180°C |
| Example 15 | D-15 | 180°C |
| Example 16 | D-16 | 180°C |
| Example 17 | D-17 | 180°C |
| Example 18 | D-18 | 180°C |
| Comparative Example 1 | Nitrogen-containing compound not added | 230°C |

As shown in Table 1 above, in Examples each containing the nitrogen-containing organic compound of the present invention, it is possible to facilitate the imidization reaction of the polymer compound having the polyimide precursor structure, and perform the imide ring closure reaction at a low temperature, i.e. 200°C or lower.

### IV. Preparation of Photosensitive Resin Composition

The polymer compound containing the polyimide precursor obtained in the above Synthesis Examples 3 to 4 was used as a base resin to prepare a resin composition containing 35 mass% of resin, in which the nitrogen-containing compound of the present invention prepared as described above was used according to the composition and blending amount described in Tables 2 to **4.** Thereafter, stirring, mixing, and dissolving were performed, followed by fine filtration using a 1.0 µm Teflon (registered trademark) filter, thereby obtaining a photosensitive resin composition. The solvent GBL in Tables indicates γ-butyrolactone.

**[Table 2]**

| | Ex. 19 | Ex .20 | Ex. 21 | Ex. 22 | Ex. 23 | Ex. 24 | Ex. 25 | Ex. 26 | Ex. 27 | Ex. 28 |
|---|---|---|---|---|---|---|---|---|---|---|
| | Photosensitive resin composition | | | | | | | | | |
| | 1 | 2 | 3 | 4 | 5 | 6 | 7 | 8 | 9 | 10 |
| Polymer compound | A-1 100 pts. wt. | A-1 100 pts. wt. | A-1 100 pts. wt. | A-1 100 pts. wt. | A-1 100 pts. wt. | A-1 100 pts. wt. | A-1 100 pts. wt. | A-1 100 pts. wt. | A-1 100 pts. wt. | A-1 100 pts. wt. |
| Nitrogen-containing organic compound | D-1 5 pts. wt. | D-2 5 pts. wt. | D-3 5 pts. wt. | D-4 5 pts. wt. | D-5 5 pts. wt. | D-6 5 pts. wt. | D-7 5 pts. wt. | D-8 5 pts. wt. | D-9 5 pts. wt. | D-10 5 pts. wt. |
| Photo-initiator (C-1) | 4 pts. wt. | 4 pts. wt. | 4 pts. wt. | 4 pts. wt. | 4 pts. wt. | 4 pts. wt. | 4 pts. wt. | 4 pts. wt. | 4 pts. wt. | 4 pts. wt. |
| Polymer-izable compound (B-1) | 10 pts. wt. | 10 pts. wt. | 10 pts. wt. | 10 pts. wt. | 10 pts. wt. | 10 pts. wt. | 10 pts. wt. | 10 pts. wt. | 10 pts. wt. | 10 pts. wt. |
| Thermal crosslinking agent | Not added | Not added | Not added | Not added | Not added | Not added | Not added | Not added | Not added | Not added |
| Antioxidant (G-1) | 1 pt. wt. | 1 pt. wt. | 1 pt. wt. | 1 pt. wt. | 1 pt. wt. | 1 pt. wt. | 1 pt. wt. | 1 pt. wt. | 1 pt. wt. | 1 pt. wt. |
| Silane compound (H-1) | 0.5 pts. wt. | 0.5 pts. wt. | 0.5 pts. wt. | 0.5 pts. wt. | 0.5 pts. wt. | 0.5 pts. wt. | 0.5 pts. wt. | 0.5 pts. wt. | 0.5 pts. wt. | 0.5 pts. wt. |
| Polymerization inhibitor (I-1) | 0.5 pts. wt. | 0.5 pts. wt. | 0.5 pts. wt. | 0.5 pts. wt. | 0.5 pts. wt. | 0.5 pts. wt. | 0.5 pts. wt. | 0.5 pts. wt. | 0.5 pts. wt. | 0.5 pts. wt. |
| Solvent GBL | 180 pts. wt. | 180 pts. wt. | 180 pts. wt. | 180 pts. wt. | 180 pts. wt. | 180 pts. wt. | 180 pts. wt. | 180 pts. wt. | 180 pts. wt. | 180 pts. wt. |
| Hole pattern shape | Good | Good | Good | Good | Good | Good | Good | Good | Good | Good |
| Minimum hole diameter | 5 µm | 5 µm | 5 µm | 5 µm | 5 µm | 5 µm | 5 µm | 5 µm | 5 µm | 5 µm |
| Sensi-tivity | 400 mJ | 400 mJ | 400 mJ | 400 mJ | 400 mJ | 400 mJ | 400 mJ | 400 mJ | 400 mJ | 400 mJ |
| Storage stability | Very good | Very good | Very good | Very good | Very good | Very good | Very good | Very good | Very good | Very good |
| Chemical resistance | Very good | Very good | Very good | Very good | Very good | Very good | Very good | Very good | Very good | Very good |

**[Table 3]**

| | Ex.29 | Ex.30 | Ex.31 | Ex.32 | Ex.33 | Ex.34 | Ex.35 | Ex.36 |
|---|---|---|---|---|---|---|---|---|
| | Photosensitive resin composition | | | | | | | |
| | 11 | 12 | 13 | 14 | 15 | 16 | 17 | 18 |
| Polymer compound | A-1 100 pts. wt. | A-1 100 pts. wt. | A-1 100 pts. wt. | A-1 100 pts. wt. | A-1 100 pts. wt. | A-1 100 pts. wt. | A-1 100 pts. wt. | A-1 100 pts. wt. |
| Nitrogen-containing organic compound | D-11 5 pts. wt. | D-12 5 pts. wt. | D-13 5 pts. wt. | D-14 5 pts. wt. | D-15 5 pts. wt. | D-16 5 pts. wt. | D-17 5 pts. wt. | D-18 5 pts. wt. |
| Photo-initiator (C-1) | 4 pts. wt. | 4 pts. wt. | 4 pts. wt. | 4 pts. wt. | 4 pts. wt. | 4 pts. wt. | 4 pts. wt. | 4 pts. wt. |
| Polymer-izable compound (B-1) | 10 pts. wt. | 10 pts. wt. | 10 pts. wt. | 10 pts. wt. | 10 pts. wt. | 10 pts. wt. | 10 pts. wt. | 10 pts. wt. |
| Thermal crosslinking agent | Not added | Not added | Not added | Not added | Not added | Not added | Not added | Not added |
| Antioxidant (G-1) | 1 pt.wt. | 1 pt.wt. | 1 pt.wt. | 1 pt.wt. | 1 pt.wt. | 1 pt.wt. | 1 pt.wt. | 1 pt.wt. |
| Silane compound (H-1) | 0.5 pts. wt. | 0.5 pts. wt. | 0.5 pts. wt. | 0.5 pts. wt. | 0.5 pts. wt. | 0.5 pts. wt. | 0.5 pts. wt. | 0.5 pts. wt. |
| Polymerization inhibitor (1-1) | 0.5 pts. wt. | 0.5 pts. wt. | 0.5 pts. wt. | 0.5 pts. wt. | 0.5 pts. wt. | 0.5 pts. wt. | 0.5 pts. wt. | 0.5 pts. wt. |
| Solvent GBL | 180 pts. wt. | 180 pts. wt. | 180 pts. wt. | 180 pts. wt. | 180 pts. wt. | 180 pts. wt. | 180 pts. wt. | 180 pts. wt. |
| Hole pattern shape | Good | Good | Good | Good | Good | Good | Good | Good |
| Minimum hole diameter | 5 µm | 5 µm | 5 µm | 5 µm | 5 µm | 5 µm | 5 µm | 5 µm |
| Sensitivity | 420 mJ | 400 mJ | 420 mJ | 420 mJ | 420 mJ | 420 mJ | 420 mJ | 420 mJ |
| Storage stability | Very good | Very good | Very good | Very good | Very good | Very good | Very good | Very good |
| Chemical resistance | Very good | Very good | Very good | Very good | Very good | Very good | Very good | Very good |

**[Table 4]**

| | Ex. 37 | Ex. 38 | Ex. 39 | Ex. 40 | Ex. 41 | Comp. Ex.2 | Comp. Ex.3 | Comp. Ex.4 | Comp. Ex.5 | Comp. Ex.6 |
|---|---|---|---|---|---|---|---|---|---|---|
| | Photosensitive resin composition | | | | | | | | | |
| | 19 | 20 | 21 | 22 | 23 | 24 | 25 | 26 | 27 | 28 |
| Polymer compound | A-1 100 pts.wt. | A-1 100 pts.wt. | A-2 100 pts.wt. | A-1 100 ts.wt. | A-2 100 pts.wt. | A-1 100 pts. wt. | A-1 100 pts. wt. | A-1 100 pts. wt. | A-1 100 pts. wt. | A-1 100 pts. wt. |
| Nitrogen-containing organic compound | D-1 5 pts. wt. | D-1 5 pts. wt. | D-1 5 pts. wt. | D-1 5 pts. wt. | D-1 5 pts. wt. | D-19 5 pts. wt. | D-20 5 pts. wt. | D-21 5 pts. wt. | D-13-1 5 pts. wt. | Not added |
| Photo-initiator (C-1) | 4 pts. wt. | 4 pts. wt. | 4 pts. wt. | 4 pts. wt. | 4 pts. wt. | 4 pts. wt. | 4 pts. wt. | 4 pts. wt. | 4 pts. wt. | 4 pts. wt. |
| Polymer izable compound (B-1) | 10 pts. wt. | 10 pts. wt. | 10 pts. wt. | 10 pts. wt. | 10 pts. wt. | 10 pts. wt. | 10 pts. wt. | 10 pts. wt. | 10 pts. wt. | 10 pts. wt. |
| Thermal crosslinking agent | F-1 5 pts.wt. | F-2 10 pts.wt. | Not added | F-2 10 pts.wt. | Not added | Not added | Not added | Not added | Not added | Not added |
| Antioxidant (G-1) | 1 pt. wt. | 1 pt. wt. | 1 pt. wt. | 1 pt. wt. | 1 pt. wt. | 1 pt. wt. | 1 pt. wt. | 1 pt. wt. | 1 pt. wt. | 1 pt. wt. |
| Silane compound (H-1) | 0.5 pts.wt. | 0.5 pts.wt. | 0.5 pts.wt. | 0.5 pts.wt. | 0.5 pts.wt. | 0.5 pts. wt. | 0.5 pts. wt. | 0.5 pts. wt. | 0.5 pts. wt. | 0.5 pts. wt. |
| Polymer-ization inhibitor (I-1) | 0.5 pts.wt. | 0.5 pts.wt. | 0.5 pts.wt. | 0.5 pts.wt. | 0.5 pts.wt. | 0.5 pts. wt. | 0.5 pts. wt. | 0.5 pts. wt. | 0.5 pts. wt. | 0.5 pts. wt. |
| Solvent GBL | 180 pts.wt. | 180 pts.wt. | 180 pts.wt. | 180 pts.wt. | 180 pts.wt. | 180 pts. wt. | 180 pts. wt. | 180 pts. wt. | 180 pts. wt. | 180 pts. wt. |
| Hole pattern shape | Good | Good | Good | Good | Good | Good | Good | Good | Good | Good |
| Minimum hole diameter | 5 µm | 5 µm | 5 µm | 5 µm | 5 µm | 5 µm | 5 µm | 5 µm | 5 µm | 6 µm |
| Sensitivity | 400 mJ | 400 mJ | 400 mJ | 400 mJ | 400 mJ | 400 mJ | 400 mJ | 400 mJ | 400 mJ | 400 mJ |
| Storage stability | Very good | Very good | Very good | Very good | Very good | Good | Good | Good | Good | Good |
| Chemical resistance | Very good | Very good | Very good | Very good | Very good | Very good | Very good | Very good | Very good | Poor |

The photosensitive resin compositions 1 to 23 (Examples 19 to 41) shown in Tables 2 to 4 relate to the negative photosensitive resin composition of the present invention as described above.

In Tables 2 to 4, the comparative photosensitive resin compositions 24 to 27 (Comparative Examples 2 to 5) relate to the negative photosensitive resin composition obtained by adding a nitrogen-containing organic compound other than the nitrogen-containing organic compound for use in the above-described negative photosensitive resin composition of the present invention, for example, the nitrogen-containing organic compounds obtained in the above-described Comparative Synthesis Examples 1, 2, and 3. Furthermore, as the nitrogen-containing compound other than the nitrogen-containing organic compound of the present invention, imidazole (D-13-1) was used in the example.

The comparative photosensitive resin composition 28 (Comparative Example 6) is a composition to which the nitrogen-containing organic compound for use in the above-described negative photosensitive resin composition of the present invention was not added.

Note that in Tables 2 to 4, details of the polymerizable compound having two or more ethylenically unsaturated groups (B-1), photoradical generator (C-1), thermal crosslinking agents (F-1) and (F-2), antioxidant (G-1), silane compound (H-1), and polymerization inhibitor (I-1) are as follows. Furthermore, "parts by weight" and "parts by mass" are used interchangeably.

### Photoinitiator (C-1): N-1919 manufactured by ADEKA Corporation

Polymerizable compound having two or more ethylenically unsaturated groups (B-1): tetraethylene glycol dimethacrylate

### Thermal crosslinking agent (F-1):

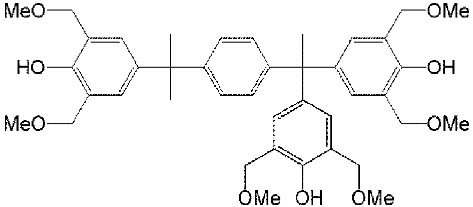

### Thermal crosslinking agent (F-2):

Epoxy resin: EP4000L manufactured by ADEKA Corporation

### Antioxidant (G-1):

Hindered phenol antioxidant: Sumilizer GA-80 manufactured by Sumitomo Chemical Co., Ltd.

### Silane compound (H-1):

Amino silane coupling agent: KBM-573 manufactured by Shin-Etsu Chemical Co., Ltd.

### Polymerization inhibitor (I-1):

2-nitroso-1-naphthol (Reagent: Tokyo Chemical Industry Co., Ltd.)

### V. Pattern Formation

5 mL of each of the above-described photosensitive resin compositions 1 to 23 and comparative photosensitive resin compositions 24 to 27 was dispensed onto a silicon substrate, and the substrate was then rotated, in other words, the composition was applied by a spin coat method such that a film thickness was 5 µm after heating in post curing following pattern formation. In other words, the decrease in the film thickness after the post curing process was considered in advance, and the number of rotations during the application was adjusted.

Next, prebaking was performed on a hot plate at 100°C for 3 minutes. Thereafter, i-line exposure and pattern formation were performed using an i-line stepper NSR-2205i11 manufactured by Nikon Corporation. In the pattern formation, a mask for a negative pattern was appropriately used according to the used photosensitive resin composition. The mask had a pattern enabling to form 20 µm holes arranged with an aspect ratio of 1:1, whereby capable of forming a hole pattern of 50 µm to 20 µm in 10 µm increments, 20 µm to 10 µm in 5 µm increments, and 10 µm to 1 µm in 1 µm increment.

In a development process, cyclopentanone was used as a developer. Organic solvent development was performed by one-time spray development with each organic solvent for 1 minute, followed by rinsing with isopropyl alcohol.

Next, the obtained pattern on the substrate was post-cured by using an oven at 200°C for 2 hours while performing nitrogen purging.

Then, each substrate was cut out such that the shape of the obtained hole pattern could be observed. The shape of the hole pattern was observed by using a scanning electron microscope (SEM). The diameter of the smallest opening hole with the film thickness of 5 µm after the post curing was determined, and the shape of the pattern was evaluated. Together with the results thereof, sensitivity at which the smallest pattern could be formed is shown in Tables 2 to 4.

Note that the shape of the hole pattern was evaluated based on the following criteria, and the evaluation results are also shown in Tables 2 to 4.

Good: hole in a rectangular or forward tapered shape (shape with the larger dimension at the upper part than the bottom part of the hole) was observed.

Poor: a reverse tapered shape (shape with the smaller dimension at the upper part than the bottom part of the hole) or an overhang shape (shape with the upper part of the hole overhanging), significant film thinning, or residue at the bottom part of the hole was observed.

### VI. Storage Stability

In the above pattern formation, 5 mL of the described photosensitive resin composition was dispensed onto a silicon substrate, and the substrate was then rotated to apply the photosensitive resin composition in the same manner. Next, prebaking was performed on a hot plate at 100°C for 3 minutes. A film thickness after the prebaking was recorded, and the solution of the photosensitive resin composition was stored at room temperature for 3 weeks.

After three weeks, a film was formed under the same conditions at the same rotation number, and a film thickness was measured. The film thickness before and after the storage was compared with each other, and storage stability was evaluated as follows.

A change rate of film thickness was calculated according to the following expression. 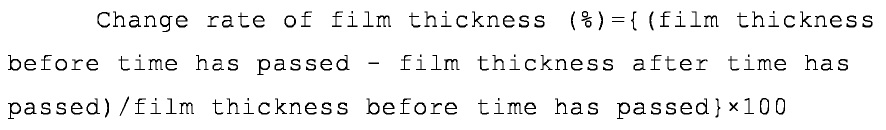 Change rate of film thickness (%)={ (film thickness before time has passed - film thickness after time has passed)/film thickness before time has passed}×100

The calculated change rate of film thickness was evaluated based on the following evaluation criteria.

Very good: composition with 10% or less change in the film thickness before and after the storage.

Good: composition with 10% to 15% change in the film thickness before and after the storage.

Poor: composition with 15% or more change in the film thickness before and after the storage.

The evaluation results are together shown in Tables 2 to 4. It can be deemed that the smaller the change rate of the film thickness, the better the storage stability of the curable resin composition.

### VII. Chemical Resistance

In the above pattern formation, 5 mL of the described photosensitive resin composition was dispensed onto a silicon substrate, followed by rotation of the substrate to apply the photosensitive resin composition in the same manner. Next, prebaking was performed on a hot plate at 100°C for 3 minutes. Then, the entire face was exposed to i-line with no pattern formation at an exposure dose of 600 mJ using an i-line stepper NSR-2205i11 manufactured by Nikon Corporation.

Subsequently, the obtained film on the substrate was post-cured by using an oven at 200°C for 2 hours while performing nitrogen purging.

The cured film thus obtained was immersed in a chemical described below, under the following condition, and a dissolution rate was calculated.
Chemical: 90:10 (mass ratio) mixture of dimethyl sulfoxide (DMSO) and 25 mass% tetramethyl ammonium hydroxide (TMAH) aqueous solution
Evaluation condition: the resin layer was immersed in the above chemical at 75°C for 15 minutes, the film thickness before and after the immersion was compared with each other, and the amount of change of the cured film was measured. Evaluation was performed based on the following evaluation criteria, and the evaluation results are together shown in Tables 2 to 4. It can be deemed that the composition with the smaller amount of change of the film thickness resulted in more excellent chemical resistance of the obtained cured film (resin layer) .

Very good: amount of change of the film thickness was less than 3.0 µm.

Good: amount of change of the film thickness was 3.0 µm or more and less than 5.0 µm.

Poor: amount of change of the film thickness was 5.0 µm or more.

As indicated by the results in Tables 2 to 4, it can be seen that the negative sensitive resin composition containing the nitrogen-containing organic compound of the present invention was excellent in development performance. Moreover, excellent storage stability and chemical resistance were also confirmed.

On the other hand, when the negative photosensitive resin composition containing the compound other than the nitrogen-containing organic compound of the present invention was used, somewhat inferior storage stability was confirmed (comparative photosensitive resin compositions 24 to 27 (Comparative Examples 2 to 5)).

The comparative photosensitive resin composition 28 (Comparative Example 6) was prepared without adding the nitrogen-containing organic compound for use in the negative photosensitive resin composition of the present invention. The cured film of this composition resulted in poorer chemical resistance as compared with the composition containing the nitrogen-containing organic compound of the present invention. This demonstrates that, as described above, the composition not containing the nitrogen-containing organic compound of the present invention had a high imide ring closure temperature of 230°C and could not achieve complete imidization under the conditions of the present evaluation, i.e. in an oven at 200°C for 2 hours, so that the advantage of polyimide, namely the chemical resistance, could not be exhibited.

## Claims

1. A negative photosensitive resin composition comprising:
(A) a polymer compound having a polyimide precursor structure;
(C) a photoinitiator;
(D) a nitrogen-containing organic compound represented by the following general formula (1); and
(E) a solvent, 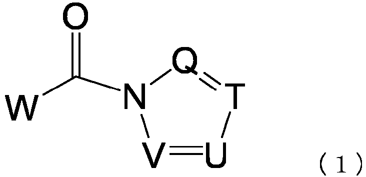
wherein Q represents a nitrogen atom or a carbon atom having a R^{q} group; T represents a nitrogen atom or a carbon atom having a R^{t} group; U represents a nitrogen atom or a carbon atom having a R^{u} group; V represents a nitrogen atom or a carbon atom having a R^{v} group; the R^{q}, R^{t}, R^{u}, and R^{v} groups each represents a hydrogen atom, a linear, branched, or cyclic alkyl group having 1 to 15 carbon atoms, an aryl group having 6 to 15 carbon atoms, a halogen atom, or a nitro group, and the R^{q} group and the R^{t} group, the R^{t} group and the R^{u} group, or the R^{u} group and the R^{v} group optionally bond together to form a ring with a carbon atom attached thereto; and W represents any structure of the following general formulae (2) to (4), 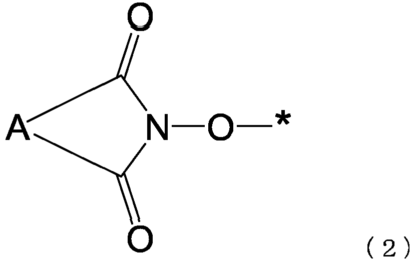
wherein A represents a divalent organic group; and * represents a bond, 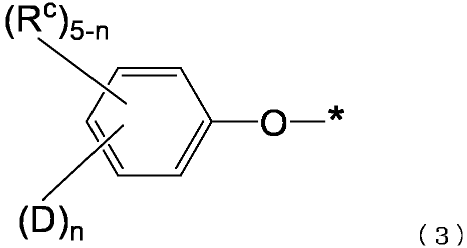
wherein D represents a halogen atom or a nitro group; R^{C} represents a hydrogen atom, a linear, branched, or cyclic alkyl group having 1 to 15 carbon atoms, or an aryl group having 6 to 15 carbon atoms; "n" represents an integer of 3 to 5 when D represents a halogen atom, and represents 1 when D represents a nitro group; and * represents a bond, 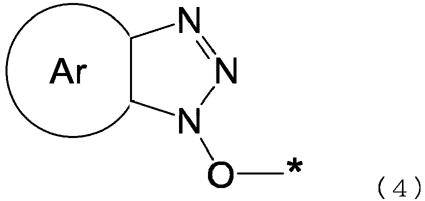
wherein Ar represents a substituted or unsubstituted aromatic ring structure, or a heterocyclic structure having a heteroatom; and * represents a bond.

2. The negative photosensitive resin composition according to claim 1, wherein the component (A) is a polymer compound having a polyimide precursor structure represented by the following general formula (5), 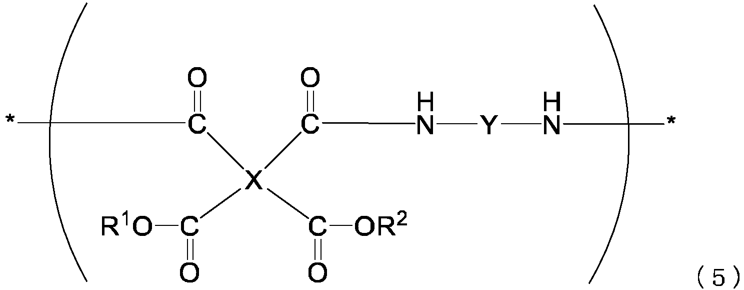
wherein X represents a tetravalent organic group; Y represents a divalent organic group; each of R¹ and R² independently represents a hydrogen atom or a monovalent organic group, and at least one of R¹ and R² represents a group represented by the following general formula (6), 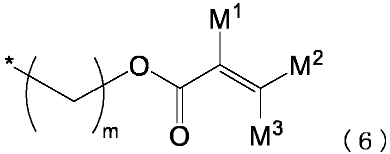
wherein each of M¹, M², and M³ independently represents a hydrogen atom or an organic group having 1 to 3 carbon atoms; "m" represents an integer of 2 to 10;
and * represents a bond.

3. The negative photosensitive resin composition according to claim 1 or 2, comprising (B) a polymerizable compound having two or more ethylenically unsaturated groups.

4. The negative photosensitive resin composition according to any one of claims 1 to 3, wherein W in the general formula (1) of the component (D) is an organic group represented by the following general formula (2-1), 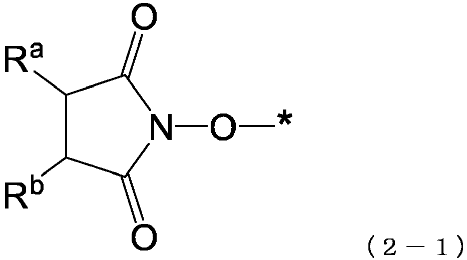 wherein a R^{a} group and a R^{b} group represent a hydrogen atom, a linear, branched, or cyclic alkyl group having 1 to 15 carbon atoms, or an aryl group having 6 to 15 carbon atoms, or the R^{a} group and the R^{b} group optionally bond together to form a ring with a carbon atom attached thereto; and * represents a bond.

5. The negative photosensitive resin composition according to any one of claims 1 to 3, wherein W in the general formula (1) of the component (D) is an organic group represented by the following (3-1) or (3-2), 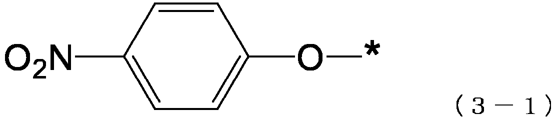
wherein * represents a bond, 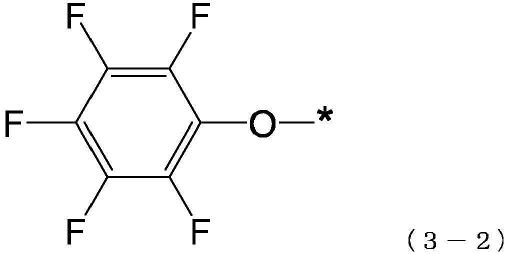
wherein * represents a bond.

6. The negative photosensitive resin composition according to any one of claims 1 to 3, wherein W in the general formula (1) of the component (D) is an organic group represented by the following general formula (4-1), 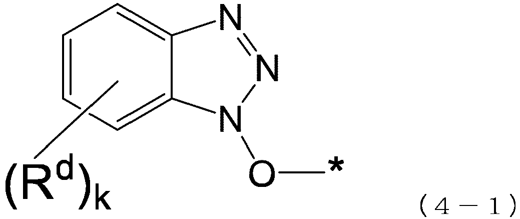 wherein a R^{d} group represents a linear, branched, or cyclic alkyl group having 1 to 15 carbon atoms and optionally having a halogen atom, or an aryl group having 6 to 15 carbon atoms; "k" represents an integer of 0 to 4; and * represents a bond.

7. The negative photosensitive resin composition according to any one of claims 1 to 6, wherein the component (D) is contained in an amount of 1 to 10 parts by mass relative to 100 parts by mass of the component (A).

8. The negative photosensitive resin composition according to any one of claims 1 to 7, comprising, as (F) a thermal crosslinking agent, one kind or two or more kinds of crosslinking agents selected from an amino condensate modified with formaldehyde or formaldehyde-alcohol, a phenol compound having two or more methylol groups or alkoxymethylol groups on average in one molecule, a compound in which a hydrogen atom of a hydroxyl group of polyhydric phenol is substituted with a glycidyl group, a compound in which a hydrogen atom of a hydroxyl group of polyhydric phenol or a hydroxyl group of polyhydric alcohol is substituted with a substituent represented by the following formula (F-1), and a compound containing two or more nitrogen atoms and having a glycidyl group represented by the following formula (F-2), 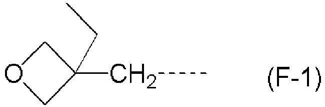 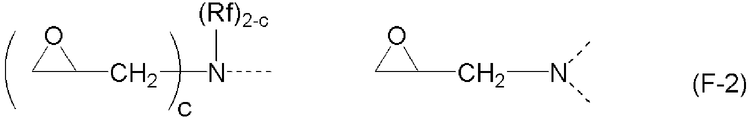 wherein a dotted line represents a bonding arm; Rf represents a linear, branched, or cyclic alkyl group having 1 to 6 carbon atoms; and "c" represents 1 or 2.

9. The negative photosensitive resin composition according to any one of claims 1 to 8, further comprising at least one or more components selected from the group of (G) an antioxidant, (H) a silane compound, and (I) a polymerization inhibitor.

10. Patterning process comprising the steps of:
(1) applying the negative photosensitive resin composition according to any one of claims 1 to 9 onto a substrate to form a photosensitive material film;
(2) heating and thereafter exposing the photosensitive material film to a high-energy beam having a wavelength of 190 to 500 nm or an electron beam through a photomask; and
(3) performing development with a developer of an organic solvent after the exposing.

11. A method for forming a cured film, comprising the step of: heating and post-curing a film having a formed pattern obtained by the patterning process according to claim 10 at a temperature of 100 to 300°C.

12. An interlayer insulating film that is a cured film of the negative photosensitive resin composition according to any one of claims 1 to 9.

13. A surface protective film that is a cured film of the negative photosensitive resin composition according to any one of claims 1 to 9.

14. An electronic component comprising the interlayer insulating film according to claim 12, or
an electronic component comprising the surface protective film according to claim 13.

## Patentansprüche

1. Negative photosensitive Harzzusammensetzung, umfassend:
(A) eine Polymerverbindung mit einer Polyimid-Precursorstruktur;
(C) einen Photoinitiator;
(D) eine stickstoffhaltige organische Verbindung, die durch die folgende allgemeine Formel (1) repräsentiert wird; und
(E) ein Lösungsmittel, 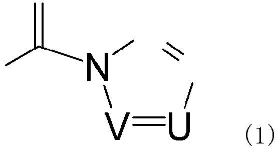
wobei Q ein Stickstoffatom oder ein Kohlenstoffatom mit einer R^{q}-Gruppe repräsentiert; T ein Stickstoffatom oder ein Kohlenstoffatom mit einer R^{t}-Gruppe repräsentiert; U ein Stickstoffatom oder ein Kohlenstoffatom mit einer R^{u}-Gruppe repräsentiert; V ein Stickstoffatom oder ein Kohlenstoffatom mit einer R^{v}-Gruppe repräsentiert; wobei die R^{q}-, R^{t}-, R^{u}- und R^{v}-Gruppen jeweils ein Wasserstoffatom, eine lineare, verzweigte oder cyclische Alkylgruppe mit 1 bis 15 Kohlenstoffatomen, eine Arylgruppe mit 6 bis 15 Kohlenstoffatomen, ein Halogenatom oder eine Nitrogruppe repräsentieren, und die R^{q}-Gruppe und die R^{t}-Gruppe, die R^{t}-Gruppe und die R^{u}-Gruppe oder die R^{u}-Gruppe und die R^{v}-Gruppe optional miteinander verbunden sind, um einen Ring zu bilden, an den ein Kohlenstoffatom gebunden ist; und W eine beliebige Struktur der folgenden allgemeinen Formeln (2) bis (4) repräsentiert, 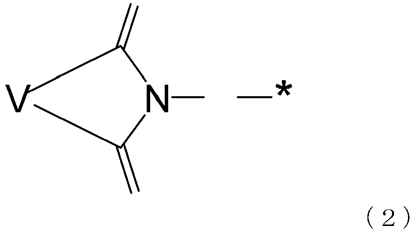
wobei A eine zweiwertige organische Gruppe repräsentiert; und * eine Bindung repräsentiert, 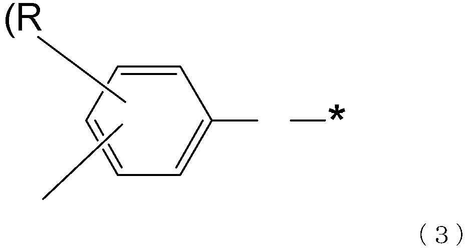
wobei D ein Halogenatom oder eine Nitrogruppe repräsentiert; R^{C} ein Wasserstoffatom, eine lineare, verzweigte oder cyclische Alkylgruppe mit 1 bis 15 Kohlenstoffatomen oder eine Arylgruppe mit 6 bis 15 Kohlenstoffatomen repräsentiert; "n" eine ganze Zahl von 3 bis 5 repräsentiert, wenn D ein Halogenatom repräsentiert, und 1 repräsentiert, wenn D eine Nitrogruppe repräsentiert; und * eine Bindung repräsentiert, 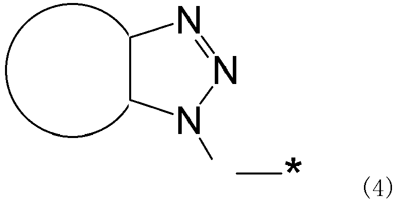
wobei Ar eine substituierte oder unsubstituierte aromatische Ringstruktur oder eine heterocyclische Struktur mit einem Heteroatom repräsentiert; und * eine Bindung repräsentiert.

2. Negative photosensitive Harzzusammensetzung nach Anspruch 1, wobei die Komponente (A) eine Polymerverbindung mit einer Polyimid-Precursorstruktur ist, die durch die folgende allgemeine Formel (5) repräsentiert wird, 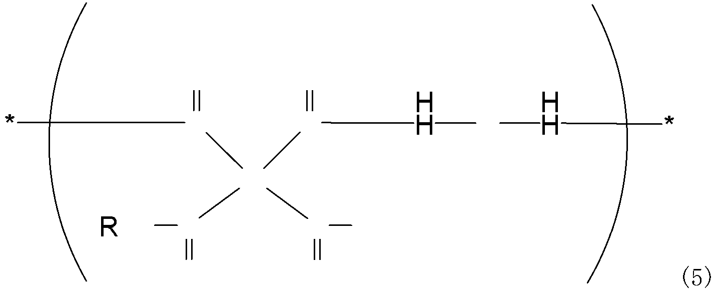
wobei X eine vierwertige organische Gruppe repräsentiert; Y eine zweiwertige organische Gruppe repräsentiert; R¹ und R² jeweils unabhängig voneinander ein Wasserstoffatom oder eine einwertige organische Gruppe repräsentieren, und R¹ und/oder R² eine durch die folgende allgemeine Formel (6) repräsentierte Gruppe repräsentiert/repräsentieren, 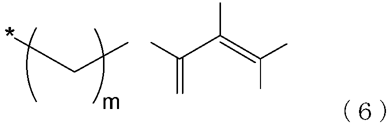
wobei M¹, M² und M³ jeweils unabhängig voneinander ein Wasserstoffatom oder eine organische Gruppe mit 1 bis 3 Kohlenstoffatomen repräsentieren; "m" eine ganze Zahl von 2 bis 10 repräsentiert; und * eine Bindung repräsentiert.

3. Negative photosensitive Harzzusammensetzung nach Anspruch 1 oder 2, die (B) eine polymerisierbare Verbindung mit zwei oder mehr ethylenisch ungesättigten Gruppen umfasst.

4. Negative photosensitive Harzzusammensetzung nach einem der Ansprüche 1 bis 3, wobei W in der allgemeinen Formel (1) der Komponente (D) eine organische Gruppe ist, die durch die folgende allgemeine Formel (2-1) repräsentiert wird, 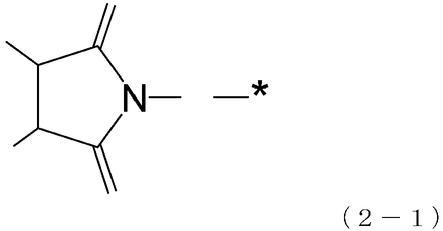 wobei eine R^{a}-Gruppe und eine R^{b}-Gruppe ein Wasserstoffatom, eine lineare, verzweigte oder cyclische Alkylgruppe mit 1 bis 15 Kohlenstoffatomen oder eine Arylgruppe mit 6 bis 15 Kohlenstoffatomen repräsentieren, oder die R^{a}-Gruppe und die R^{b}-Gruppe optional miteinander verbunden sind, um einen Ring zu bilden, an den ein Kohlenstoffatom gebunden ist; und * eine Bindung repräsentiert.

5. Negative photosensitive Harzzusammensetzung nach einem der Ansprüche 1 bis 3, wobei W in der allgemeinen Formel (1) der Komponente (D) eine organische Gruppe ist, die durch die folgenden (3-1) oder (3-2) repräsentiert wird, 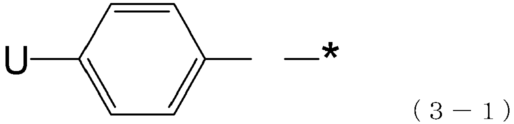
wobei * eine Bindung repräsentiert, 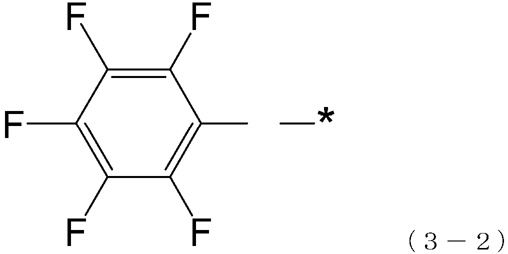
wobei * eine Bindung repräsentiert.

6. Negative photosensitive Harzzusammensetzung nach einem der Ansprüche 1 bis 3, wobei W in der allgemeinen Formel (1) der Komponente (D) eine organische Gruppe ist, die durch die folgende allgemeine Formel (4-1) repräsentiert wird, 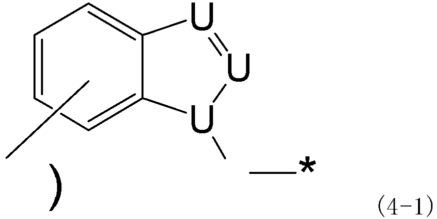 wobei eine R^{d}-Gruppe eine lineare, verzweigte oder cyclische Alkylgruppe mit 1 bis 15 Kohlenstoffatomen und optional einem Halogenatom oder eine Arylgruppe mit 6 bis 15 Kohlenstoffatomen repräsentiert; "k" eine ganze Zahl von 0 bis 4 repräsentiert; und * eine Bindung repräsentiert.

7. Negative photosensitive Harzzusammensetzung nach einem der Ansprüche 1 bis 6, wobei die Komponente (D) in einer Menge von 1 bis 10 Masseteilen, bezogen auf 100 Masseteile der Komponente (A), enthalten ist.

8. Negative photosensitive Harzzusammensetzung gemäß einem der Ansprüche 1 bis 7, umfassend als (F) ein thermisches Vernetzungsmittel, eine Art oder zwei oder mehr Arten von Vernetzungsmitteln, ausgewählt aus einem mit Formaldehyd oder Formaldehyd-Alkohol modifizierten Aminokondensat, einer Phenolverbindung mit durchschnittlich zwei oder mehr Methylolgruppen oder Alkoxymethylolgruppen pro Molekül, einer Verbindung, in der ein Wasserstoffatom einer Hydroxylgruppe eines mehrere Hydroxylgruppen enthaltenden Phenols durch eine Glycidylgruppe substituiert ist, einer Verbindung, in der ein Wasserstoffatom einer Hydroxylgruppe eines mehrwertigen Phenols oder einer Hydroxylgruppe eines mehrere Hydroxylgruppen enthaltenden Alkohols durch einen durch die folgende Formel (F-1) repräsentierten Substituenten substituiert ist, und eine Verbindung, die zwei oder mehr Stickstoffatome enthält und eine durch die folgende Formel (F-2) repräsentierte Glycidylgruppe aufweist, 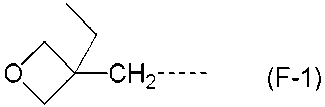 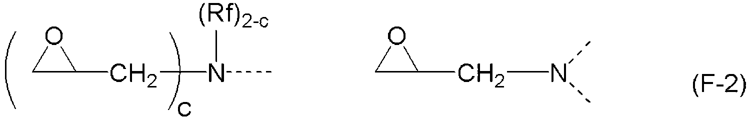 wobei eine gepunktete Linie einen Bindungsarm repräsentiert; Rf eine lineare, verzweigte oder cyclische Alkylgruppe mit 1 bis 6 Kohlenstoffatomen repräsentiert; und "c" 1 oder 2 repräsentiert.

9. Negative photosensitive Harzzusammensetzung nach einem der Ansprüche 1 bis 8, die ferner mindestens eine oder mehrere Komponenten umfasst, die aus der Gruppe, bestehend aus (G) einem Antioxidationsmittel, (H) einer Silanverbindung und (I) einem Polymerisationsinhibitor ausgewählt sind.

10. Strukturierungsverfahren, umfassend die folgenden Schritte:
(1) Aufbringen der negativen photosensitiven Harzzusammensetzung nach einem der Ansprüche 1 bis 9 auf ein Substrat, um einen photosensitiven Materialfilm zu bilden;
(2) Erhitzen und anschließendes Belichten des photosensitiven Materialfilms mit einem Hochenergiestrahl mit einer Wellenlänge von 190 bis 500 nm oder einem Elektronenstrahl durch eine Fotomaske; und
(3) Durchführen einer Entwicklung mit einem Entwickler aus einem organischen Lösungsmittel nach dem Belichten.

11. Verfahren zur Bildung eines ausgehärteten Films, umfassend den Schritt: Erhitzen und Nachhärtens eines Films mit einem durch das Strukturierungsverfahren nach Anspruch 10 erhaltenen Strukturmuster bei einer Temperatur von 100 bis 300 °C.

12. Zwischenschicht-Isolierfilm, der ein ausgehärteter Film der negativen photosensitiven Harzzusammensetzung nach einem der Ansprüche 1 bis 9 ist.

13. Oberflächenschutzfilm, der ein ausgehärteter Film der negativen photosensitiven Harzzusammensetzung nach einem der Ansprüche 1 bis 9 ist.

14. Elektronisches Bauteil, das den Zwischenschicht-Isolierfilm nach Anspruch 12 umfasst, oder
eine elektronische Komponente, die den Oberflächenschutzfilm nach Anspruch 13 umfasst.

## Revendications

1. Composition de résine photosensible négative comprenant:
(A) un composé polymère présentant une structure de précurseur de polyimide;
(C) un photo-initiateur;
(D) un composé organique contenant de l'azote représenté par la formule générale (1) suivante; et
(E) un solvant, 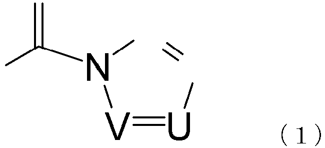
dans laquelle Q représente un atome d'azote ou un atome de carbone portant un groupe R^{q}; T représente un atome d'azote ou un atome de carbone ayant un groupe R^{t}; U représente un atome d'azote ou un atome de carbone ayant un groupe R^{u}; V représente un atome d'azote ou un atome de carbone ayant un groupe R^{v}; les groupes R^{q}, R^{t}, R^{u}, et R^{v} représentent chacun un atome d'hydrogène, un groupe alkyle linéaire, ramifié ou cyclique comportant de 1 à 15 atomes de carbone, un groupe aryle comportant de 6 à 15 atomes de carbone, un atome d'halogène ou un groupe nitro, et le groupe R^{q} et le groupe R^{t}, le groupe R^{t} et le groupe R^{u}, ou le groupe R^{u} et le groupe R^{v} peuvent éventuellement se lier entre eux pour former un cycle auquel est lié un atome de carbone; et W représente n'importe quelle structure répondant aux formules générales (2) à (4) suivantes, 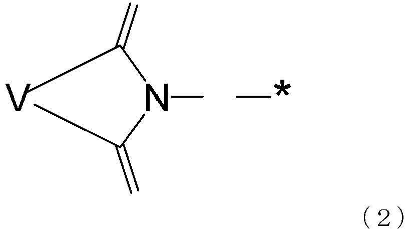
dans laquelle A représente un groupe organique divalent; et * représente une liaison, 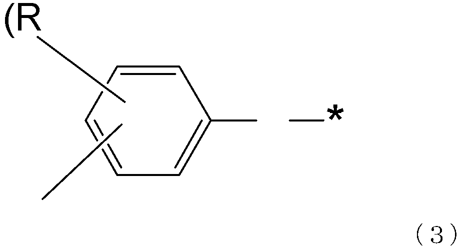
dans laquelle D représente un atome d'halogène ou un groupe nitro; R^{C} représente un atome d'hydrogène, un groupe alkyle linéaire, ramifié ou cyclique comportant de 1 à 15 atomes de carbone, ou un groupe aryle comportant de 6 à 15 atomes de carbone; « n » représente un nombre entier compris entre 3 et 5 lorsque D représente un atome d'halogène, et représente 1 lorsque D représente un groupe nitro; et * représente une liaison, 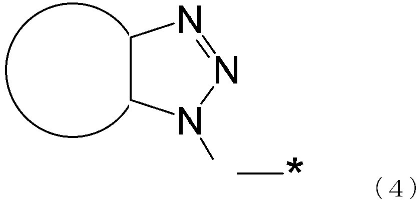
dans laquelle Ar représente une structure cyclique aromatique substituée ou non substituée, ou une structure hétérocyclique comportant un hétéroatome; et * représente une liaison.

2. Composition de résine photosensible négative selon la revendication 1, dans laquelle le composant (A) est un composé polymère ayant une structure de précurseur de polyimide représentée par la formule générale (5) suivante: 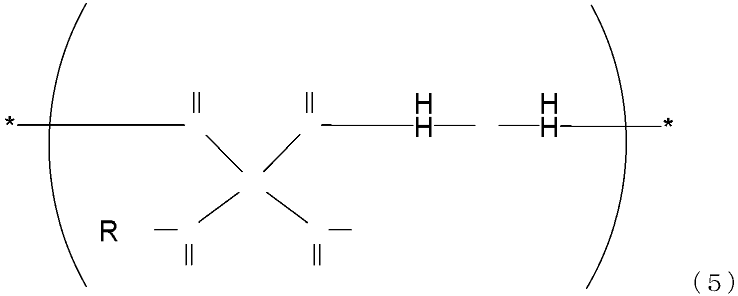
dans laquelle X représente un groupe organique tétravalent; Y représente un groupe organique divalent; R¹ et R² représentent chacun, indépendamment l'un de l'autre, un atome d'hydrogène ou un groupe organique monovalent, et au moins l'un parmi R¹ et R2 représente un groupe représenté par la formule générale (6) suivante, 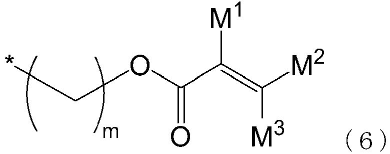
dans laquelle M¹, M², et M³ représentent indépendamment un atome d'hydrogène ou un groupe organique comportant de 1 à 3 atomes de carbone; « m » représente un nombre entier compris entre 2 et 10; et * représente une liaison.

3. Composition de résine photosensible négative selon la revendication 1 ou 2, comprenant (B) un composé polymérisable comportant au moins deux groupes à insaturation éthylénique.

4. Composition de résine photosensible négative selon l'une quelconque des revendications 1 à 3, dans laquelle W, dans la formule générale (1) du composé (D), est un groupe organique représenté par la formule générale (2-1) suivante: 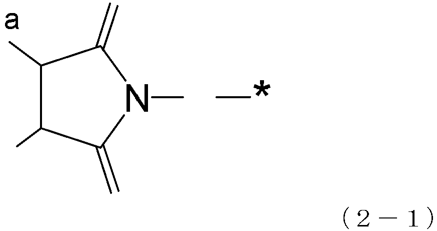 dans laquelle un groupe R^{a} et un groupe R^{b} représentent un atome d'hydrogène, un groupe alkyle linéaire, ramifié ou cyclique comportant de 1 à 15 atomes de carbone, ou un groupe aryle comportant de 6 à 15 atomes de carbone, ou le groupe R^{a} et le groupe R^{b} peuvent éventuellement se lier l'un à l'autre pour former un cycle auquel est lié un atome de carbone; et * représente une liaison.

5. Composition de résine photosensible négative selon l'une quelconque des revendications 1 à 3, dans laquelle W, dans la formule générale (1) du composé (D), est un groupe organique représenté par la formule (3-1) ou (3-2) suivante: 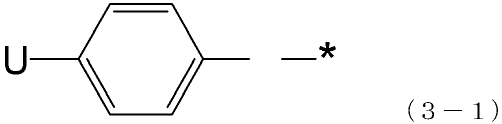
dans laquelle * représente une liaison, 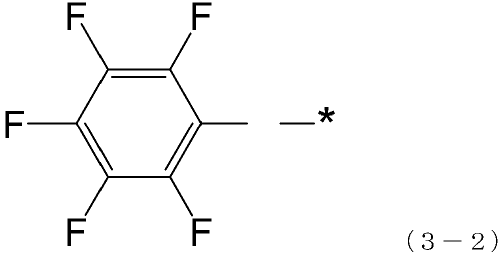
dans laquelle * représente une liaison.

6. Composition de résine photosensible négative selon l'une quelconque des revendications 1 à 3, dans laquelle W, dans la formule générale (1) du composé (D), est un groupe organique représenté par la formule générale (4-1) suivante: 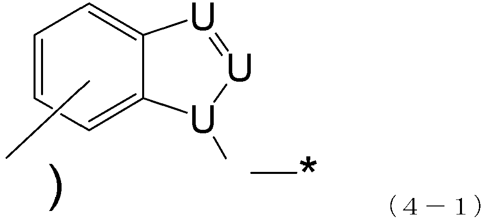 dans laquelle un groupe R^{d} représente un groupe alkyle linéaire, ramifié ou cyclique comportant de 1 à 15 atomes de carbone et comportant éventuellement un atome d'halogène, ou un groupe aryle comportant de 6 à 15 atomes de carbone ; « k » représente un nombre entier compris entre 0 et 4; et * représente une liaison.

7. Composition de résine photosensible négative selon l'une quelconque des revendications 1 à 6, dans laquelle le composé (D) est présent à hauteur de 1 à 10 parties en masse pour 100 parties en masse du composé (A).

8. Composition de résine photosensible négative selon l'une quelconque des revendications 1 à 7, comprenant, en tant que (F), un agent de réticulation thermique, un type ou au moins deux types d'agents de réticulation choisis parmi un condensat d'amino modifié par du formaldéhyde ou du formaldéhyde-alcool, un composé phénolique comportant en moyenne au moins deux groupes méthylol ou groupes alcoxyméthylol par molécule, un composé dans lequel un atome d'hydrogène d'un groupe hydroxyle d'un phénol polyhydrique est substitué par un groupe glycidyle, un composé dans lequel un atome d'hydrogène d'un groupe hydroxyle d'un phénol polyhydrique ou d'un groupe hydroxyle d'un alcool polyhydrique est substitué par un substituant représenté par la formule (F-1) suivante, et un composé contenant au moins deux atomes d'azote et comportant un groupe glycidyle représenté par la formule (F-2) suivante, 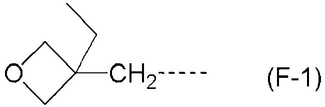 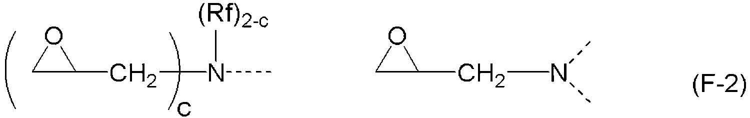 dans laquelle une ligne pointillée représente un bras de liaison; Rf représente un groupe alkyle linéaire, ramifié ou cyclique comportant de 1 à 6 atomes de carbone; et « c » représente 1 ou 2.

9. Composition de résine photosensible négative selon l'une quelconque des revendications 1 à 8, comprenant en outre au moins un ou plusieurs composés choisis parmi le groupe constitué de (G) un antioxydant, (H) un composé silane et (I) un inhibiteur de polymérisation.

10. Procédé de formation de motifs comprenant les étapes consistant à:
(1) appliquer la composition de résine photosensible négative selon l'une quelconque des revendications 1 à 9 sur un substrat afin de former un film de matériau photosensible;
(2) chauffer, puis exposer le film de matériau photosensible à un faisceau à haute énergie d'une longueur d'onde comprise entre 190 et 500 nm ou à un faisceau d'électrons à travers un photomasque; et
(3) procéder au développement à l'aide d'un révélateur à base de solvant organique après l'exposition.

11. Procédé de formation d'un film durci, comprenant l'étape consistant à: chauffer et post-durcir un film comportant un motif formé, obtenu selon le procédé de formation de motifs selon la revendication 10, à une température comprise entre 100 et 300 °C.

12. Film isolant intercouche qui est un film durci de la composition de résine photosensible négative selon l'une quelconque des revendications 1 à 9.

13. Film de protection de surface qui est un film durci de la composition de résine photosensible négative selon l'une quelconque des revendications 1 à 9.

14. Composant électronique comprenant le film isolant intercouche selon la revendication 12, ou
un composant électronique comprenant le film de protection de surface selon la revendication 13.
